(19) Europäisches Patentamt
European Patent Office
Office européen des brevets

(11) EP 3 487 864 B1

(12) EUROPÄISCHE PATENTSCHRIFT

(45) Veröffentlichungstag und Bekanntmachung des Hinweises auf die Patenterteilung:
**29.04.2020 Patentblatt 2020/18**

(21) Anmeldenummer: **17745685.2**

(22) Anmeldetag: **20.07.2017**

(51) Int Cl.:
***C07F 15/00*** *(2006.01)* ***C09K 11/06*** *(2006.01)*
***H01L 51/00*** *(2006.01)* ***H05B 33/00*** *(2006.01)*

(86) Internationale Anmeldenummer:
**PCT/EP2017/068292**

(87) Internationale Veröffentlichungsnummer:
**WO 2018/019688 (01.02.2018 Gazette 2018/05)**

(54) **METALLKOMPLEXE FÜR DEN EINSATZ ALS EMITTER IN ORGANISCHEN ELEKTROLUMINESZENZVORRICHTUNGEN**

METAL COMPLEXES FOR USE AS EMITTERS IN ORGANIC ELECTROLUMINESCENCE DEVICES

COMPLEXES MÉTALLIQUES TROUVANT APPLICATION COMME ÉMETTEURS DANS DES DISPOSITIFS ÉLECTROLUMINESCENTS ORGANIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.07.2016 EP 16180990**

(43) Veröffentlichungstag der Anmeldung:
**29.05.2019 Patentblatt 2019/22**

(73) Patentinhaber: **Merck Patent GmbH**
**64293 Darmstadt (DE)**

(72) Erfinder:
- **STOESSEL, Philipp**
  **60389 Frankfurt am Main (DE)**
- **EHRENREICH, Christian**
  **64285 Darmstadt (DE)**

(56) Entgegenhaltungen:
**JP-A- 2013 117 005**

- **CHE-JEN LIN ET AL: "Unichromophoric Platinum-Acetylides That Contain Pentiptycene Scaffolds: Torsion-Induced Dual Emission and Steric Shielding of Dynamic Quenching", INORGANIC CHEMISTRY, Bd. 53, Nr. 2, 21. Januar 2014 (2014-01-21), Seiten 737-745, XP055399168, EASTON, US ISSN: 0020-1669, DOI: 10.1021/ic4025052**
- **GUANGXIA WANG ET AL: "Molecular Turnstiles Regulated by Metal Ions", THE JOURNAL OF ORGANIC CHEMISTRY, Bd. 81, Nr. 8, 17. März 2016 (2016-03-17), Seiten 3364-3371, XP055399163, ISSN: 0022-3263, DOI: 10.1021/acs.joc.6b00463**

EP 3 487 864 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft Metallkomplexe, welche mit aromatischen und bicyclischen aliphatischen Substituenten substituiert sind und welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem ortho-metallierte Iridium- oder Platinkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, wobei als Liganden beispielsweise 1- oder 3-Phenylisochinoline, 2-Phenylchinoline oder Phenylcarbene einsetzt werden.

CHE-JEN LIN ET AL: "Unichromophoric Platinum-Acetylides That Contain Pentiptycene Scaffolds: Torsion-Induced Dual Emission and Steric Shielding of Dynamic Quenching", INORGANIC CHEMISTRY, Bd. 53, 2014, Seiten 737-745 offenbart Platin-komplexe und ihre Verwendung als Sauerstoff-Sensibilisator.

Aufgabe der vorliegenden Erfindung ist die Bereitstellung neuer Metallkomplexe, welche sich als Emitter für die Verwendung in OLEDs eignen. Insbesondere ist die Aufgabe, Emitter bereitzustellen, welche orientierte Emission zeigen und/oder verbesserte Eigenschaften in Bezug auf Effizienz, Betriebsspannung und/oder Lebensdauer zeigen. Durch orientierte Emission kann man eine höhere Quanteneffizienz durch verbesserte Lichtauskopplung aus dem Bauteil erhalten, so dass die OLED insgesamt eine höhere Effizienz aufweist. Als Folge davon kann das Bauteil mit weniger Strom getrieben werden, woraus sich als weiterer Vorteil eine höhere Lebensdauer ergibt.

Überraschend wurde gefunden, dass Iridium- oder Platinkomplexe, welche einen oder mehrere Substituenten aus Arylen- bzw. Heteroarylengruppen und aliphatischen bi- bzw. oligocyclischen Gruppen enthalten, die oben genannte Aufgabe lösen und sich sehr gut für die Verwendung in einer organischen Elektrolumineszenzvorrichtung eignen. Diese Komplexe und organische Elektrolumineszenzvorrichtungen, welche diese Komplexe enthalten, sind der Gegenstand der vorliegenden Erfindung.

Gegenstand der Erfindung ist eine Verbindung gemäß der folgenden Formel (1),

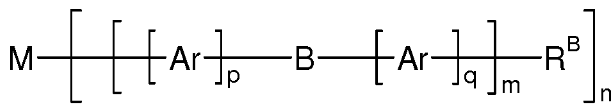

Formel (1)

wobei für die verwendeten Symbole und Indizes gilt:

M ist bei jedem Auftreten gleich oder verschieden ein organometallischer Iridiumkomplex oder ein organometallischer Platinkomplex;

Ar ist bei jedem Auftreten gleich oder verschieden eine linear verknüpfte Arylen- oder Heteroarylengruppe mit 6 bis 30 aromatischen Ringatomen, welche mit einem oder mehreren Resten R substituiert sein kann;

B ist eine Gruppe der folgenden Formel (2),

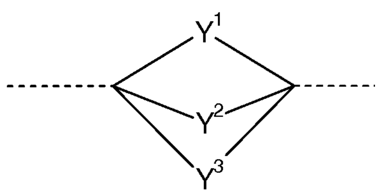

Formel (2)

wobei die gestrichelten Bindungen die Verknüpfungen dieser Gruppe mit Ar bzw. mit $R^B$ andeutet und weiterhin gilt:

$Y^1$, $Y^2$ $Y^3$ ist gleich oder verschieden bei jedem Auftreten $CR_2$, $CR_2$-$CR_2$, $CR_2$-$CR_2$-$CR_2$, $CR_2$-$CR_2$-$CR_2$-$CR_2$, CR=CR

oder eine ortho-verknüpfte Phenylengruppe, welche mit einem oder mehreren Resten R substituiert sein kann; dabei können die Gruppen $Y^1$, $Y^2$ und/oder $Y^3$ durch eine Einfachbindung oder über Reste R miteinander verknüpft sein, so dass oligocyclische Gruppen entstehen;

$R^B$ ist bei jedem Auftreten gleich oder verschieden ausgewählt aus M oder H, D, einer geradkettigen Alkylgruppe mit 1 bis 20 C-Atomen oder einer verzweigten oder cyclischen Alkylgruppe mit 3 bis 20 C-Atomen, wobei die Alkylgruppe jeweils mit einem oder mehreren Resten $R^1$ substituiert sein kann, oder einem aromatischen oder heteroaromatischen Ringsystem mit 5 bis 40 aromatischen Ringatomen, das jeweils durch einen oder mehrere Reste $R^1$ substituiert sein kann;

R ist bei jedem Auftreten gleich oder verschieden H, D, F, Cl, Br, I, $N(R^1)_2$, CN, $NO_2$, $OR^1$, $SR^1$, COOH, $C(=O)N(R^1)_2$, $Si(R^1)_3$, $B(OR^1)_2$, $C(=O)R^1$, $P(=O)(R^1)^2$, $S(=O)R^1$, $S(=O)_2R^1$, $OSO_2R^1$, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^1$ substituiert sein kann, wobei eine oder mehrere nicht benachbarte $CH_2$-Gruppen durch $R^1C{=}CR^1$, C=C, $Si(R^1)_2$, C=O, $NR^1$, O, S oder $CONR^1$ ersetzt sein können, oder ein aromatisches oder heteroaromatisches Ringsystem mit 5 bis 40 aromatischen Ringatomen, das jeweils durch einen oder mehrere Reste $R^1$ substituiert sein kann; dabei können zwei Reste R auch miteinander ein Ringsystem bilden;

$R^1$ ist bei jedem Auftreten gleich oder verschieden H, D, F, Cl, Br, I, $N(R^2)_2$, CN, $NO_2$, $OR^2$, $SR^2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^2$ substituiert sein kann, wobei eine oder mehrere nicht benachbarte $CH_2$-Gruppen durch $R^2C{=}CR^2$, C=C, $Si(R^2)_2$, C=O, $NR^2$, O, S oder $CONR^2$ ersetzt sein können, oder ein aromatisches oder heteroaromatisches Ringsystem mit 5 bis 40 aromatischen Ringatomen, das jeweils durch einen oder mehrere Reste $R^2$ substituiert sein kann; dabei können zwei oder mehrere Reste $R^1$ miteinander ein Ringsystem bilden;

$R^2$ ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 CAtomen, in dem auch ein oder mehrere H-Atome durch F ersetzt sein können;

n ist 1, 2, 3, 4, 5 oder 6;

p ist bei jedem Auftreten gleich oder verschieden 1 bis 100;

q ist bei jedem Auftreten gleich oder verschieden 0 bis 100;

m ist bei jedem Auftreten gleich oder verschieden 1 bis 100.

Dabei sind p, q und m ganze Zahlen.

Für q = 0 handelt es sich dabei um eine Verbindung der folgenden Formel (1A), und für q = 1 bis 100 handelt es sich um eine Verbindung der folgenden Formel (1B),

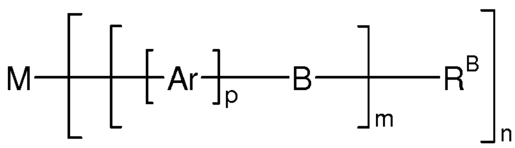

Formel (1A)

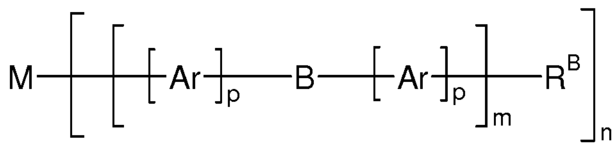

Formel (1B)

wobei die verwendeten Symbole und Indizes die oben genannten Bedeutungen aufweisen.

Bevorzugt ist p gleich oder verschieden bei jedem Auftreten 1 bis 50, besonders bevorzugt 1 bis 20, ganz besonders bevorzugt 1 bis 10 und insbesondere 1, 2, 3 oder 4. Bevorzugt ist weiterhin q bei jedem Auftreten gleich oder verschieden 0 bis 50, besonders bevorzugt 0 bis 10, ganz besonders bevorzugt 0 bis 10 und insbesondere 0, 1, 2, 3 oder 4. Bevorzugt ist weiterhin m bei jedem Auftreten gleich oder verschieden 1 bis 50, besonders bevorzugt 1 bis 20, ganz besonders bevorzugt 1 bis 10 und insbesondere 1, 2, 3, 4 oder 5. Insbesondere gelten die hier aufgeführten bevorzugten Ausführungsformen von p und m gleichzeitig.

Bevorzugt ist weiterhin n = 1, 2 oder 3, besonders bevorzugt ist n = 1 oder 2, und ganz besonders bevorzugt ist n = 1.

Wenn zwei Reste R bzw. $R^1$ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

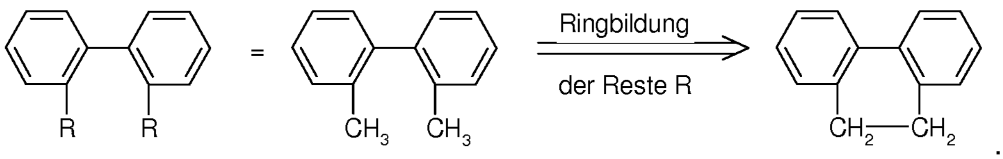


Ebenso ist die Ringbildung von bicyclischen, tricyclischen und oligocyclischen Strukturen möglich. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

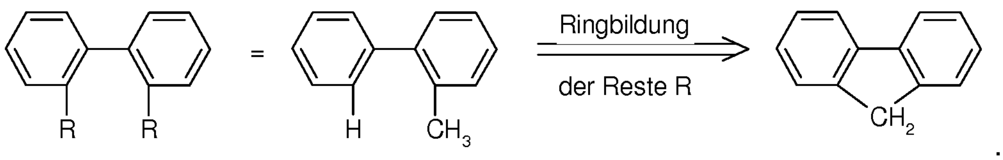


Ganz analog soll darunter auch verstanden werden, dass für den Fall, dass beide Reste Wasserstoffatome darstellen, statt der beiden Wasserstoffatome eine Ringbildung durch eine Einfachbindung erfolgt.

Die Bildung eines aromatischen Ringsystems soll durch das folgende Schema verdeutlicht werden:

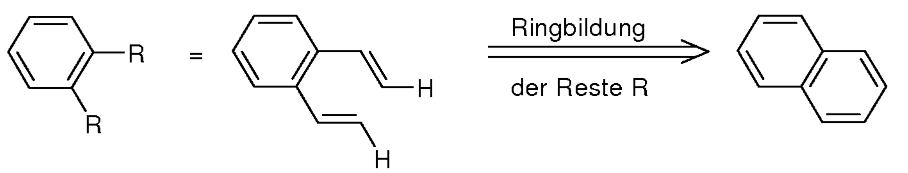


Dabei kann die Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome oder an dasselbe Kohlenstoffatom

gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden. Weiterhin soll im Sinne der vorliegenden Erfindung unter einer Arylgruppe eine Gruppe verstanden werden, in der zwei, drei oder mehr Phenylgruppen, die direkt aneinander gebunden sind, durch eine Gruppe $CR_2$ miteinander verbrückt sind, also beispielsweise eine Fluorengruppe, eine Spirobifluorengruppe oder eine Indenofluorengruppe.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{20}$-Alkylgruppe, in der auch einzelne H-Atome oder $CH_2$-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer $C_1$- bis $C_{20}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform der Erfindung ist die Triplettenergie des Fragments M nicht mehr als 0.1 eV größer als die Triplettenergie des Fragments $-[[Ar]_p-B-[Ar]_q]_m-R^B$. Dieses Fragment entspricht $-[[Ar]_p-B]_m-R^B$ für q = 0 bzw. $-[[Ar]_p-B-[Ar]_p]_m-R^B$ für q = 1 bis 100. Besonders bevorzugt ist die Triplettenergie des Fragments M gleich groß oder kleiner als die Triplettenergie des Fragments $-[[Ar]_p-B-[Ar]_q]_m-R^B$, besonders bevorzugt mindestens 0.1 eV kleiner.

Im Sinne der vorliegenden Erfindung wird dabei als Triplettenergie des Fragments M die Triplettenergie einer Verbindung verstanden, die die Struktur von M aufweist, die jedoch statt der Substituenten $-[[Ar]_p-B-[Ar]_q]_m-R^B$ jeweils ein Wasserstoffatom aufweist. Als Triplettenergie des Fragments $-[[Ar]_p-B-[Ar]_q]_m-R^B$ wird die Triplettenergie einer Verbindung verstanden, die die Struktur $H-[[Ar]_p-B-[Ar]_q]_m-R^B$ aufweist. Dabei wird die Triplettenergie durch quantenchemische Rechnung bestimmt, wie hinten im Beispielteil allgemein beschrieben.

Im Folgenden werden bevorzugte Iridium- bzw. Platinkomplexe M beschrieben. Wie oben beschrieben, handelt es sich dabei um organometallische Komplexe. Ein organometallischer Komplex im Sinne der vorliegenden Erfindung ist Komplex, welcher mindestens eine Metall-Kohlenstoffbindung aufweist.

In einer bevorzugten Ausführungsform der Erfindung ist der Iridium- bzw. Platinkomplex nicht geladen, d. h. elektrisch neutral. Dabei enthält der Iridiumkomplex bevorzugt entweder drei bidentate, monoanionische Liganden oder einen tripodalen, hexadentaten, trianionischen Liganden, und der Platinkomplex enthält entweder zwei bidentate, monoanionische Liganden oder einen tetradentaten, dianionischen Liganden.

Die Bindung des Liganden an das Iridium kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass ein Ligand bzw. ein Teilligand an das Iridium koordiniert oder bindet, so bezeichnet dies im Sinne der vorliegenden Anmeldung jede Art der Bindung des Liganden bzw. Teilliganden an das Iridium, unabhängig vom kovalenten Anteil der Bindung.

In einer bevorzugten Ausführungsform der Erfindung handelt es sich bei M um einen Iridiumkomplex. Besonders bevorzugt handelt es sich um einen Iridiumkomplex mit einem tripodalen, hexadentaten Liganden, wie er nachfolgend beschrieben wird. Dabei enthält der tripodale, hexadentate Ligand drei bidentate Teilliganden, die gleich oder verschieden sein können und die an ein Iridiumatom koordinieren, wobei die drei bidentaten Teilliganden über eine Brücke der folgenden Formel (3) oder Formel (4) verknüpft sind,

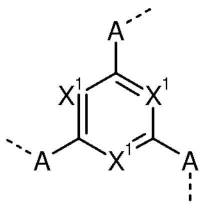

Formel (3)

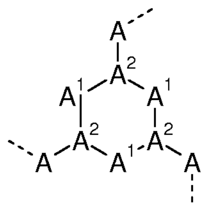

Formel (4)

wobei die gestrichelte Bindung die Bindung der bidentaten Teilliganden an diese Struktur darstellt, R, $R^1$ und $R^2$ die oben genannten Bedeutungen aufweisen und weiterhin gilt:

$X^1$ ist bei jedem Auftreten gleich oder verschieden CR oder N;

$A^1$ ist bei jedem Auftreten gleich oder verschieden $C(R)_2$ oder O;

$A^2$ ist bei jedem Auftreten gleich oder verschieden CR, P(=O), B oder SiR, mit der Maßgabe, dass für $A^2$ = P(=O), B oder SiR das Symbol $A^1$ für O steht und das Symbol A, das an dieses $A^2$ gebunden ist, nicht für -C(=O)-NR'- oder -C(=O)-O- steht;

A ist bei jedem Auftreten gleich oder verschieden -CR=CR-, -C(=O)-NR'-, -C(=O)-O-, $-CR_2-CR_2-$ oder eine Gruppe der folgenden Formel (5),

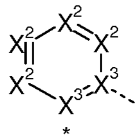

Formel (5)

wobei die gestrichelte Bindung die Position der Bindung der bidentaten Teilliganden an diese Struktur darstellt und * die Position der Verknüpfung der Einheit der Formel (5) mit der zentralen cyclischen Gruppe darstellt, also der Gruppe, die explizit in Formel (3) bzw. (4) aufgeführt ist;

$X^2$ ist bei jedem Auftreten gleich oder verschieden CR oder N oder zwei benachbarte Gruppen $X^2$ stehen zusammen für NR, O oder S, so dass ein Fünfring entsteht, und die verbleibenden $X^2$ stehen gleich oder verschieden bei jedem Auftreten für CR oder N; oder zwei benachbarte Gruppen $X^2$ stehen zusammen für CR oder N, wenn in dem Cyclus eine der Gruppen $X^3$ für N steht, so dass ein Fünfring entsteht; mit der Maßgabe, dass maximal zwei benachbarte Gruppen $X^2$ für N stehen;

$X^3$ ist bei jedem Auftreten C oder eine Gruppe $X^3$ steht für N und die andere Gruppe $X^3$ in demselben Cyclus steht für C; mit der Maßgabe, dass zwei benachbarte Gruppen $X^2$ zusammen für CR oder N stehen, wenn in dem Cyclus eine der Gruppen $X^3$ für N steht;

R’ ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^1$ substituiert sein kann und wobei eine oder mehrere nicht benachbarte $CH_2$-Gruppen durch $Si(R^1)_2$ ersetzt sein können, oder ein aromatisches oder heteroaromatisches Ringsystem mit 5 bis 40 aromatischen Ringatomen, das jeweils durch einen oder mehrere Reste $R^1$ substituiert sein kann;

dabei können die drei bidentaten Teilliganden außer durch die Brücke der Formel (3) oder (4) auch noch durch eine weitere Brücke zu einem Kryptat geschlossen sein.

Die Gruppe $-[[Ar]_p-B-[Ar]_q]_m-R^B$ kann an den Komplex M entweder an die Gruppe der Formel (3) bzw. (4) gebunden sein oder an einen der Teilliganden.

Die Struktur der hexadentaten, tripodalen Liganden kann schematisch durch die folgende Formel (Lig) dargestellt werden:

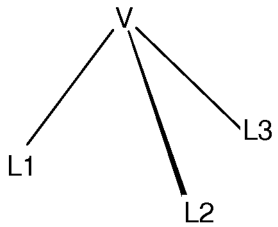


(Lig)

wobei V die Brücke gemäß Formel (3) oder (4) darstellt und L1, L2 und L3 gleich oder verschieden bei jedem Auftreten jeweils bidentate Teilliganden darstellen, bevorzugt monoanionische bidentate Teilliganden. Dabei bedeutet bidentat, dass der jeweilige Teilligand im Komplex M über zwei Koordinationsstellen an das Iridium koordiniert bzw. bindet. Tripodal bedeutet, dass der Ligand drei Teilliganden aufweist, die an die Brücke V bzw. die Brücke der Formel (3) oder (4) gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei dieser Einheit um einen bidentaten Liganden handeln würde, wenn die Brücke der Formel (3) bzw. (4) nicht vorhanden wären. Durch die formale Abstraktion eines Wasserstoffatoms an diesem bidentaten Liganden und die Anknüpfung an die Brücke der Formel (3) bzw. (4) ist dieser jedoch kein separater Ligand, sondern ein Teil des so entstehenden hexadentaten Liganden, so dass hierfür der Begriff "Teilligand" verwendet wird.

Der mit diesem Liganden der Formel (Lig) gebildete Iridiumkomplex M kann somit schematisch durch die

folgende Formel dargestellt werden:

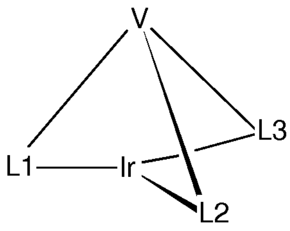

M

wobei V die Brücke gemäß Formel (3) oder (4) darstellt und L1, L2 und L3 gleich oder verschieden bei jedem Auftreten jeweils bidentate Teilliganden darstellen.

Im Folgenden werden bevorzugte Ausführungsformen der Brücke der Formel (3) bzw. (4), die die drei bidentaten Teilliganden verknüpft, ausgeführt. Geeignete Ausführungsformen der Gruppe der Formel (3) sind die Strukturen der folgenden Formeln (6) bis (9), und geeignete Ausführungsformen der Gruppe der Formel (4) sind die Strukturen der folgenden Formeln (10) bis (14),

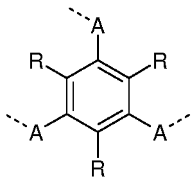

Formel (6)

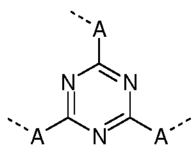

Formel (7)

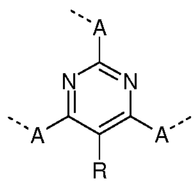

Formel (8)

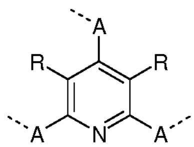

Formel (9)

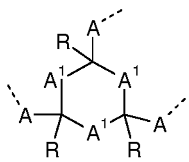

Formel (10)

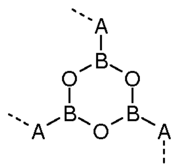

Formel (11)

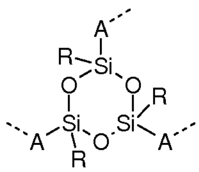

Formel (12)

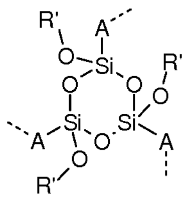

Formel (13)

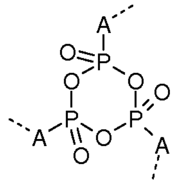

Formel (14)

wobei die Symbole die oben genannten Bedeutungen aufweisen.

Für bevorzugte Reste R in Formeln (6) bis (14) gilt:

R ist bei jedem Auftreten gleich oder verschieden H, D, F, CN, $OR^1$, eine geradkettige Alkylgruppe mit 1 bis 10 C-Atomen oder eine verzweigte oder cyclische Alkylgruppe mit 3 bis 10 C-Atomen, die jeweils mit einem oder mehreren Resten $R^1$ substituiert sein kann, oder ein aromatisches oder heteroaromatisches Ringsystem mit 5 bis 24 aromatischen Ringatomen, das jeweils durch einen oder mehrere Reste $R^1$ substituiert sein kann;

$R^1$ ist bei jedem Auftreten gleich oder verschieden H, D, F, CN, $OR^2$, eine geradkettige Alkylgruppe mit 1 bis 10 C-Atomen oder eine verzweigte oder cyclische Alkylgruppe mit 3 bis 10 C-Atomen, die jeweils mit einem oder mehreren Resten $R^2$ substituiert sein kann, oder ein aromatisches oder heteroaromatisches Ringsystem mit 5 bis 24 aromatischen Ringatomen, das jeweils durch einen oder mehrere Reste $R^2$ substituiert sein kann; dabei können

zwei oder mehrere benachbarte Reste $R^1$ miteinander ein Ringsystem bilden;

$R^2$ ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Für besonders bevorzugte Reste R in Formeln (6) bis (14) gilt:

R ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten $R^1$ substituiert sein kann, oder ein aromatisches oder heteroaromatisches Ringsystem mit 6 bis 12 aromatischen Ringatomen, das jeweils durch einen oder mehrere Reste $R^1$ substituiert sein kann;

$R^1$ ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten $R^2$ substituiert sein kann, oder ein aromatisches oder heteroaromatisches Ringsystem mit 6 bis 12 aromatischen Ringatomen, das jeweils durch einen oder mehrere Reste $R^2$ substituiert sein kann; dabei können zwei oder mehrere benachbarte Reste $R^1$ miteinander ein Ringsystem bilden;

$R^2$ ist bei jedem Auftreten gleich oder verschieden H, D, F oder ein aliphatischer oder aromatischer Kohlenwasserstoffrest mit 1 bis 12 C-Atomen.

In einer bevorzugten Ausführungsform der Erfindung stehen alle Gruppen $X^1$ in der Gruppe der Formel (3) für CR, so dass der zentrale trivalente Cyclus der Formel (3) ein Benzol darstellt. Besonders bevorzugt stehen alle Gruppen $X^1$ für CH. In einer weiteren bevorzugten Ausführungsform der Erfindung stehen alle Gruppen $X^1$ für ein Stickstoffatom, so dass der zentrale trivalente Cyclus der Formel (3) ein Triazin darstellt. Bevorzugte Ausführungsformen der Formel (3) sind somit die Strukturen der oben abgebildeten Formeln (6) und (7). Besonders bevorzugt ist die Struktur der Formel (6) eine Struktur der folgenden Formel (6'),

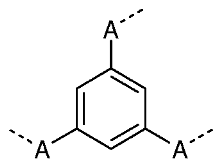

Formel (6')

wobei die Symbole die oben genannten Bedeutungen aufweisen.

In einer weiteren bevorzugten Ausführungsform der Erfindung stehen alle Gruppen $A^2$ in der Gruppe der Formel (4) für CR. Besonders bevorzugt stehen alle Gruppen $A^2$ für CH. Bevorzugte Ausführungsformen der Formel (4) sind somit die Strukturen der oben abgebildeten Formel (10). Besonders bevorzugt ist die Struktur der Formel (10) eine Struktur der folgenden Formel (10') oder (10"),

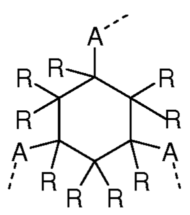

Formel (10')

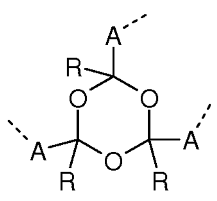

Formel (10")

wobei die Symbole die oben genannten Bedeutungen aufweisen und R bevorzugt für H steht. Dabei ist die Gruppe der Formel (10') besonders bevorzugt.

Wenn $A^2$ für CR steht, insbesondere wenn alle $A^2$ für CR stehen, ganz besonders wenn zusätzlich 0, 1, 2 oder 3, insbesondere 3, der $A^1$ für $CR_2$ stehen, können die Reste R an $A^2$ abhängig von der Konfiguration unterschiedliche

Positionen einnehmen. Bevorzugt sind dabei kleine Reste R wie H oder D. Bevorzugt ist, dass sie entweder alle weg vom Metall gerichtet sind (apical) oder alle nach innen zum Metall hin gerichtet sind (endohedral). Dies ist nachfolgend am Beispiel eines Komplexes mit Esterbrücken veranschaulicht. Es gilt in gleicher Weise für ortho-Arylen-, ortho-Heteroarylen-, 1,2-Olefin-, Imin- und Amidbrücken und zwar unabhängig davon, wie die Brücke orientiert ist, d.h. ob die Carbonyl-Gruppe der Ester-/Amid-Brücke bzw. das N-Atom der Iminbrücke an den Cyclohexanring bindet oder an den Aromaten des zweizähnigen Teilliganden.

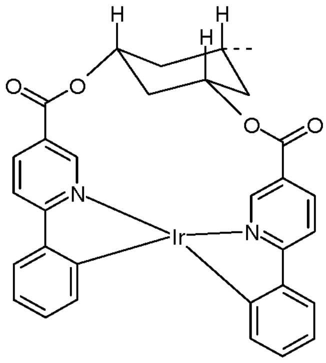

apical

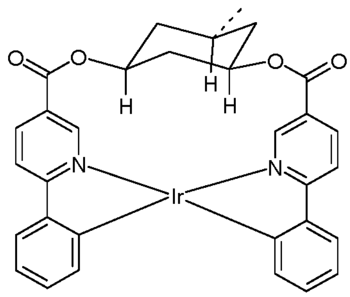

endohedral

Der dritte Teilligand ist der Übersichtlichkeit halber nicht dargestellt, sondern nur durch die gestrichelte Bindung angedeutet. Bevorzugt sind daher Komplexe, welche mindestens eine der beiden Konfigurationen einnehmen können. Dies sind Komplexe, bei welchen alle drei Gruppen A äquatorial am zentralen Ring angeordnet sind.

Im Folgenden werden bevorzugte Gruppen A beschrieben, wie sie in den Strukturen der Formeln (3) und (4) sowie (6) bis (14) vorkommen. Die Gruppe A kann gleich oder verschieden bei jedem Auftreten eine Alkenylgruppe, eine Amidgruppe, eine Estergruppe oder eine ortho-verknüpfte Arylen- bzw. Heteroarylengruppe der Formel (5) darstellen. Wenn A für eine Alkenylgruppe steht, dann handelt es sich um eine cis-verknüpfte Alkenylgruppe. Bei unsymmetrischen Gruppen A ist jede Orientierung der Gruppen möglich. Dies ist nachfolgend schematisch am Beispiel von A = -C(=O)-O- erläutert. Hieraus ergeben sich die folgenden möglichen Orientierungen von A, die alle von der vorliegenden Erfindung umfasst sind:

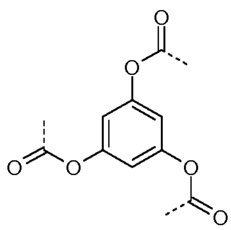

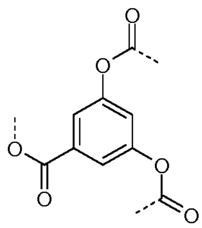

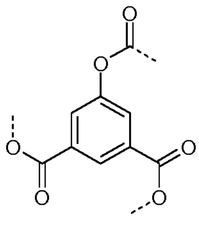

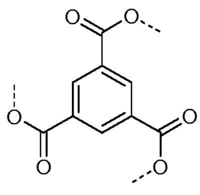

.

In einer bevorzugten Ausführungsform der Erfindung ist A gleich oder verschieden, besonders bevorzugt gleich, bei jedem Auftreten ausgewählt aus der Gruppe bestehend aus -C(=O)-O-, -C(=O)-NR'- oder einer Gruppe der Formel (5). Weiterhin bevorzugt sind zwei Gruppen A gleich und auch gleich substituiert, und die dritte Gruppe A ist von den ersten beiden Gruppen A verschieden, oder alle drei Gruppen A sind gleich und auch gleich substituiert. Bevorzugte Kombinationen für die drei Gruppen A in Formel (3) und (4) und den bevorzugten Ausführungsformen sind:

| A | A | A |
|---|---|---|
| Formel (5) | Formel (5) | Formel (5) |
| -C(=O)-O- | -C(=O)-O- | -C(=O)-O- |
| -C(=O)-O- | -C(=O)-O- | Formel (5) |
| -C(=O)-O- | Formel (5) | Formel (5) |
| -C(=O)-NR'- | -C(=O)-NR'- | -C(=O)-NR'- |

(fortgesetzt)

| A | A | A |
|---|---|---|
| -C(=O)-NR- | -C(=O)-NR'- | Formel (5) |
| -C(=O)-NR'- | Formel (5) | Formel (5) |

Dabei sind Strukturen, in denen alle drei Symbole A jeweils für eine Gruppe der Formel (5) stehen, besonders bevorzugt.

Wenn A für -C(=O)-NR'- steht, dann steht R' bevorzugt gleich oder verschieden bei jedem Auftreten für eine geradkettige Alkylgruppe mit 1 bis 10 C-Atomen oder eine verzweigte oder cyclische Alkylgruppe mit 3 bis 10 C-Atomen oder ein aromatisches oder heteroaromatisches Ringsystem mit 6 bis 24 aromatischen Ringatomen, das jeweils durch einen oder mehrere Reste $R^1$ substituiert sein kann. Besonders bevorzugt steht R' gleich oder verschieden bei jedem Auftreten für eine geradkettige Alkylgruppe mit 1 bis 5 C-Atomen oder eine verzweigte oder cyclische Alkylgruppe mit 3 bis 6 C-Atomen oder ein aromatisches oder heteroaromatisches Ringsystem mit 6 bis 12 aromatischen Ringatomen, das jeweils durch einen oder mehrere Reste $R^1$ substituiert sein kann, bevorzugt aber unsubstituiert ist.

Im Folgenden werden bevorzugte Ausführungsformen der Gruppe der Formel (5) beschrieben. Die Gruppe der Formel (5) kann einen heteroaromatischen Fünfring oder einen aromatischen oder heteroaromatischen Sechsring darstellen. In einer bevorzugten Ausführungsform der Erfindung enthält die Gruppe der Formel (5) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn beide Gruppen $X^3$ in Formel (5) für Kohlenstoffatome stehen, sind bevorzugte Ausführungsformen der Gruppe der Formel (5) die Strukturen der folgenden Formeln (15) bis (31), und wenn eine Gruppe $X^3$ für ein Kohlenstoffatom und die andere Gruppe $X^3$ in demselben Cyclus für ein Stickstoffatom steht, sind bevorzugte Ausführungsformen der Gruppe der Formel (5) die Strukturen der folgenden Formeln (32) bis (39),

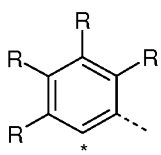
Formel (15)

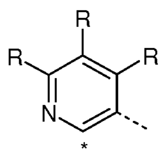
Formel (16)

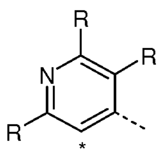
Formel (17)

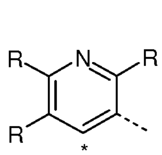
Formel (18)

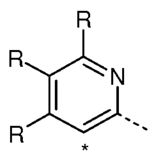
Formel (19)

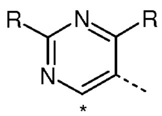
Formel (20)

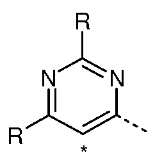
Formel (21)

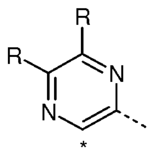
Formel (22)

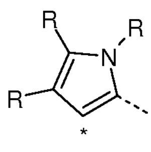
Formel (23)

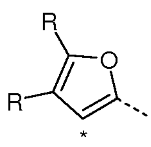
Formel (24)

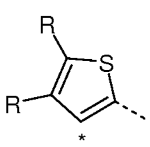
Formel (25)

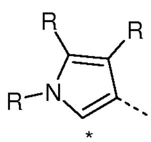
Formel (26)

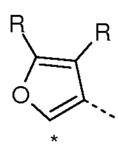
Formel (27)

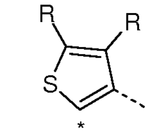
Formel (28)

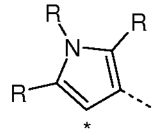
Formel (29)

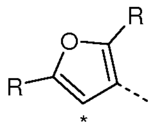
Formel (30)

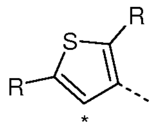
Formel (31)

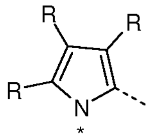
Formel (32)

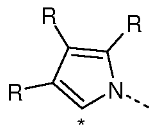
Formel (33)

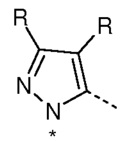
Formel (34)

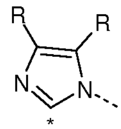
Formel (35)

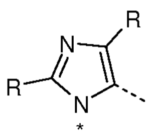
Formel (36)

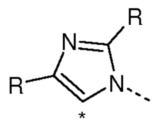
Formel (37)

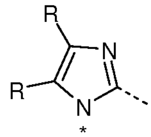
Formel (38)

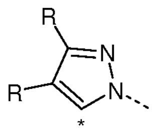
Formel (39)

wobei die Symbole die oben genannten Bedeutungen aufweisen.

Besonders bevorzugt sind die Sechsring-Aromaten und -Heteroaromaten der oben abgebildeten Formeln (15) bis (19). Ganz besonders bevorzugt ist ortho-Phenylen, also eine Gruppe der oben genannten Formel (15). Bevorzugt stehen dabei alle R für H.

Dabei können auch benachbarte Substituenten R miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (15) aufgeführt, was beispielsweise zu Gruppen der folgenden Formeln (15a) bis (15j) führen kann:

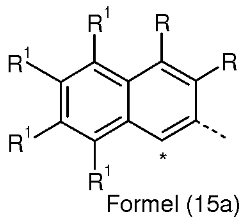
Formel (15a)

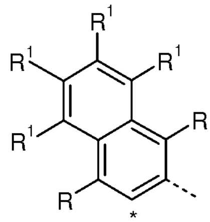
Formel (15b)

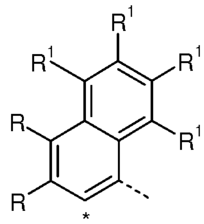
Formel (15b)

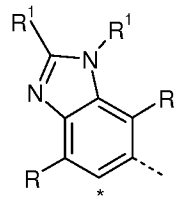
Formel (15d)

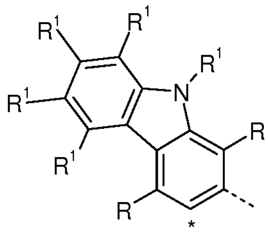
Formel (15e)

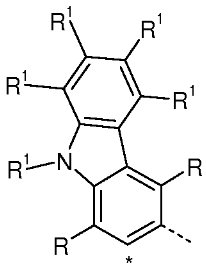
Formel (15f)

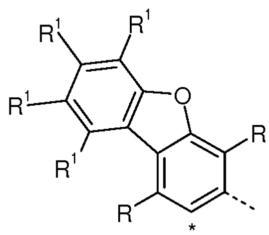
Formel (15g)

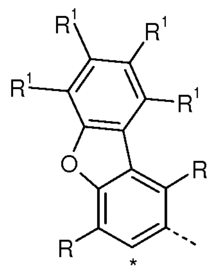
Formel (15h)

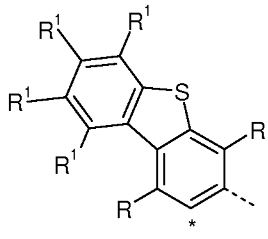

Formel (15i)

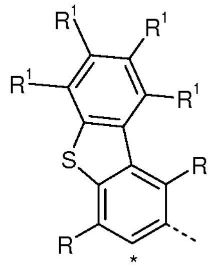

Formel (15j)

wobei die Symbole die oben genannten Bedeutungen aufweisen.

Generell können die ankondensierten Gruppen an jeder Position der Einheit gemäß Formel (5) ankondensiert sein, wie durch die ankondensierte Benzogruppe in den Formeln (15a) bis (15c) dargestellt. Die Gruppen, wie sie in den Formeln (15d) bis (15j) an die Einheit der Formel (5) ankondensiert sind, können daher auch an anderen Positionen der Einheit der Formel (5) ankondensiert werden.

Die Gruppe der Formel (3) kann besonders bevorzugt durch die folgenden Formeln (3a) bis (3m) dargestellt werden, und die Gruppe der Formel (4) kann besonders bevorzugt durch die folgenden Formeln (4a) bis (4m) dargestellt werden:

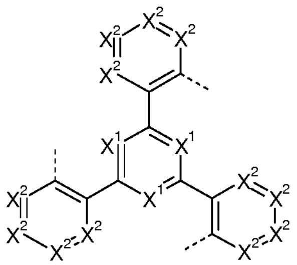

Formel (3a)

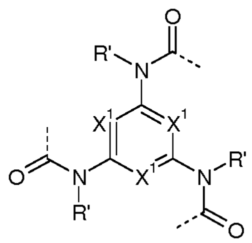

Formel (3b)

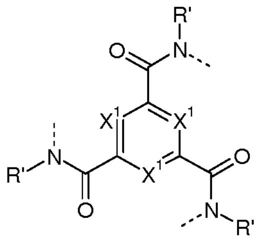

Formel (3c)

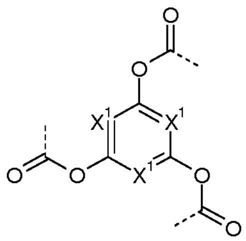

Formel (3d)

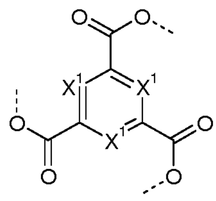

Formel (3e)

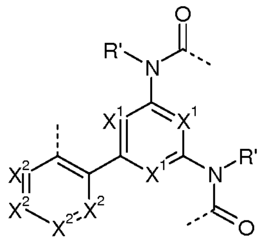

Formel (3f)

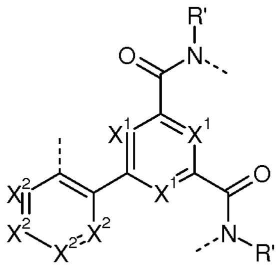

Formel (3g)

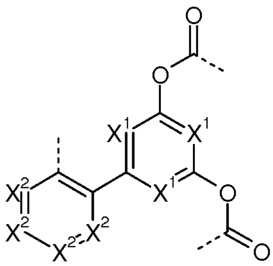

Formel (3h)

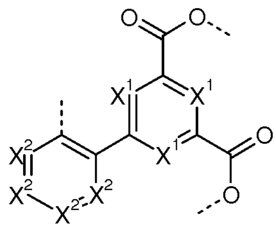

Formel (3i)

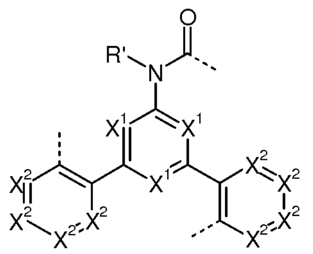
Formel (3j)

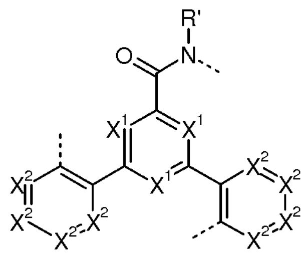
Formel (3k)

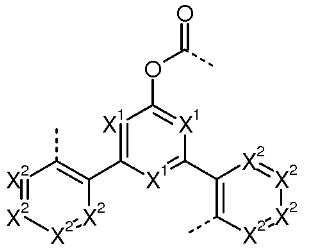
Formel (3l)

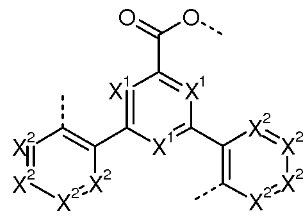
Formel (3m)

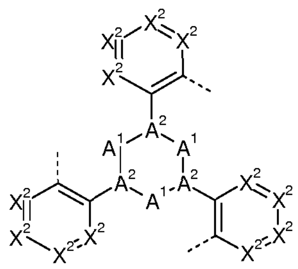
Formel (4a)

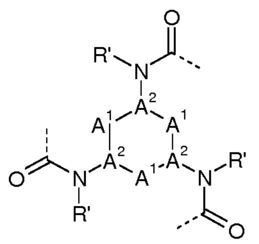
Formel (4b)

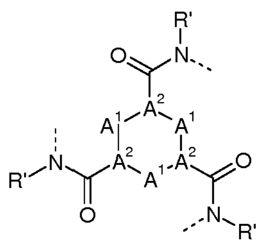
Formel (4c)

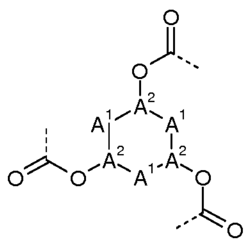
Formel (4d)

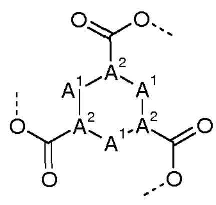
Formel (4e)

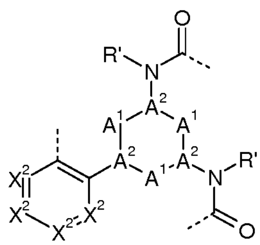
Formel (4f)

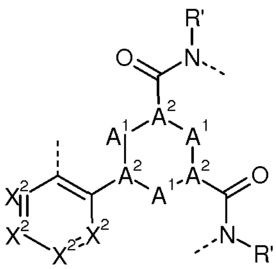
Formel (4g)

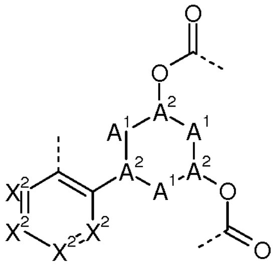
Formel (4h)

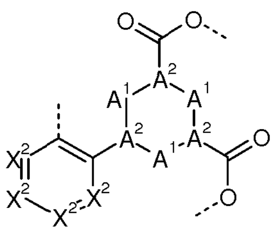
Formel (4i)

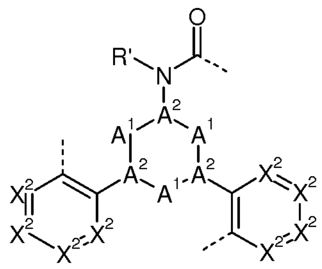

Formel (4j)

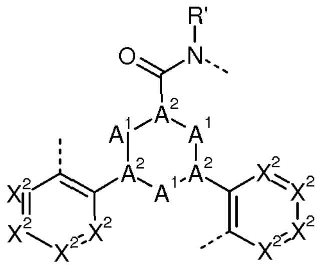

Formel (4k)

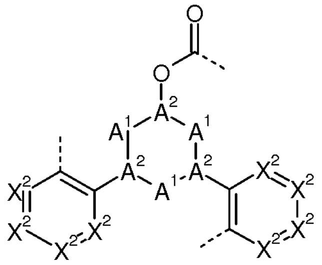

Formel (4l)

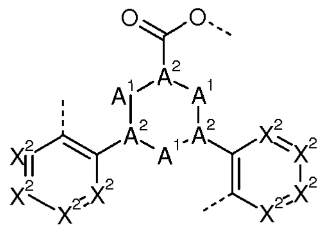

Formel (4m)

wobei die Symbole die oben genannten Bedeutungen aufweisen. Bevorzugt steht $X^2$ gleich oder verschieden bei jedem Auftreten für CR.

In einer bevorzugten Ausführungsform der Erfindung ist die Gruppe der Formeln (3a) bis (3m) ausgewählt aus den Gruppen der Formeln (6a') bis (6m') und die Gruppe der Formel (4a) bis (4m) aus den Gruppen der Formeln (10a') bis (10m'),

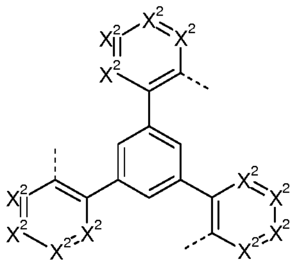

Formel (6a')

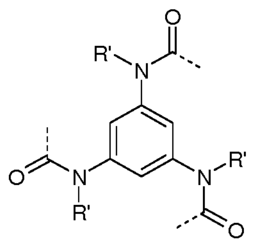

Formel (6b')

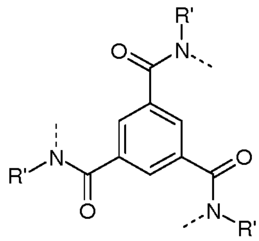

Formel (6c')

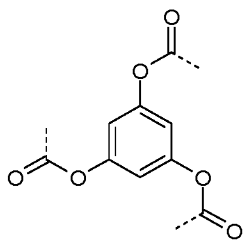

Formel (6d')

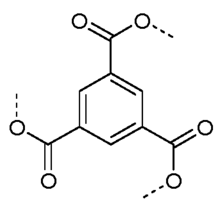

Formel (6e')

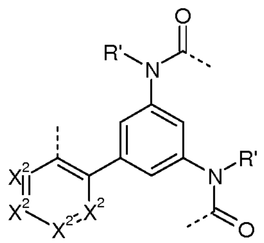

Formel (6f')

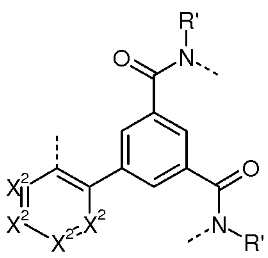

Formel (6g')

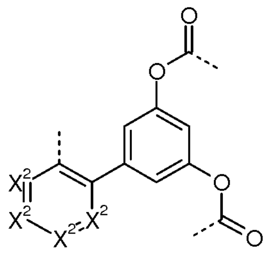

Formel (6h')

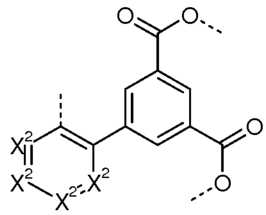

Formel (6i')

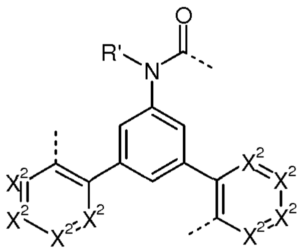

Formel (6j')

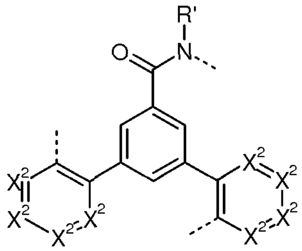

Formel (6k')

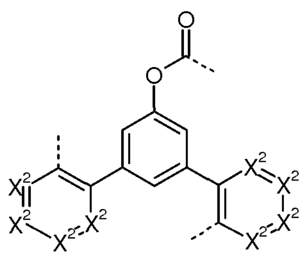

Formel (6l')

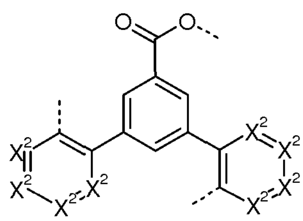

Formel (6m')

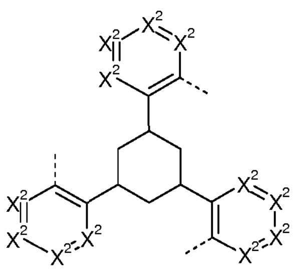

Formel (10a')

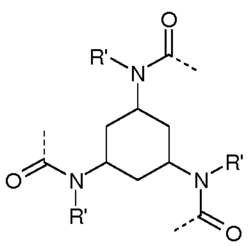

Formel (10b')

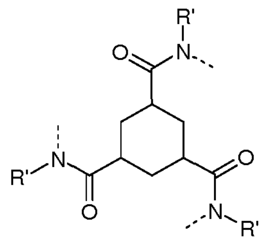

Formel (10c')

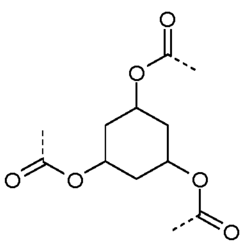

Formel (10d')

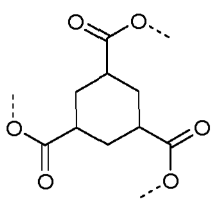

Formel (10e')

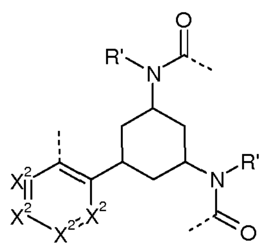

Formel (10f')

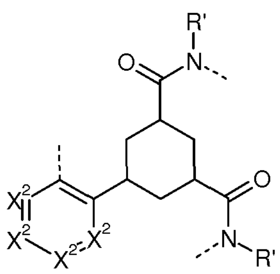

Formel (10g')

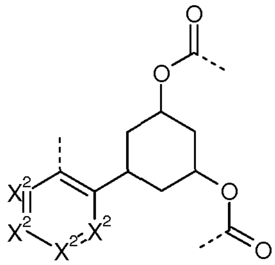

Formel (10h')

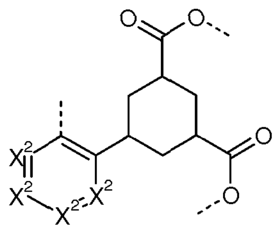

Formel (10i')

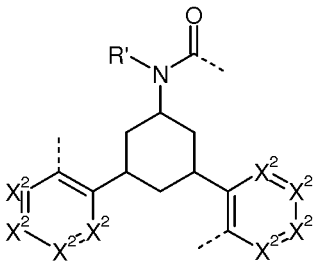

Formel (10j')

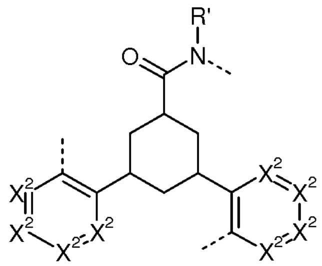

Formel (10k')

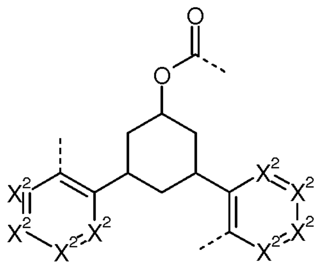

Formel (10l')

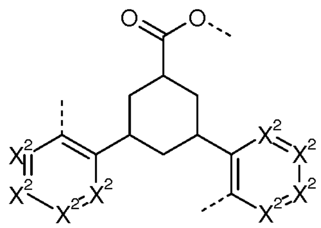

Formel (10m')

wobei die Symbole die oben genannten Bedeutungen aufweisen. Bevorzugt steht $X^2$ gleich oder verschieden bei jedem Auftreten für CR, insbesondere für CH.

Eine besonders bevorzugte Ausführungsform der Gruppe der Formel (3) ist die Gruppe der folgenden Formel (6a''),

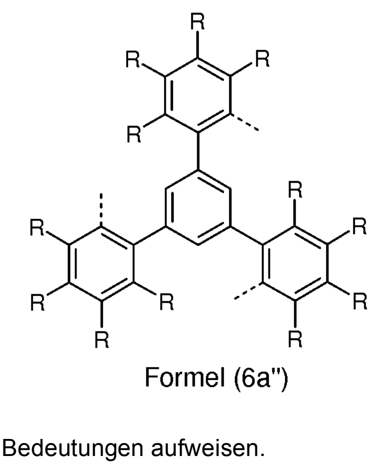

Formel (6a'')

wobei die Symbole die oben genannten Bedeutungen aufweisen.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt ist also die

Struktur der folgenden Formeln (6a'''),

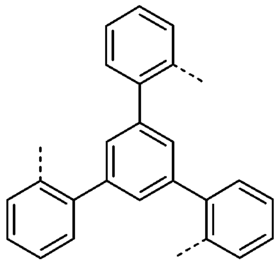

Formel (6a''')

wobei die Symbole die oben genannten Bedeutungen aufweisen.

Im Folgenden werden die bidentaten Teilliganden beschrieben, die in M mit der Brücke der Formel (3) oder (4) bzw. den oben genannten bevorzugten Ausführungsformen verknüpft sind.

Die drei bidentaten Teilliganden können gleich oder verschieden sein und sind bevorzugt monoanionisch. Wenn die bidentaten Teilliganden gleich sind, sind sie bevorzugt auch gleich substituiert. Wenn alle drei bidentaten Teilliganden gleich gewählt sind, entstehen dadurch $C_3$-symmetrische Iridiumkomplexe, wenn auch die Einheit der Formel (3) bzw. (4) $C_3$-symmetrisch ist, was vorteilhaft bezüglich der Synthese der Liganden ist. Es kann auch vorteilhaft sein, die drei bidentaten Teilliganden unterschiedlich zu wählen bzw. zwei Teilliganden gleich und den dritten Teilliganden davon verschieden zu wählen, so dass $C_1$-symmetrische Metallkomplexe entstehen, weil dies größere Variationsmöglichkeiten der Liganden zulässt, so dass sich die gewünschten Eigenschaften des Komplexes, wie beispielsweise die Lage von HOMO und LUMO bzw. die Emissionsfarbe leichter variieren lassen. Außerdem lässt sich so auch die Löslichkeit der Komplexe verbessern, ohne lange aliphatische oder aromatische, löslichkeitsvermittelnde Gruppen anbringen zu müssen. In einer bevorzugten Ausführungsform der Erfindung sind die drei bidentaten Teilliganden entweder gleich gewählt oder zwei der bidentaten Teilliganden sind gleich gewählt und der dritte bidentate Teilligand ist unterschiedlich von den ersten beiden bidentaten Teilliganden.

In einer weiteren bevorzugten Ausführungsform der Erfindung sind die koordinierenden Atome der bidentaten Teilliganden gleich oder verschieden bei jedem Auftreten ausgewählt aus C, N, P, O, S und/oder B, besonders bevorzugt C, N und/oder O und ganz besonders bevorzugt C und/oder N. Dabei weisen die bidentaten Teilliganden bevorzugt ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Dabei können die koordinierenden Atome von jedem der drei Teilliganden gleich sein, oder sie können unterschiedlich sein. Bevorzugt weist mindestens einer der bidentaten Teilliganden ein Kohlenstoffatom und ein Stickstoffatom oder zwei Kohlenstoffatome als koordinierende Atome auf, insbesondere ein Kohlenstoffatom und ein Stickstoffatom. Besonders bevorzugt weisen mindestens zwei der bidentaten Teilliganden und ganz besonders bevorzugt alle drei bidentaten Teilliganden ein Kohlenstoffatom und ein Stickstoffatom oder zwei Kohlenstoffatome als koordinierende Atome auf, insbesondere ein Kohlenstoffatom und ein Stickstoffatom. Besonders bevorzugt handelt es sich somit um einen Iridiumkomplex, in dem alle drei bidentaten Teilliganden ortho-metalliert sind, d. h. mit dem Iridium einen Metallacyclus bilden, in dem mindestens eine Iridium-Kohlenstoff-Bindung vorliegt.

Es ist weiterhin bevorzugt, wenn es sich bei dem Metallacyclus, der aus dem Iridium und dem bidentaten Teilliganden aufgespannt wird, um einen Fünfring handelt, der vor allem dann bevorzugt ist, wenn die koordinierenden Atome C und N, N und N oder N und O sind. Wenn es sich bei den koordinierenden Atomen um O handelt, kann auch ein Metallasechsring bevorzugt sein. Dies wird im Folgenden schematisch dargestellt:

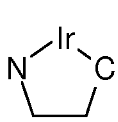

Fünfring

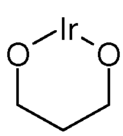

Sechsring

wobei N ein koordinierendes Stickstoffatom, C ein koordinierendes Kohlenstoffatom und O koordinierende Sauerstoffatome darstellen und die eingezeichneten Kohlenstoffatome Atome des bidentaten Liganden darstellen.

In einer bevorzugten Ausführungsform der Erfindung ist mindestens einer der bidentaten Teilliganden, besonders bevorzugt mindestens zwei der bidentaten Teilliganden, ganz besonders bevorzugt alle drei bidentaten Teilliganden gleich oder verschieden bei jedem Auftreten ausgewählt aus den Strukturen der folgenden Formeln (L-1), (L-2) oder (L-3),

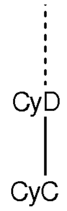
Formel (L-1)

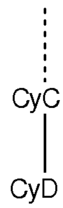
Formel (L-2)

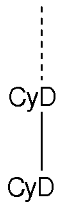
Formel (L-3)

wobei die gestrichelte Bindung die Bindung des Teilliganden an die Brücke der Formeln (3) bzw. (4) bzw. die bevorzugten Ausführungsformen darstellt und für die weiteren verwendeten Symbole gilt:

CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche jeweils über eine kovalente Bindung mit CyD verbunden ist;

CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;

dabei können mehrere der optionalen Substituenten miteinander ein Ringsystem bilden; weiterhin sind die optionalen Reste bevorzugt ausgewählt aus den oben genannten Resten R.

Dabei koordiniert CyD in den Teilliganden der Formeln (L-1) und (L-2) bevorzugt über ein neutrales Stickstoffatom oder über ein Carben-Kohlenstoffatom, insbesondere über ein neutrales Stickstoffatom. Weiterhin bevorzugt koordiniert eine der beiden Gruppen CyD in dem Liganden der Formel (L-3) über ein neutrales Stickstoffatom und die andere der beiden Gruppen CyD über ein anionisches Stickstoffatom. Weiterhin bevorzugt koordiniert CyC in den Teilliganden der Formeln (L-1) und (L-2) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, insbesondere Phenyl, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20),

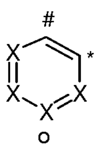
(CyC-1)

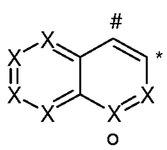
(CyC-2)

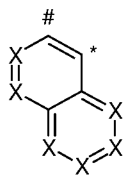
(CyC-3)

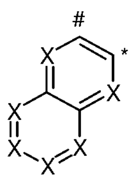
(CyC-4)

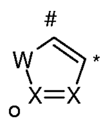
(CyC-5)

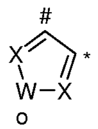
(CyC-6)
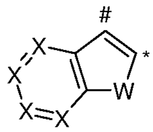
(CyC-7)
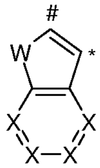
(CyC-8)
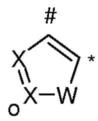
(CyC-9)

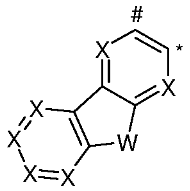
(CyC-10)
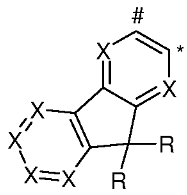
(CyC-11)
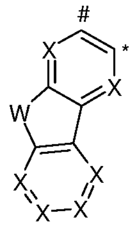
(CyC-12)
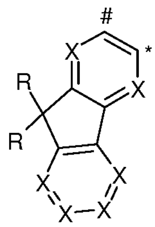
(CyC-13)

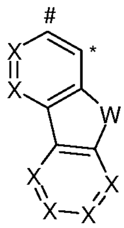
(CyC-14)
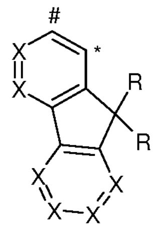
(CyC-15)
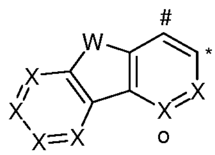
(CyC-16)
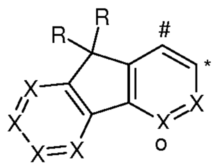
(CyC-17)

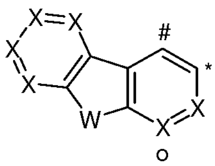
(CyC-18)
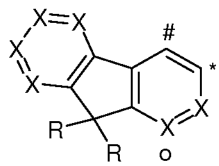
(CyC-19)
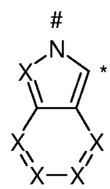
(CyC-20)

wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:

X ist bei jedem Auftreten gleich oder verschieden CR oder N mit der Maßgabe, dass maximal zwei Symbole X pro Cyclus für N stehen;

W ist NR, O oder S;

mit der Maßgabe, dass, wenn die Brücke der Formeln (3) bzw. (4) bzw. die bevorzugten Ausführungsformen an CyC gebunden ist, ein Symbol X für C steht und die Brücke der Formeln (3) bzw. (4) bzw. die bevorzugten Ausführungsformen an dieses Kohlenstoffatom gebunden ist und weiterhin mit der Maßgabe, dass, wenn die Gruppe Ar an CyC gebunden ist, ein Symbol X für C steht und die Gruppe Ar an dieses Kohlenstoffatom gebunden ist. Wenn die Gruppe CyC an die Brücke der Formeln (3) bzw. (4) bzw. die bevorzugten Ausführungsformen gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formeln (3) bzw. (4) bzw. die bevorzugten Ausführungsformen gebunden, da eine solche Bindung an die Brücke aus sterischen Gründen nicht vorteilhaft ist.

Bevorzugt steht maximal ein Symbol X in CyC für N, besonders bevorzugt stehen alle Symbole X für CR, mit der Maßgabe, dass, wenn die Brücke der Formeln (3) bzw. (4) bzw. die bevorzugten Ausführungsformen an CyC

gebunden ist, ein Symbol X für C steht und die Brücke der Formeln (3) bzw. (4) bzw. die bevorzugten Ausführungsformen an dieses Kohlenstoffatom gebunden ist, und dass, wenn die Gruppe Ar an CyC gebunden ist, ein Symbol X für C steht und die Gruppe Ar an dieses Kohlenstoffatom gebunden ist.

Besonders bevorzugte Gruppen CyC sind die Gruppen der folgenden Formeln (CyC-1a) bis (CyC-20a),

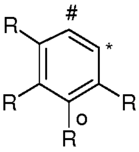
(CyC-1a)

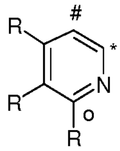
(CyC-1b)

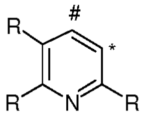
(CyC-1c)

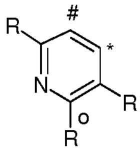
(CyC-1d)

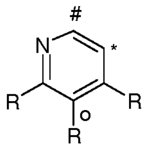
(CyC-1e)

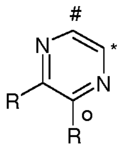
(CyC-1f)

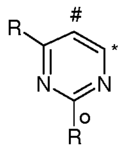
(CyC-1g)

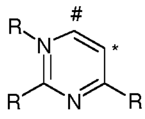
(CyC-1h)

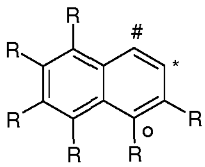
(CyC-2a)

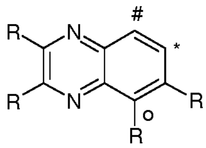
(CyC-2b)

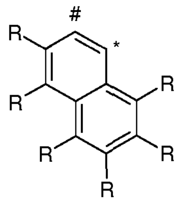
(CyC-3a)

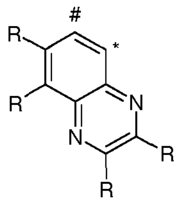
(CyC-3b)

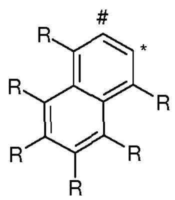
(CyC-4a)

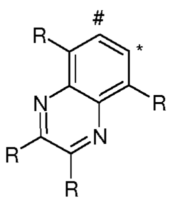
(CyC-4b)

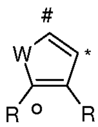
(CyC-5a)

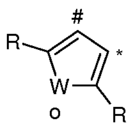
(CyC-6a)

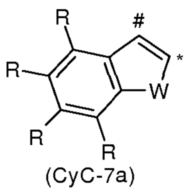
(CyC-7a)

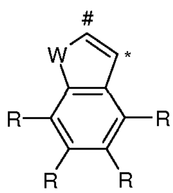
(CyC-8a)

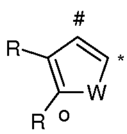
(CyC-9a)

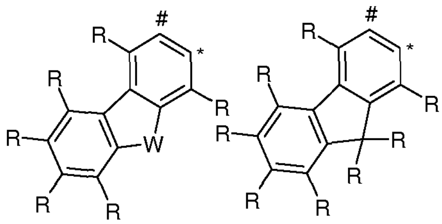
(CyC-10a) (CyC-11a)

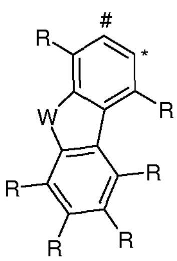
(CyC-12a)

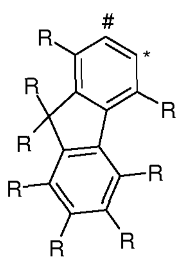
(CyC-13a)

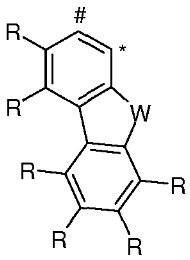
(CyC-14a)

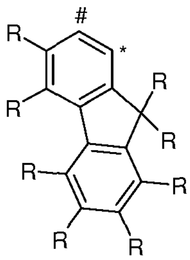
(CyC-15a)

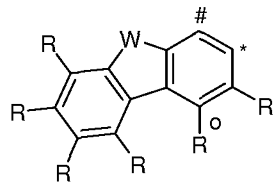
(CyC-16a)

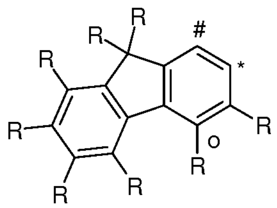
(CyC-17a)

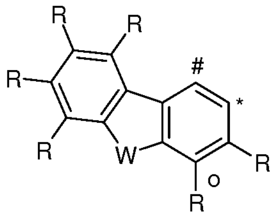
(CyC-18a)

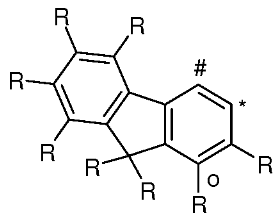
(CyC-19a)

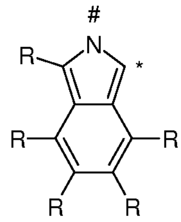
(CyC-20a)

wobei die Symbole die oben genannten Bedeutungen aufweisen und, wenn die Brücke der Formel (3) bzw. (4) bzw. die bevorzugten Ausführungsformen an CyC gebunden ist, ein Rest R nicht vorhanden ist und die Brücke der Formel (3) bzw. (4) bzw. die bevorzugten Ausführungsformen an das entsprechende Kohlenstoffatom gebunden ist und weiterhin mit der Maßgabe, dass, wenn die Gruppe Ar an CyC gebunden ist, ein Rest R nicht vorhanden ist und die Gruppe Ar an das entsprechende Kohlenstoffatom gebunden ist. Wenn die Gruppe CyC an die Brücke der Formeln (3) bzw. (4) bzw. die bevorzugten Ausführungsformen gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke der Formeln (3) bzw. (4) bzw. die bevorzugten Ausführungsformen gebunden.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist. Bevorzugte Ausführungsformen der Gruppe CyD sind die Strukturen der folgenden Formeln (CyD-1) bis (CyD-14),

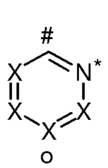
(CyD-1)

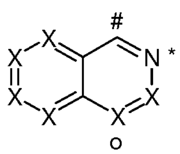
(CyD-2)

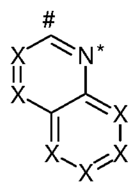
(CyD-3)

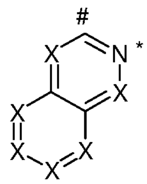
(CyD-4)

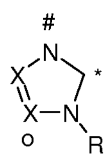
(CyD-5)

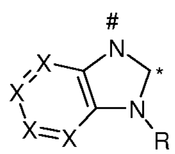
(CyD-6)

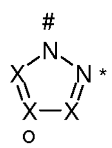
(CyD-7)

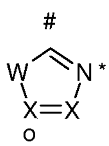
(CyD-8)

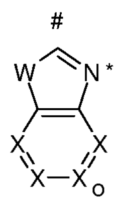
(CyD-9)

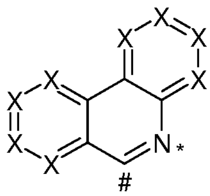
(CyD-10)

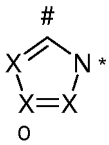
(CyD-11)

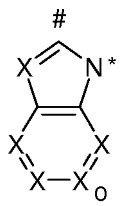
(CyD-12)

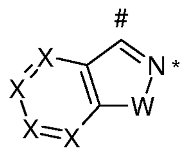
(CyD-13)

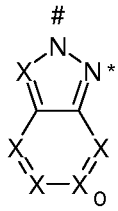
(CyD-14)

wobei die Gruppe CyD jeweils an der durch # gekennzeichneten Position an CyC bindet und an der durch * gekennzeichneten Position an das Metall koordiniert und wobei X, W und R die oben genannten Bedeutungen aufweisen, mit der Maßgabe, dass, wenn die Brücke der Formeln (3) bzw. (4) bzw. die bevorzugten Ausführungsformen an CyD gebunden ist, ein Symbol X für C steht und die Brücke der Formeln (3) bzw. (4) bzw. die bevorzugten Ausführungsformen an dieses Kohlenstoffatom gebunden ist und weiterhin mit der Maßgabe, dass, wenn die Gruppe Ar an CyD gebunden ist, ein Symbol X für C steht und die Gruppe Ar an dieses Kohlenstoffatom gebunden ist. Wenn die Gruppe CyD an die Brücke der Formeln (3) bzw. (4) bzw. die bevorzugten Ausführungsformen gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formeln (3) bzw. (4) bzw. die bevorzugten Ausführungsformen gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt steht maximal ein Symbol X in CyD für N, besonders bevorzugt stehen alle Symbole X für CR, mit der Maßgabe, dass, wenn die Brücke der Formeln (3) bzw. (4) bzw. die bevorzugten Ausführungsformen an CyD gebunden ist, ein Symbol X für C steht und die Brücke der Formeln (3) bzw. (4) bzw. die bevorzugten Ausführungsformen an dieses Kohlenstoffatom gebunden ist. Weiterhin gilt, dass, wenn die Gruppe Ar an CyD gebunden ist, ein Symbol X für C steht und die Gruppe Ar an dieses Kohlenstoffatom gebunden ist.

Besonders bevorzugte Gruppen CyD sind die Gruppen der folgenden Formeln (CyD-1 a) bis (CyD-14b),

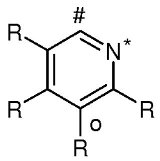
(CyD-1a)

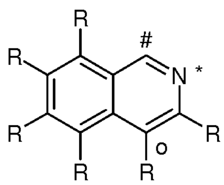
(CyD-2a)

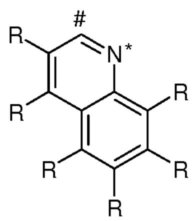
(CyD-3a)

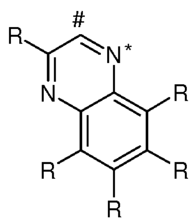
(CyD-3b)

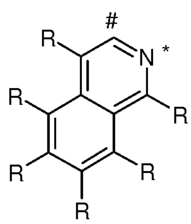
(CyD-4a)

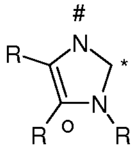
(CyD-5a)

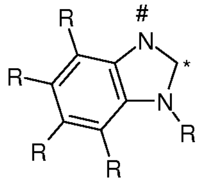
(CyD-6a)

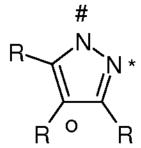
(CyD-7a)

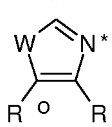
(CyD-8a)

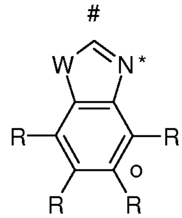
(CyD-9a)

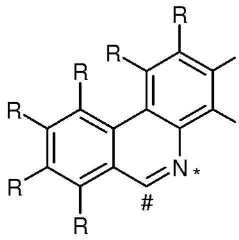

(CyD-10a)

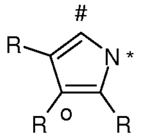

(CyD-11a)

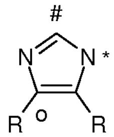

(CyD-11b)

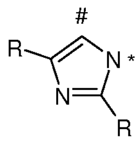

(CyD-11c)

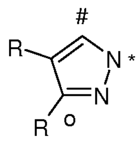

(CyD-11d)

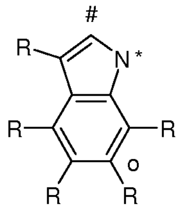

(CyD-12a)

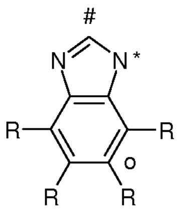

(CyD-12b)

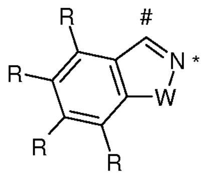

(CyD-13a)

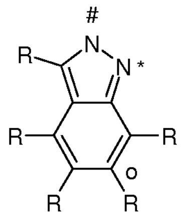

(CyD-14a)

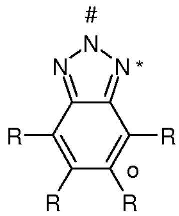

(CyD-14b)

wobei die verwendeten Symbole die oben genannten Bedeutungen aufweisen und, wenn die Brücke der Formeln (3) bzw. (4) bzw. die bevorzugten Ausführungsformen an CyD gebunden ist, ein Rest R nicht vorhanden ist und die Brücke der Formel (3) bzw. (4) bzw. die bevorzugten Ausführungsformen an das entsprechende Kohlenstoffatom gebunden ist und weiterhin mit der Maßgabe, dass, wenn die Gruppe Ar an CyD gebunden ist, ein Rest R nicht vorhanden ist und die Gruppe Ar an das entsprechende Kohlenstoffatom gebunden ist. Wenn die Gruppe CyD an die Brücke der Formeln (3) bzw. (4) bzw. die bevorzugten Ausführungsformen gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke der Formeln (3) bzw. (4) bzw. die bevorzugten Ausführungsformen gebunden. Weiterhin gilt, dass, wenn die Gruppe Ar an CyD gebunden ist, eine Position nicht mit einem Rest R substituiert ist und die Gruppe Ar an dieses Kohlenstoffatom gebunden ist.

Bevorzugte Gruppen unter den Gruppen (CyD-1) bis (CyD-14) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1 a), (CyD-2a), (CyD-3a), (CyD-4a), (CyD-5a) und (CyD-6a), insbesondere (CyD-1 a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen, insbesondere Phenyl, und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Brücke der Formel (3) bzw. (4) bzw. die bevorzugten Ausführungsformen aufweist, wobei geeignete Anknüpfungsstellen in den oben genannten Formeln mit "o" gekennzeichnet sind. Insbesondere bevorzugt ist es, wenn die oben als besonders bevorzugt genannten Gruppen CyC und CyD, also die Gruppen der Formeln (CyC-1 a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Brücke der Formel (3) bzw. (4) bzw. die bevorzugten Ausführungsformen aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Brücke der Formel (3) bzw. (4) bzw. die bevorzugten Ausführungsformen aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte

Teilliganden (L-2) sind die Strukturen der folgenden Formeln (L-2-1) bis (L-2-3),

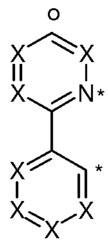
(L-1-1)

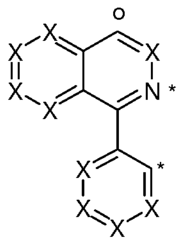
(L-1-2)

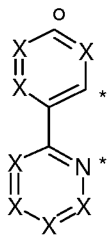
(L-2-1)

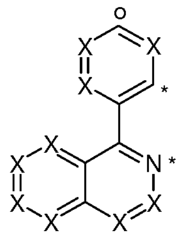
(L-2-2)

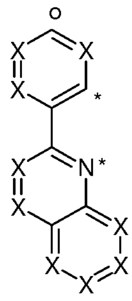
(L-2-3)

wobei die verwendeten Symbole die oben genannten Bedeutungen aufweisen, * die Position der Koordination an das Iridium darstellt und "o" die Position der Bindung an die Brücke der Formel (3) bzw. (4) bzw. die bevorzugten Ausführungsformen darstellt und mit der Maßgabe, dass, wenn die Gruppe Ar den Teilliganden gebunden ist, ein Symbol X für C steht und die Gruppe Ar an dieses Kohlenstoffatom gebunden ist.

Besonders bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1a) bis (L-2-3a),

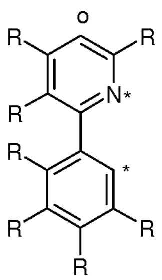
(L-1-1a)

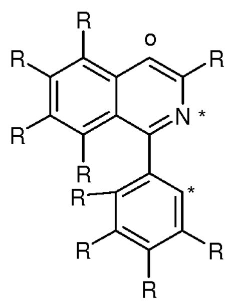
(L-1-2a)

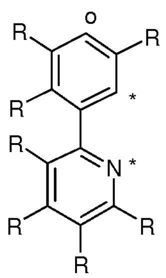
(L-2-1a)

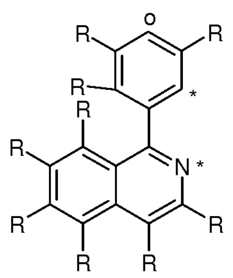
(L-2-2a)

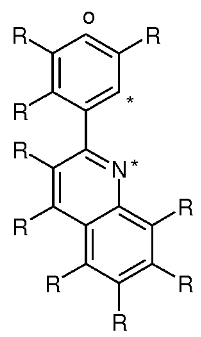
(L-2-3a)

wobei die verwendeten Symbole die oben genannten Bedeutungen aufweisen und "o" die Position der Bindung an die Brücke der Formel (3) bzw. (4) bzw. die bevorzugten Ausführungsformen darstellt und mit der Maßgabe, dass, wenn die Gruppe Ar an den Teilliganden gebunden ist, ein Rest R nicht vorhanden ist und die Gruppe Ar an dieses Kohlenstoffatom gebunden ist.

Ebenso können die oben genannten bevorzugten Gruppen CyD in den Teilliganden der Formel (L-3) beliebig miteinander kombiniert werden, wobei es bevorzugt ist, eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12), zu kombinieren, sofern mindestens eine der bevorzugten Gruppen CyD eine geeignete Anknüpfungsstelle an die Brücke der Formel (3) bzw. (4) bzw. die bevorzugten Ausführungsformen aufweist, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden

sind, miteinander ein aromatisches Ringsystem bilden, können sich überbrückte Teilliganden und beispielsweise auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (40) bis (49),

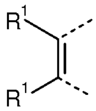
Formel (40)

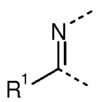
Formel (41)

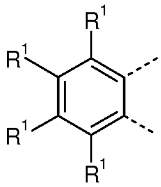
Formel (42)

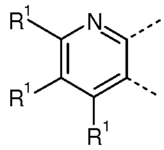
Formel (43)

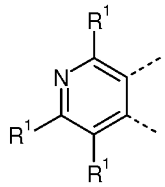
Formel (44)

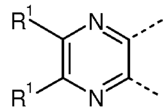
Formel (45)

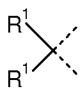
Formel (46)

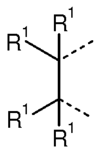
Formel (47)

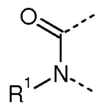
Formel (48)

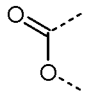
Formel (49)

wobei $R^1$ die oben genannten Bedeutungen aufweist und die gestrichelten Bindungen die Bindungen an CyC bzw. CyD andeuten. Dabei können die unsymmetrischen der oben genannten Gruppen in jeder der beiden Orientierungen eingebaut werden, beispielsweise kann bei der Gruppe der Formel (49) das Sauerstoffatom an die Gruppe CyC und die Carbonyl-gruppe an die Gruppe CyD binden, oder das Sauerstoffatom kann an die Gruppe CyD und die Carbonylgruppe an die Gruppe CyC binden. Dabei kann die Gruppe Ar auch an eine dieser Gruppen gebunden sein.

Dabei ist die Gruppe der Formel (46) besonders dann bevorzugt, wenn sich dadurch die Ringbildung zu einem Sechsring ergibt, wie beispielsweise unten durch die Formeln (L-22) und (L-23) dargestellt.

Bevorzugte Liganden, die durch Ringbildung zweier Reste R an den unterschiedlichen Cyclen entstehen, sind die im Folgenden aufgeführten Strukturen der Formeln (L-4) bis (L-31),

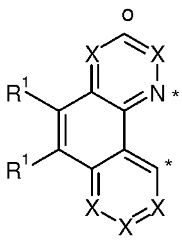
(L-4)

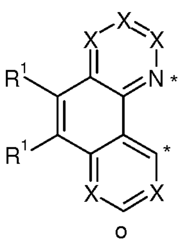
(L-5)

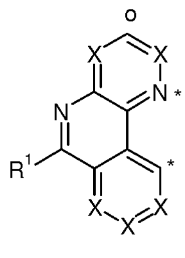
(L-6)

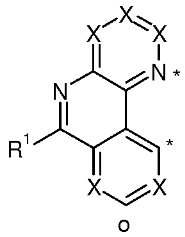
(L-7)

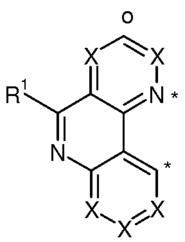
(L-8)

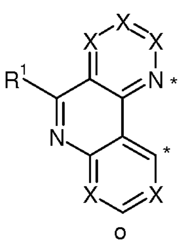
(L-9)

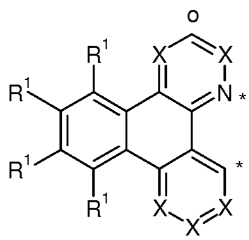
(L-10)

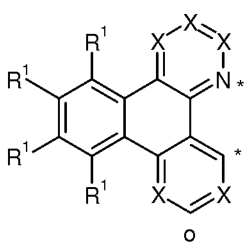
(L-11)

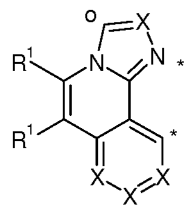
(L-12)

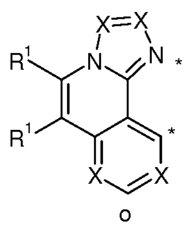
(L-13)

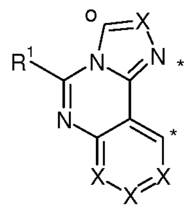
(L-14)

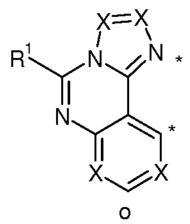
(L-15)

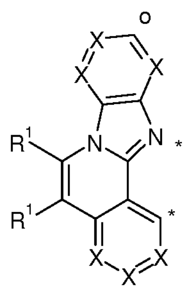
(L-16)

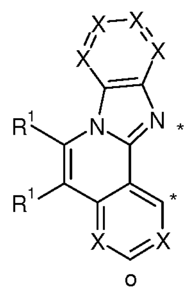
(L-17)

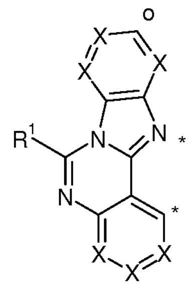
(L-18)

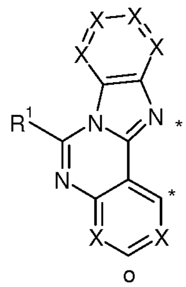
(L-19)

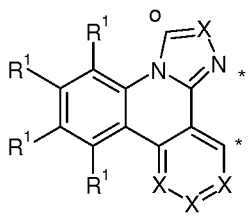
(L-20)

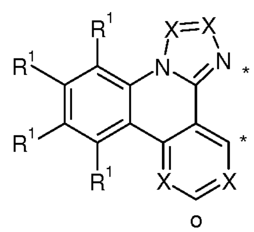
(L-21)

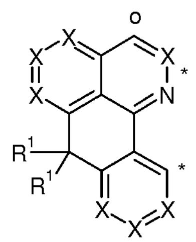
(L-22)

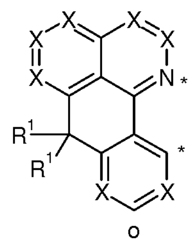
(L-23)

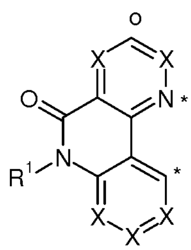
(L-24)

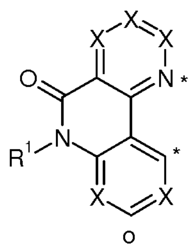
(L-25)

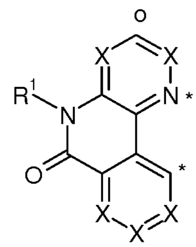
(L-26)

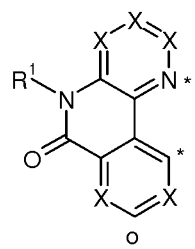
(L-27)

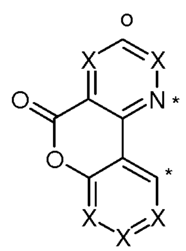
(L-28)

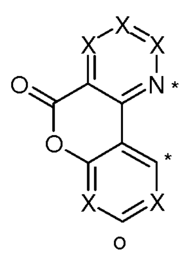
(L-29)

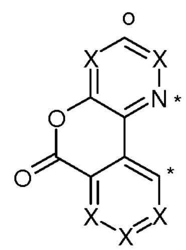
(L-30)

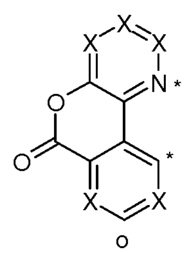
(L-31)

wobei die verwendeten Symbole die oben genannten Bedeutungen aufweisen und "o" die Position angibt, an denen dieser Teilligand mit der Gruppe der Formel (3) bzw. (4) bzw. den bevorzugten Ausführungsformen verknüpft ist und

mit der Maßgabe, dass, wenn die Gruppe Ar an diesen Teilliganden gebunden ist, ein Symbol X für C steht und die Gruppe Ar an dieses Kohlenstoffatom gebunden ist

In einer bevorzugten Ausführungsform der Teilliganden der Formeln (L-4) bis (L-31) steht insgesamt ein Symbol X für N und die anderen Symbole X stehen für CR, oder alle Symbole X stehen für CR mit der Maßgabe, dass, wenn die Gruppe Ar an diesen Teilliganden gebunden ist, ein Symbol X für C steht und die Gruppe Ar an dieses Kohlenstoffatom gebunden ist.

In einer weiteren Ausführungsform der Erfindung ist es bevorzugt, falls in den Gruppen (CyC-1) bis (CyC-20) oder (CyD-1) bis (CyD-14) oder in den Teilliganden (L-1-1) bis (L-2-3) und (L-4) bis (L-31) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus $CF_3$, $OCF_3$, $OR^1$, Alkylgruppen mit 1 bis 10 C-Atomen, insbesondere verzweigten oder cyclischen Alkylgruppen mit 3 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand ist der Teilligand der folgenden Formel (L-32) oder (L-33),

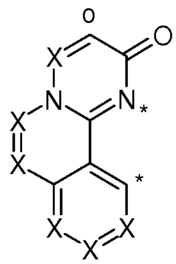

(L-32)

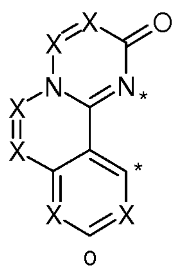

(L-33)

wobei R die oben genannten Bedeutungen aufweist, * die Position der Koordination an das Metall darstellt, "o" die Position der Verknüpfung des Teilliganden mit der Gruppe der Formeln (3) bzw. (4) bzw. den bevorzugten Ausführungsformen darstellt und für die weiteren verwendeten Symbole gilt:

X ist bei jedem Auftreten gleich oder verschieden CR oder N mit der Maßgabe, dass maximal ein Symbol X pro Cyclus für N steht und weiterhin mit der Maßgabe, dass ein Symbol X für C steht und an dieses Kohlenstoffatom die Gruppe der Formel (3) bzw. (4) bzw. die bevorzugten Ausführungsformen gebunden sind und weiterhin mit der Maßgabe, dass, wenn die Gruppe Ar an diesen Teilliganden gebunden ist, ein Symbol X für C steht und die Gruppe Ar an dieses Kohlenstoffatom gebunden ist.

Wenn zwei Reste R, die in den Teilliganden (L-32) bzw. (L-33) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (50),

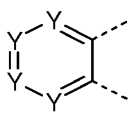

Formel (50)

wobei die gestrichelten Bindungen die Verknüpfung dieser Gruppe im Teilliganden symbolisieren und Y gleich oder verschieden bei jedem Auftreten für $CR^1$ oder N steht und bevorzugt maximal ein Symbol Y für N steht. Dabei kann die Gruppe Ar auch an diese Gruppe gebunden sein.

In einer bevorzugten Ausführungsform des Teilliganden (L-32) bzw. (L-33) ist maximal eine Gruppe der Formel (50) vorhanden. Es handelt sich also bevorzugt um Teilliganden der folgenden Formeln (L-34) bis (L-39),

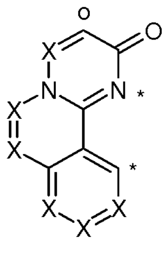
(L-34)

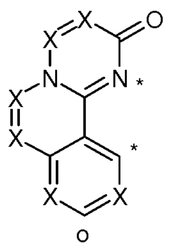
(L-35)

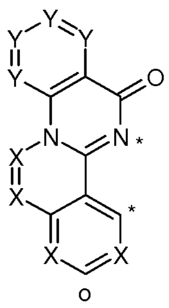
(L-36)

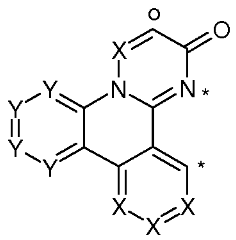
(L-37)

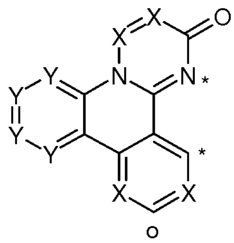
(L-38)

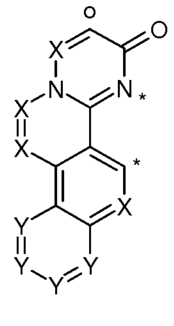
(L-39)

wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen, mit der Maßgabe, dass, wenn die Gruppe Ar an diesen Teilliganden gebunden ist, ein Symbol X für C steht und die Gruppe Ar an dieses Kohlenstoffatom gebunden ist.

In einer bevorzugten Ausführungsform der Erfindung stehen im Teilliganden der Formel (L-32) bis (L-39) insgesamt 0, 1 oder 2 der Symbole X und, falls vorhanden, Y für N. Besonders bevorzugt stehen insgesamt 0 oder 1 der Symbole X und, falls vorhanden, Y für N.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist. Dabei ist dieser Substituent R bevorzugt eine Gruppe, ausgewählt aus $CF_3$, $OCF_3$, $OR^1$, Alkylgruppen mit 1 bis 10 C-Atomen, insbesondere verzweigten oder cyclischen Alkylgruppen mit 3 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Weitere geeignete bidentate Teilliganden sind die Strukturen der folgenden Formeln (L-40) bis (L-44), wobei bevorzugt maximal einer der drei bidentaten Teilliganden für eine dieser Strukturen steht,

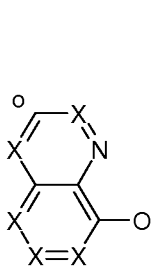
(L-40)

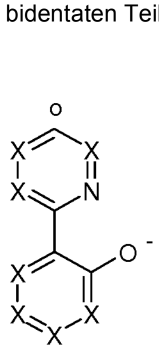
(L-41)

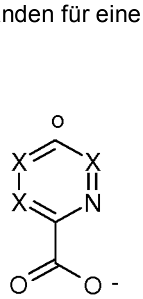
(L-42)

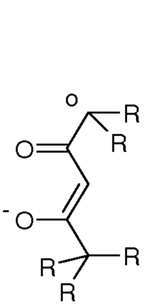
(L-43)

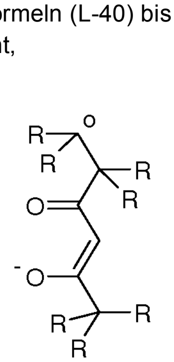
(L-44)

wobei die Teilliganden (L-40) bis (L-42) jeweils über das explizit eingezeichnete Stickstoffatom und das negativ geladene Sauerstoffatom und die Teilliganden (L-43) und (L-44) über die beiden Sauerstoffatome an das Metall koordinieren, X die oben genannten Bedeutungen aufweist und "o" die Position angibt, über die der Teilligand mit der Gruppe der Formel (3) bzw. (4) bzw. den bevorzugten Ausführungsformen verknüpft ist, mit der Maßgabe, dass, wenn die Gruppe Ar an diesen Teilliganden gebunden ist, ein Symbol X für C steht und die Gruppe Ar an dieses Kohlenstoffatom gebunden ist.

Die oben ausgeführten bevorzugten Ausführungsformen für X sind auch bevorzugt für die Teilliganden der Formeln (L-40) bis (L-42). Bevorzugte Teilliganden der Formeln (L-40) bis (L-42) sind daher die Teilliganden der folgenden Formeln (L-40a) bis (L-42a),

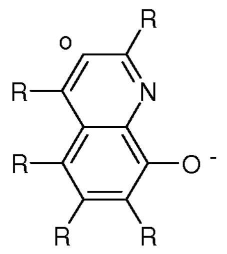
(L-40a)

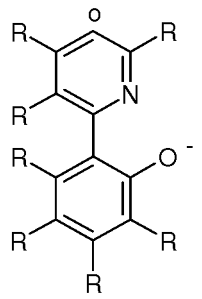
(L-41a)

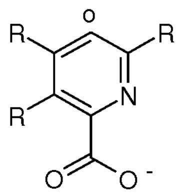
(L-42a)

wobei die verwendeten Symbole die oben genannten Bedeutungen aufweisen und "o" die Position angibt, über die der Teilligand mit der Gruppe der Formel (3) bzw. (4) bzw. den bevorzugten Ausführungsformen verknüpft ist, mit der Maßgabe, dass, wenn die Gruppe Ar an diesen Teilliganden gebunden ist, ein Rest R nicht vorhanden ist und die Gruppe Ar an das entsprechende Kohlenstoffatom gebunden ist.

Besonders bevorzugt steht in diesen Formeln R für Wasserstoff, wobei "o" die Position angibt, über die der Teilligand mit der Gruppe der Formel (3) bzw. (4) bzw. den bevorzugten Ausführungsformen verknüpft ist, so dass es sich um die Strukturen der folgenden Formeln (L-40b) bis (L-42b) handelt,

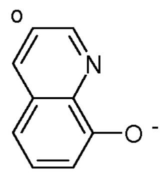
(L-40b)

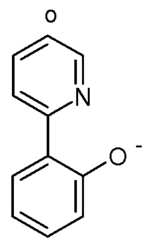
(L-41b)

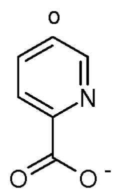
(L-42b)

wobei die verwendeten Symbole die oben genannten Bedeutungen aufweisen.

In einer weiteren bevorzugten Ausführungsform der Erfindung handelt es sich bei dem Komplex M um einen Iridiumkomplex, in dem drei bidentate Liganden, die gleich oder verschieden sein können, an ein Iridiumatom koordinieren. Dabei bindet die Gruppe $-[[[Ar]_p-B]_m-R^B]$ an einen der drei bidentaten Liganden bzw., wenn mehrere dieser Gruppen vorhanden sind, auch an zwei oder drei der bidentaten Liganden.

Die bidentaten Liganden sind bevorzugt ausgewählt aus den Strukturen gemäß den folgenden Formeln (L-1') oder (L-3'),

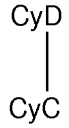
Formel (L-1')

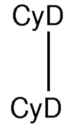
Formel (L-3')

wobei die Symbole die oben genannten Bedeutungen aufweisen.

Dabei gelten für die Liganden der Formeln (L-1') und (L-3') dieselben Bevorzugungen, wie oben für die Teilliganden (L-1), (L-2) und (L-3) beschrieben, mit dem Unterschied, dass die Liganden der Formeln (L-1') und (L-3') nicht an eine Brücke der Formel (3) oder (4) gebunden sind.

In einer weiteren bevorzugten Ausführungsform der Erfindung ist M ein organometallischer Platinkomplex. Wenn M ein organometallischer Platinkomplex mit zwei bidentaten Liganden ist, dann sind diese gleich oder verschieden bevorzugt ausgewählt aus den oben abgebildeten Liganden der Formeln (L-1') und (L-3'), wobei hierfür auch die oben genannten Bevorzugungen gelten.

Wenn M ein organometallischer Platinkomplex mit einem tetradentaten Liganden ist, dann kann dieser schematisch durch die folgende Formel (Lig') dargestellt werden:

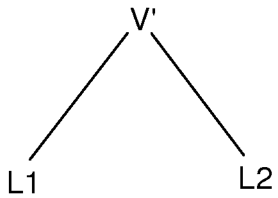

(Lig')

wobei V' bevorzugt ausgewählt ist aus $CR_2$, NR, O, S und BR, besonders bevorzugt $CR_2$ und NR, wobei R die oben genannten Bedeutungen aufweist, und L1 und L2 gleich oder verschieden bei jedem Auftreten jeweils bidentate Teilliganden darstellen, bevorzugt monoanionische bidentate Teilliganden. Da der Ligand zwei bidentate Teilliganden aufweist, ergibt sich insgesamt ein tetradentater Ligand, also ein Ligand, der über vier Koordinationsstellen an das Platin koordiniert bzw. bindet. Dabei sind L1 und L2 bevorzugt solche Strukturen, wie sie oben durch die Formeln (L-1), (L-2) und (L-3) bzw. die bevorzugten Strukturen angegeben sind.

Der mit diesem Liganden der Formel (Lig') gebildete Platinkomplex M kann somit schematisch durch die folgende Formel dargestellt werden:

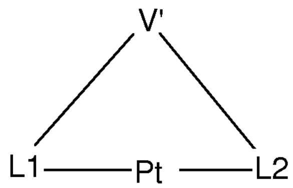

wobei die verwendeten Symbole die oben genannten Bedeutungen aufweisen.

Im Folgenden werden bevorzugte Substituenten beschrieben, wie sie an den oben beschriebenen Teilliganden und Liganden, aber auch an der bivalenten Arylen- oder Heteroarylengruppe in der Struktur der Formel (5) vorliegen können.

In einer bevorzugten Ausführungsform der Erfindung enthält der erfindungsgemäße Metallkomplex zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (3) bzw. (4) bzw. den bevorzugten Ausführungsformen vorliegen und/oder an einem oder mehreren der bidentaten Teilliganden vorliegen. Der aliphatische Ring, der durch die Ringbildung von zwei Substituenten R miteinander miteinander gebildet wird, wird bevorzugt durch eine der folgenden Formeln (51) bis (57) beschrieben,

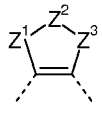

Formel (51)

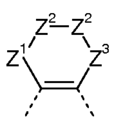

Formel (52)

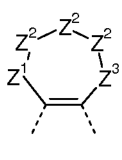

Formel (53)

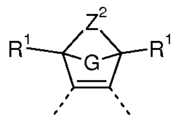
Formel (54)

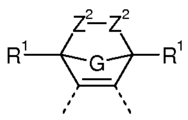
Formel (55)

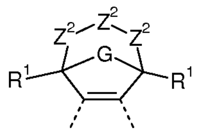
Formel (56)

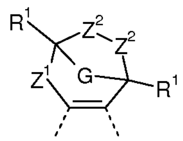
Formel (57)

wobei $R^1$ und $R^2$ die oben genannten Bedeutungen aufweisen, die gestrichelten Bindungen die Verknüpfung der beiden Kohlenstoffatome im Liganden andeuten und weiterhin gilt:

$Z^1$, $Z^3$ ist gleich oder verschieden bei jedem Auftreten $C(R^3)_2$, O, S, $NR^3$ oder C(=O);

$Z^2$ ist $C(R^1)_2$, O, S, $NR^3$ oder C(=O);

G ist eine Alkylengruppe mit 1, 2 oder 3 C-Atomen, welche mit einem oder mehreren Resten $R^2$ substituiert sein kann, $-CR^2=CR^2-$ oder eine ortho-verknüpfte Arylen- oder Heteroarylengruppe mit 5 bis 14 aromatischen Ringatomen, welche durch einen oder mehrere Reste $R^2$ substituiert sein kann;

$R^3$ ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten $R^2$ substituiert sein kann, wobei eine oder mehrere nicht benachbarte $CH_2$-Gruppen durch $R^2C=CR^2$, C≡C, $Si(R^2)_2$, C=O, $NR^2$, O, S oder $CONR^2$ ersetzt sein können, oder ein aromatisches oder heteroaromatisches Ringsystem mit 5 bis 24 aromatischen Ringatomen, das jeweils durch einen oder mehrere Reste $R^2$ substituiert sein kann, oder eine Aryloxy- oder Heteroaryloxygruppe mit 5 bis 24 aromatischen Ringatomen, die durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden;

mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist $R^3$ ungleich H.

In den oben abgebildeten Strukturen der Formeln (51) bis (57) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (50) bis (52) dadurch erreicht, dass $Z^1$ und $Z^3$, wenn diese für $C(R^3)_2$ stehen, so definiert sind, dass $R^3$ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (53) bis (57) dadurch erreicht, dass es sich dabei um eine bicyclische Struktur handelt, wodurch $R^1$, wenn es für H steht, deutlich weniger azide als benzylische Protonen, da das korrespondierende Anion der bicyclischen Struktur nicht mesomeriestabilisiert ist. Auch wenn $R^1$ in Formeln (53) bis (57) für H steht, handelt es sich dabei daher um ein nicht-azides Proton im Sinne der vorliegenden Anmeldung.

In einer bevorzugten Ausführungsform der Struktur gemäß Formel (51) bis (57) steht maximal eine der Gruppen $Z^1$, $Z^2$ und $Z^3$ für ein Heteroatom, insbesondere für O oder $NR^3$, und die anderen Gruppen stehen für $C(R^3)_2$ bzw. $C(R^1)_2$

oder $Z^1$ und $Z^3$ stehen gleich oder verschieden bei jedem Auftreten für O oder $NR^3$ und $Z^2$ steht für $C(R^1)_2$. In einer besonders bevorzugten Ausführungsform der Erfindung stehen $Z^1$ und $Z^3$ gleich oder verschieden bei jedem Auftreten für $C(R^3)_2$ und $Z^2$ steht für $C(R^1)_2$ und besonders bevorzugt für $C(R^3)_2$ oder $CH_2$.

Bevorzugte Ausführungsformen der Formel (51) sind somit die Strukturen der Formel (51-A), (51-B), (51-C) und (51-D), und eine besonders bevorzugte Ausführungsform der Formel (51-A) sind die Strukturen der Formel (51-E) und (51-F),

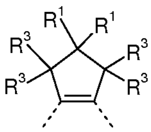
Formel (51-A)
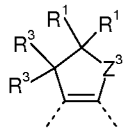
Formel (51-B)
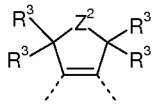
Formel (51-C)
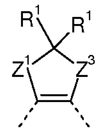
Formel (51-D)

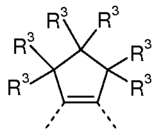
Formel (51-E)
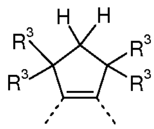
Formel (51-F)

wobei $R^1$ und $R^3$ die oben genannten Bedeutungen aufweisen und $Z^1$, $Z^2$ und $Z^3$ gleich oder verschieden bei jedem Auftreten für O oder $NR^3$ steht.

Bevorzugte Ausführungsformen der Formel (52) sind die Strukturen der folgenden Formeln (52-A) bis (52-F),

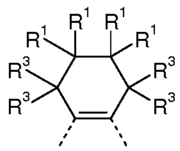
Formel (52-A)
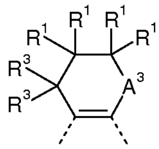
Formel (52-B)
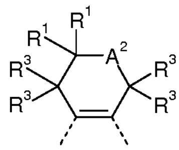
Formel (52-C)

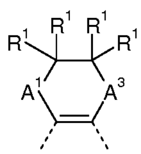
Formel (52-D)
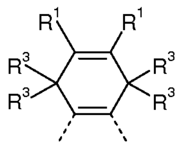
Formel (52-E)
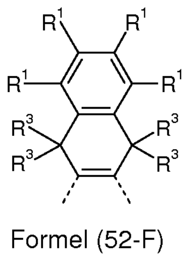
Formel (52-F)

wobei $R^1$ und $R^3$ die oben genannten Bedeutungen aufweisen und $Z^1$, $Z^2$ und $Z^3$ gleich oder verschieden bei jedem Auftreten für O oder $NR^3$ steht.

Bevorzugte Ausführungsformen der Formel (53) sind die Strukturen der folgenden Formeln (53-A) bis (53-E),

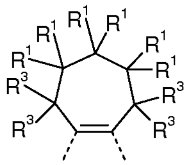
Formel (53-A)
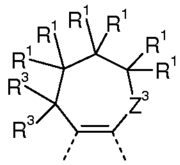
Formel (53-B)
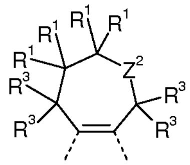
Formel (53-C)

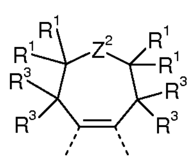
Formel (53-D)

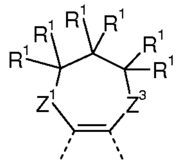
Formel (53-E)

wobei $R^1$ und $R^3$ die oben genannten Bedeutungen aufweisen und $Z^1$, $Z^2$ und $Z^3$ gleich oder verschieden bei jedem Auftreten für O oder $NR^3$ steht.

In einer bevorzugten Ausführungsform der Struktur gemäß Formel (54) stehen die Reste $R^1$, die an den Brückenkopf gebunden sind, für H, D, F oder $CH_3$. Weiterhin bevorzugt steht $Z^2$ für $C(R^1)_2$ oder O, und besonders bevorzugt für $C(R^3)_2$. Bevorzugte Ausführungsformen der Formel (54) sind somit eine Strukturen der Formel (54-A) und (54-B), und eine besonders bevorzugte Ausführungsform der Formel (54-A) ist eine Struktur der Formel (54-C),

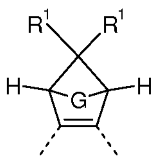
Formel (54-A)

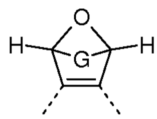
Formel (54-B)

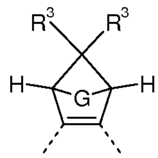
Formel (54-C)

wobei die verwendeten Symbole die oben genannten Bedeutungen aufweisen.

In einer bevorzugten Ausführungsform der Struktur gemäß Formel (55), (56) und (57) stehen die Reste $R^1$, die an den Brückenkopf gebunden sind, für H, D, F oder $CH_3$. Weiterhin bevorzugt steht $Z^2$ für $C(R^1)_2$. Bevorzugte Ausführungsformen der Formel (55), (56) und (57) sind somit die Strukturen der Formeln (55-A), (56-A) und (56-A),

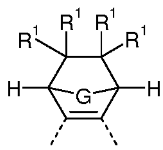
Formel (55-A)

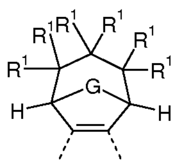
Formel (56-A)

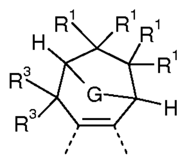
Formel (57-A)

wobei die verwendeten Symbole die oben genannten Bedeutungen aufweisen.

Weiterhin bevorzugt steht die Gruppe G in den Formeln (54), (54-A), (54-B), (54-C), (55), (55-A), (56), (56-A), (57) und (57-A) für eine 1,2-Ethylengruppe, welche mit einem oder mehreren Resten $R^2$ substituiert sein kann, wobei $R^2$ bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten $R^2$ substituiert sein kann, bevorzugt aber unsubstituiert ist, insbesondere eine ortho-Phenylengruppe, welche mit einem oder mehreren Resten $R^2$ substituiert sein kann, bevorzugt aber unsubstituiert ist.

In einer weiteren bevorzugten Ausführungsform der Erfindung steht $R^3$ in den Gruppen der Formel (51) bis (57) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte $CH_2$-Gruppen durch $R^2C{=}CR^2$ ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden.

In einer besonders bevorzugten Ausführungsform der Erfindung steht $R^3$ in den Gruppen der Formeln (51) bis (57) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste $R^2$ substituiert sein kann, bevorzugt aber unsubstituiert ist; dabei können zwei Reste $R^3$, welche an dasselbe Kohlenstoffatom gebunden sind, miteinander

ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden.

Beispiele für besonders geeignete Gruppen der Formel (51) sind die im Folgenden abgebildeten Gruppen:

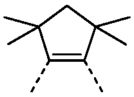
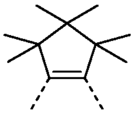
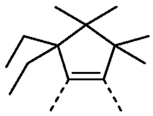
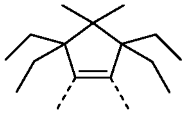
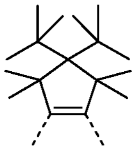
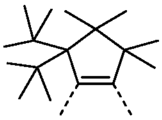
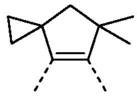
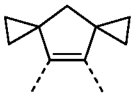
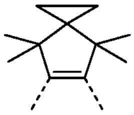
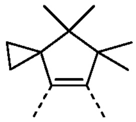
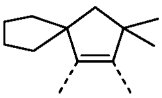
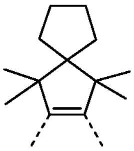
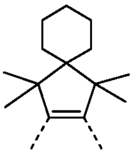
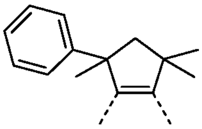
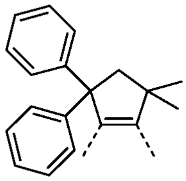
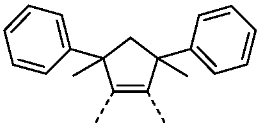
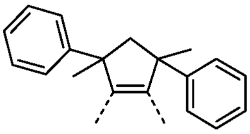
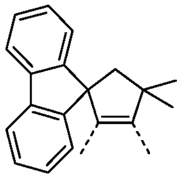
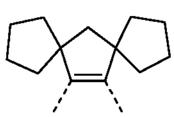
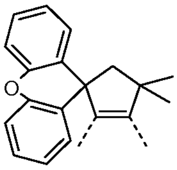
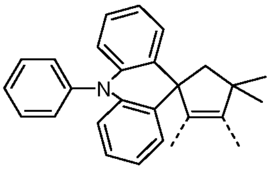
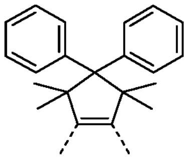
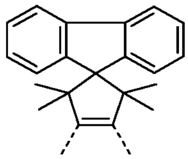
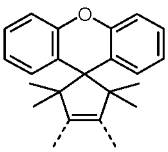
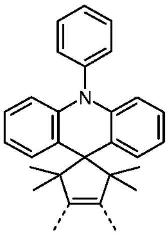
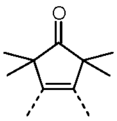
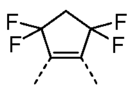
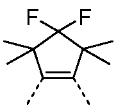
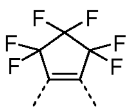
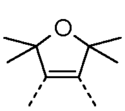
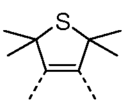
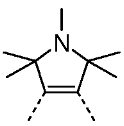
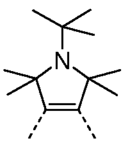
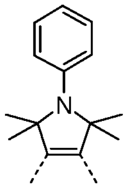
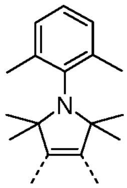

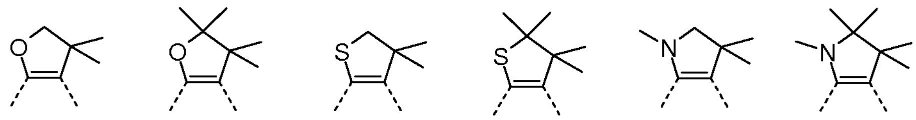

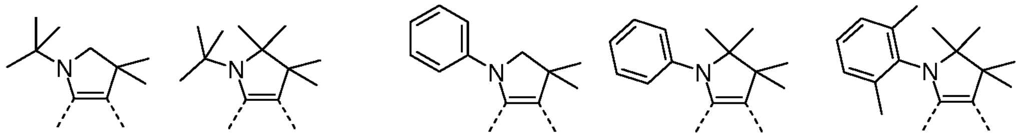

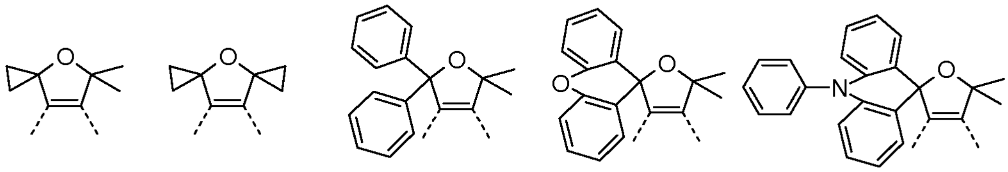

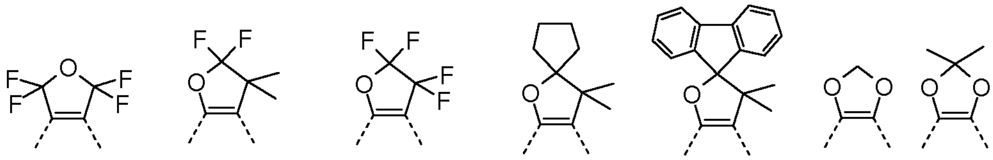

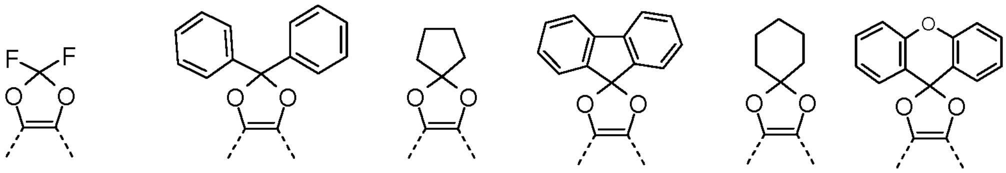

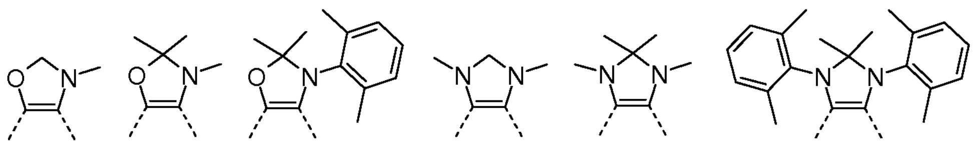

.

Beispiele für besonders geeignete Gruppen der Formel (52) sind die im Folgenden abgebildeten Gruppen:

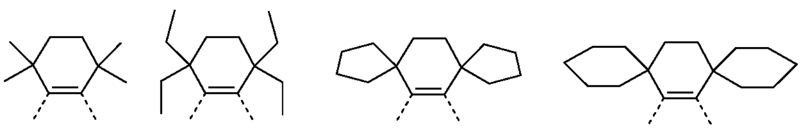

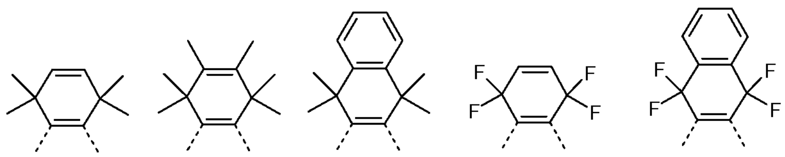

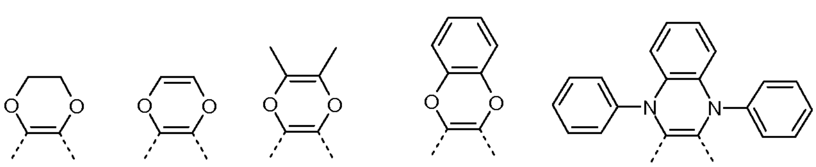

.

Beispiele für besonders geeignete Gruppen der Formel (53), (56) und (57) sind die im Folgenden abgebildeten Gruppen:

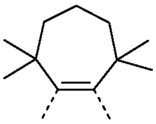 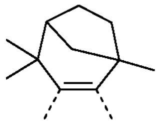 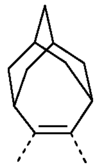 .

Beispiele für besonders geeignete Gruppen der Formel (54) sind die im Folgenden abgebildeten Gruppen:

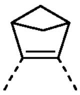 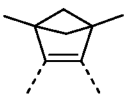 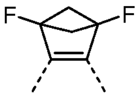 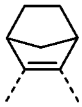 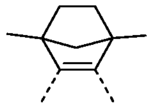 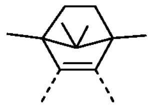

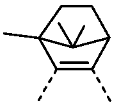 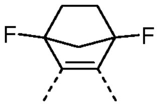 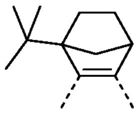 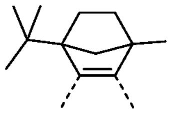 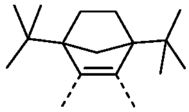

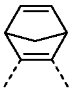 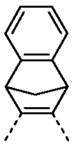 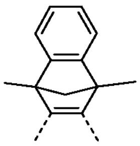 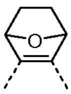 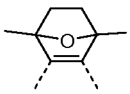 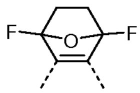

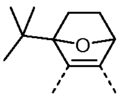 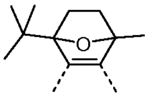 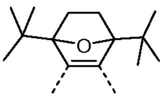 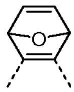 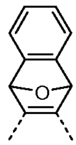 .

Beispiele für besonders geeignete Gruppen der Formel (55) sind die im Folgenden abgebildeten Gruppen:

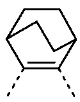 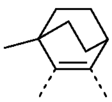 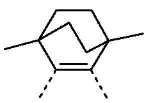 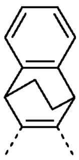 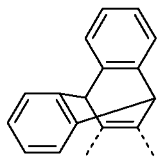 .

Wenn in den bidentaten Teilliganden bzw. Liganden bzw. in den bivalenten Arylen- bzw. Heteroarylengruppen der Formel (5), welche in den Formeln (3) bzw. (4) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, $N(R^1)_2$, CN, $Si(R^1)_3$, $B(OR^1)_2$, $C(=O)R^1$, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten $R^1$ substituiert sein kann, oder einem aromatischen oder heteroaromatischen Ringsystem mit 5 bis 30 aromatischen Ringatomen, das jeweils durch einen oder mehrere Reste $R^1$ substituiert sein kann; dabei können zwei benachbarte Rest R oder R mit $R^1$ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, $N(R^1)_2$, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24, bevorzugt 6 bis 24, besonders bevorzugt 6 bis 13 aromatischen Ringatomen, das jeweils durch einen oder mehrere Reste $R^1$ substituiert sein kann; dabei können zwei benachbarte

Reste R oder R mit $R^1$ auch miteinander ein mono- oder polycyclisches, aliphatisches oder aromatisches Ringsystem bilden.

Bevorzugte Reste $R^1$, die an R gebunden sind, sind bei jedem Auftreten gleich oder verschieden H, D, F, $N(R^2)_2$, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten $R^2$ substituiert sein kann, oder ein aromatisches oder heteroaromatisches Ringsystem mit 5 bis 24 aromatischen Ringatomen, das jeweils durch einen oder mehrere Reste $R^2$ substituiert sein kann; dabei können zwei oder mehrere benachbarte Reste $R^1$ miteinander ein mono- oder polycyclisches, aliphatisches Ringsystem bilden. Besonders bevorzugte Reste $R^1$, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten $R^2$ substituiert sein kann, oder ein aromatisches oder heteroaromatisches Ringsystem mit 5 bis 13, bevorzugt 6 bis 13 aromatischen Ringatomen, das jeweils durch einen oder mehrere Reste $R^2$ substituiert sein kann; dabei können zwei oder mehrere benachbarte Reste $R^1$ miteinander ein mono- oder polycyclisches, aliphatisches Ringsystem bilden.

Bevorzugte Reste $R^2$ sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten $R^2$ auch miteinander ein mono- oder polycyclisches, aliphatisches Ringsystem bilden.

Im Folgenden werden bevorzugte Ausführungsformen des erfindungsgemäßen Substituenten $-[[Ar]_p-B-[Ar]_q]_m-R^B$ ausgeführt, wobei es sich für q = 0 um einen Substituenten $-[[Ar]_p-B]_m-R^B$ handelt.

Wie oben beschrieben, handelt es sich bei Ar um eine linear verknüpfte Arylen- bzw. Heteroarylengruppe mit 6 bis 30 aromatischen Ringatomen, welche mit einem oder mehreren Resten R substituiert sein kann.

Unter einer linear verknüpften Arylen- bzw. Heteroarylengruppe im Sinne der vorliegenden Erfindung wird eine para-verknüpfte Sechsringarylen- bzw. Sechsringheteroarylengruppe verstanden. Dies gilt ebenfalls, wenn an diese Gruppe weitere Gruppen ankondensiert sind, wie z. B. im 1,4-verknüpften Naphthalin. Dies gilt weiterhin, wenn die Gruppe Ar formal mehrere Sechsringarylen- bzw. Sechsringheteroarylengruppen enthält, wie beispielsweise im 2,7-verknüpften Fluoren, im entsprechend verknüpften Indenofluoren bzw. im 2,7-verknüpften Carbazol.

In einer bevorzugten Ausführungsform der Erfindung ist Ar bei jedem Auftreten gleich oder verschieden ausgewählt aus den Gruppen der folgenden Formeln (Ar-1) bis (Ar-10),

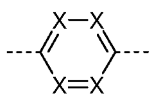

(Ar-1)

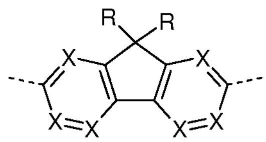

(Ar-2)

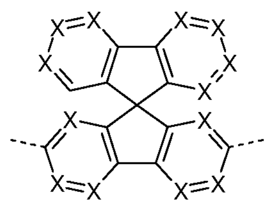

(Ar-3)

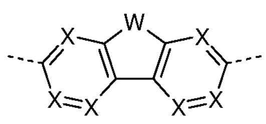

(Ar-4)

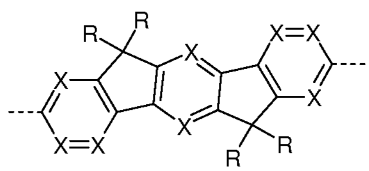

(Ar-5)

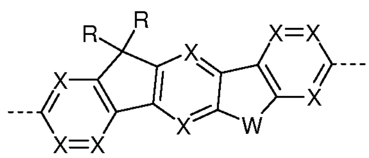

(Ar-6)

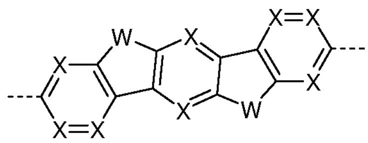

(Ar-7)

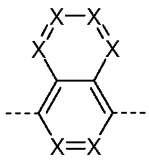
(Ar-8)

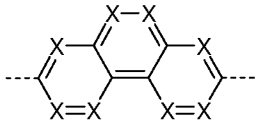
(Ar-9)

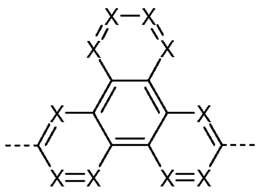
(Ar-10)

wobei die gestrichelten Bindungen die Verknüpfung dieser Gruppe andeuten und die verwendeten Symbole die oben genannten Bedeutungen aufweisen. Bevorzugt stehen maximal zwei Symbole X pro Gruppe Ar, besonders bevorzugt maximal ein Symbol X pro Gruppe Ar, für N, und die anderen Symbole X stehen für CR. Ganz besonders bevorzugt stehen alle Symbole X für CR, so dass die Gruppen Ar daher besonders bevorzugt ausgewählt sind aus den folgenden Formeln (Ar-1a) bis (Ar-10a),

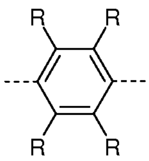
(Ar-1a)

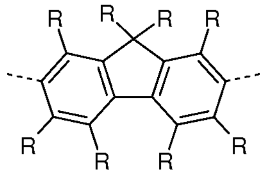
(Ar-2a)

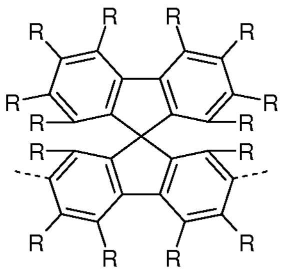
(Ar-3a)

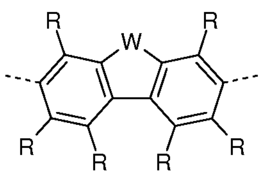
(Ar-4a)

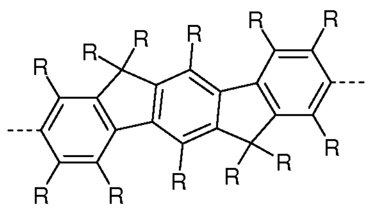
(Ar-5a)

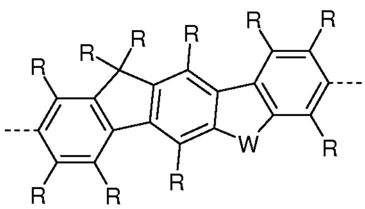
(Ar-6a)

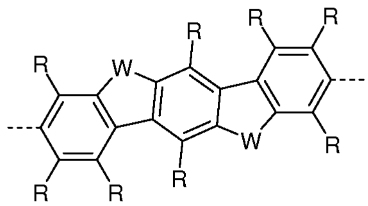
(Ar-7a)

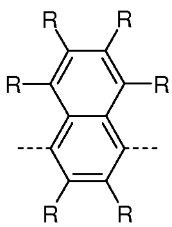
(Ar-8a)

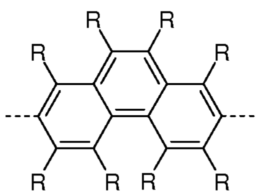
(Ar-9a)

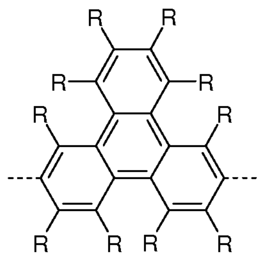
(Ar-10a)

wobei die verwendeten Symbole die oben genannten Bedeutungen aufweisen.

Wie oben beschrieben, handelt es sich bei der Gruppe B um eine bicyclische oder oligocyclische Gruppe gemäß Formel (2). In einer bevorzugten Ausführungsform der Erfindung sind $Y^1$, $Y^2$ und $Y^3$ gleich oder verschieden bei jedem Auftreten, bevorzugt gleich, ausgewählt aus $CR_2$, CR2-CR2, CR2-CR2-CR2, CR2-CR2-CR2-CR2 oder einer ortho-verknüpften Phenylengruppe, welche mit einem oder mehreren Resten R substituiert sein kann; dabei können die Gruppen $Y^1$, $Y^2$ und/oder $Y^3$ durch eine Einfachbindung oder über Reste R miteinander verknüpft sein, so dass oligocyclische Gruppen entstehen.

Besonders bevorzugt sind die Gruppen $Y^1$, $Y^2$ und $Y^3$ gleich und stehen für CH2, CH2-CH2, CH2-CH2-CH2, CH2-CH2-CH2-CH2 oder für eine unsubstituierte ortho-Phenylengruppe.

Beispiele für geeignete und besonders bevorzugte Gruppen der Formel (2) sind die im Folgenden abgebildeten Strukturen (B-1) bis (B-6):

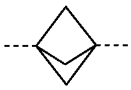
(B-1)

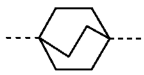
(B-2)

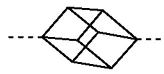
(B-3)

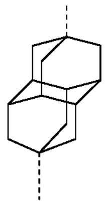
(B-4)

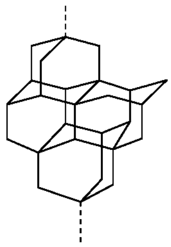
(B-5)

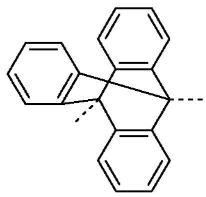
(B-6)

wobei die gestrichelte Bindung jeweils die Verknüpfung dieser Gruppe darstellt.

In einer bevorzugten Ausführungsform der Erfindung ist der Substituent $R^B$ ausgewählt aus H, M, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils mit einem oder mehreren Resten $R^1$ substituiert sein kann, bevorzugt aber unsubstituiert ist, oder einem aromatischen oder heteroaromatischen Ringsystem mit 6 bis 24 aromatischen Ringatomen, das jeweils durch einen oder mehrere Reste $R^1$ substituiert sein kann. Besonders bevorzugt ist der Substituent $R^B$ ausgewählt aus M, einer geradkettigen Alkylgruppe mit 1 bis 6 C-Atomen oder einer verzweigten oder cyclischen Alkylgruppe mit 3 bis 6 C-Atomen oder einem aromatischen Ringsystem mit 6 bis 12 aromatischen Ringatomen, das durch einen oder mehrere Reste $R^1$ substituiert sein kann, bevorzugt aber unsubstituiert ist. Wenn $R^B$ für M steht, dann gelten hierfür dieselben Bevorzugungen, wie oben bereits für die andere Gruppe M in der erfindungsgemäßen Verbindung beschrieben.

Bei den erfindungsgemäßen Verbindungen handelt es sich um chirale Strukturen. Je nach genauer Struktur der Komplexe und Liganden, ist die Bildung von Diastereomeren und mehreren Enantiomerenpaaren möglich. Die erfindungsgemäßen Komplexe umfassen sowohl die Mischungen der verschiedenen Diastereomere bzw. die entsprechenden Racemate wie auch die einzelnen isolierten Diastereomere bzw. Enantiomere.

Werden einkernige Komplex-Synthesebausteine zum Aufbau von mehrkernigen erfindungsgemäßen Komplexe verwendet, werden diese üblicherweise als Racemat der $\Delta$- und $\Lambda$-Isomeren eingesetzt. Dies führt in den mehrkernigen erfindungsgemäßen Verbindungen zu Diastereomerengemischen, z. B. für zweikernige Verbindungen zu $\Delta,\Delta$-/$\Lambda,\Lambda$- und (meso)-$\Delta,\Lambda$-Formen. Diese werden, sofern nicht anderes vermerkt, als Diastereomerengemisch weiter um- bzw. eingesetzt. Daneben besteht die Möglichkeit, diese durch chomatographische Methoden oder durch fraktionierte Kristallisation zu trennen.

Werden die enatiomenrenreinen $\Delta$- bzw. $\Lambda$-Isomeren einkerniger Komplex-Synthesebausteine zum Aufbau von mehrkernigen erfindungsgemäßen Komplexe verwendet, können z. B. für zweikernige Verbindungen $\Delta,\Delta$-bzw. $\Lambda,\Lambda$-bzw. (meso)$\Delta,\Lambda$-Formen gezielt dargestellt werden. Analoges gilt auch für drei- und höhekernige erfindungsgemäßen Komplexe.

Die dazu notwendigen $\Delta$- bzw. $\Lambda$-Isomeren einkerniger Komplex-Synthesebausteine können wie folgt erhalten werden. Werden in der Synthese der einkernigen Komplex-Synthesebausteine $C_3$- bzw. $C_{3v}$-symmetrische Liganden eingesetzt, fällt üblicherweise ein racemisches Gemisch der $C_3$-symmetrischen Komplexe, also des $\Delta$- und des $\Lambda$-Enantiomers, an. Diese können durch gängige Methoden (Chromatographie an chiralen Materialien / Säulen oder Racemattrennung durch Kristallisation) getrennt werden. Dies ist im folgenden Schema am Beispiel eines $C_3$-symmetrischen

Liganden, der drei Phenylpyridin-Teilliganden trägt, gezeigt und gilt in analoger Form auch für alle anderen $C_3$- bzw. $C_{3v}$-symmetrischen Liganden.

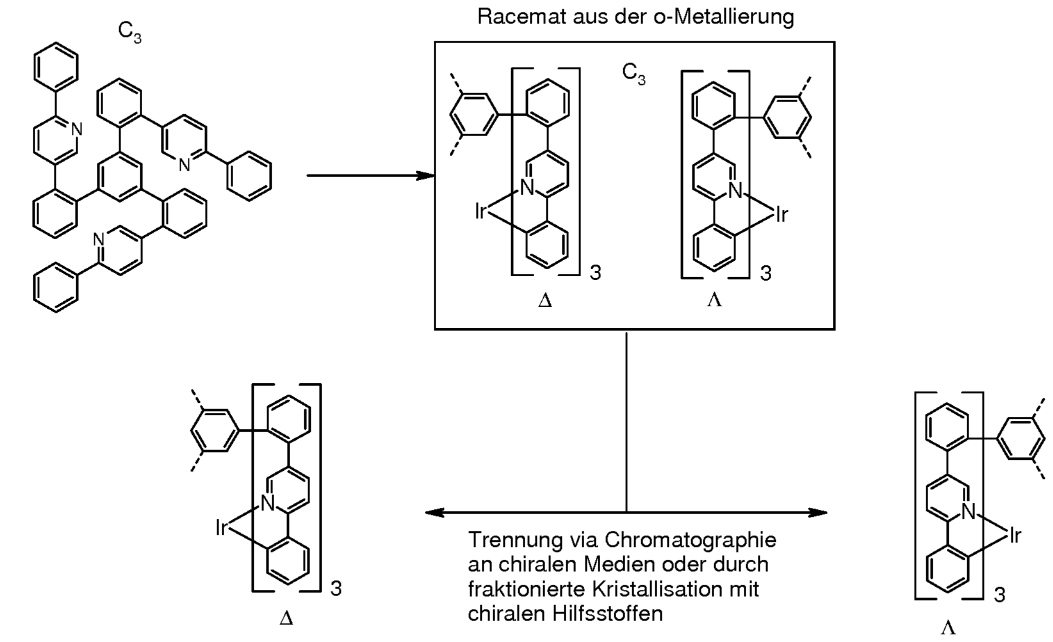


Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, $H_2O_2$ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

$$\Lambda,\Delta\text{-}\overset{+III}{Ir}L \xrightarrow{\text{Ox.}} [\Lambda,\Delta\text{-}\overset{+IV}{Ir}L]^{+}$$

frakt. Kristallisation / chirale Base

$$\rightarrow [\Lambda\text{-}\overset{+IV}{Ir}L]^{+}[\text{chirale Base}]^{-} \xrightarrow{\text{Red.}} \Lambda\text{-}Ir^{+III}L$$

$$\rightarrow [\Delta\text{-}\overset{+IV}{Ir}L]^{+}[\text{chirale Base}]^{-} \xrightarrow{\text{Red.}} \Delta\text{-}Ir^{+III}L$$

Daneben ist eine enantiomerenreine bzw. enantiomerenanreichernde Synthese durch Komplexierung in einem chiralen Medium (z. B. R- oder S-1,1-Binaphthol) möglich.

Analoge Verfahren können auch mit Komplexen $C_s$-symmetrischer Liganden durchgeführt werden.

Werden in der Komplexierung $C_1$-symmetrische Liganden eingesetzt, fällt üblicherweise ein Diastereomerengemisch der Komplexe an, das durch gängige Methoden (Chromatographie, Kristallisation) getrennt werden kann.

Enantiomerenreine $C_3$-symmetrische Komplexe können auch gezielt synthetisiert werden, wie im folgenden Schema dargestellt. Dazu wird ein enantiomerenreiner, Cs-symmetrischer Ligand dargestellt, komplexiert, das erhaltene Diasteroemerengemisch wird getrennt und anschließend wird die chirale Gruppe abgespalten.

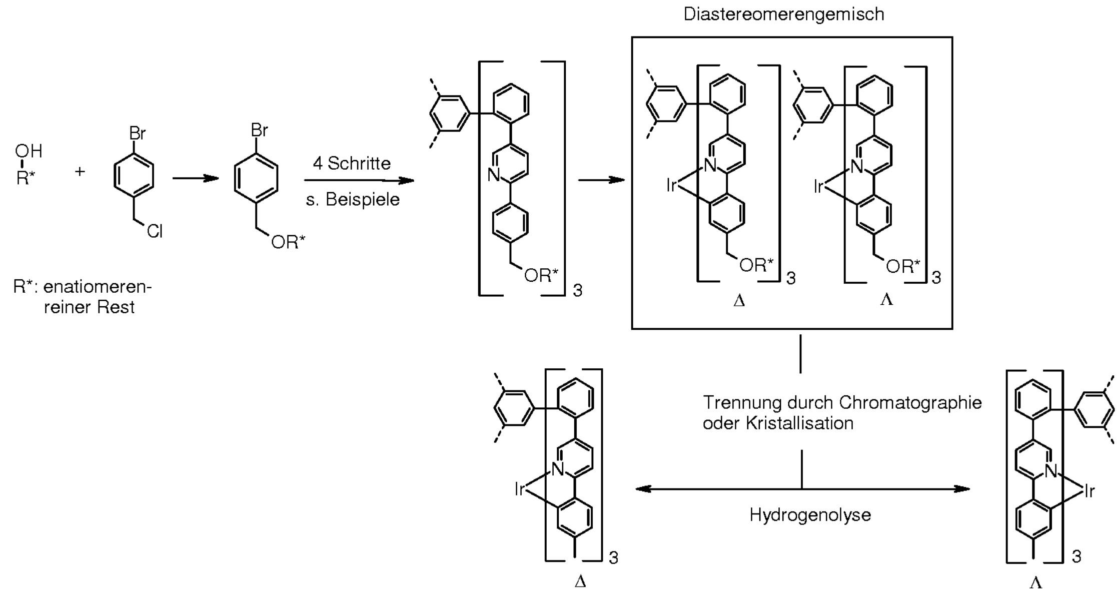


Die so erhaltenen Δ- bzw. einkerniger Komplex-Synthesebausteine können abschließend funktionalisiert, z. B. halogeniert bzw. boryliert, werden und dann via Kupplungsreaktionen, z. B. Suzuki-Kupplung, zu mehrkernigen erfindungsgemäßen Komplexen verknüpft werden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Komplexe können auf zwei Wegen dargestellt werden. Zum einen kann der Ligand (2-, 4-, 6,- 8, 10- oder 12-zähnig) enthaltend die bi- bzw. polycyclischen Einheiten B dargestellt und dann an das / die Metalle bzw. Metallfragmente koordiniert werden. Generell wird hierzu ein Iridium- bzw. Platinsalz mit dem entsprechenden freien Liganden umgesetzt.

Daher ist ein weiterer Gegenstand der vorliegenden Erfindung ein Verfahren zur Herstellung der erfindungsgemäßen Iridiumkomplexe durch Umsetzung der entsprechenden freien Liganden mit Metallalkoholaten der Formel (58), mit Metallketoketonaten der Formel (59), mit Metallhalogeniden der Formel (60) oder mit Metallcarboxylaten der Formel (61),

$Ir(OR)_3$

Formel (58)

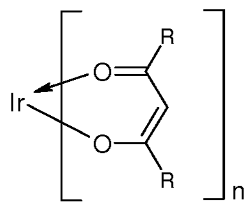

Formel (59)

$IrHal_3$

Formel (60)

$Ir(OOCR)_3$

Formel (61)

wobei R die oben angegebenen Bedeutungen hat, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind $[IrCl_2(acac)_2]^-$, beispielsweise $Na[IrCl_2(acac)_2]$, Metallkomplexe mit Acetylacetonat-Derivaten als Ligand, beispielsweise $Ir(acac)_3$ oder Tris(2,2,6,6-Tetramethylheptan-3,5-dionato)iridium, und $IrCl_3 \cdot xH_2O$, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden

zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Alterntiv kann ein bzw. können mehrere mit Halogen bzw. Boronsäure- oder Boronsäureester-Gruppen funktionalisierte Metallkomplexe mit der/den entsprechend funktionalisierten Einheiten $[[Ar]_p\text{-}B]\text{-}R^B$ oder aber mit einem Gemisch aus funktionalisierten Ar- und B-Bausteinen in Kupplungsreaktionen, bevorzugt einer Suzuki-Kupplung, zur erfindungsgemäßen Verbindung umgesetzt werden. Nähere Erläuterungen hierzu können den Beispielen entnommen werden.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels $^1$H-NMR und/oder HPLC) erhalten.

Die erfindungsgemäßen Metallkomplexe können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (51) bis (57) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Verbindungen können auch mit einem Polymer gemischt oder kovalent in ein Polymer eingebaut werden. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. In einer bevorzugten Ausführungsform der vorliegenden Erfindung werden die erfindungsgemäßen Verbindungen, wenn sie in Oligomeren, Dendrimeren oder Polymeren eingesetzt werden, darin als Endgruppe eingesetzt.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft oder stellt eine Endgruppe dar. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren oder in der Photokatalyse verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder in der Photokatalyse. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden. Insbesondere wenn das Metall Ruthenium ist, ist der Einsatz als Photosensibilisator in einer farbstoffsensibilisierten Solarzelle ("Grätzel-Zelle") bevorzugt.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie $MoO_3$ oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Für weiß emittierende OLEDs eignen sich insbesondere auch Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise

zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011 /000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011 /042107 oder WO 2011 /088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist.

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_x$, Al/$PtO_x$) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die

Anode ein p-dotiertes Lochtransportmaterial als Lochinjektionsschicht aufgebracht wird, wobei sich als p-Dotanden Metalloxide, beispielsweise $MoO_3$ oder $WO_3$, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner $10^{-5}$ mbar, bevorzugt kleiner $10^{-6}$ mbar aufgedampft. Es ist auch möglich, dass der Anfangsdruck noch geringer oder noch höher ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:

1. Die erfindungsgemäßen Metallkomplexe zeigen orientierte Emission. Dies ermöglicht höhere Quanteneffizienzen durch verbesserte Lichtauskopplung aus dem Bauteil und somit eine höhere Effizienz der OLED. Dadurch lässt sich auch die Lebensdauer steigern, da die OLED mit geringerem Strom betrieben werden kann.

2. Die erfindungsgemäßen Metallkomplexe lassen sich in sehr hoher Ausbeute und sehr hoher Reinheit bei außergewöhnlich kurzen Reaktionszeiten und vergleichsweise geringen Reaktionstemperaturen synthetisieren.

3. Die erfindungsgemäßen Metallkomplexe weisen eine hervorragende thermische Stabilität auf.

4. Die erfindungsgemäßen Metallkomplexe zeigen weder thermisch noch photochemisch fac/mer- bzw. mer/fac-Isomerisierung, was zu Vorteilen in der Anwendung dieser Komplexe führt. Dies gilt insbesondere für die polypodalen Komplexe.

5. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.

6. Organische Elektrolumineszenzvorrichtungen enthaltend die erfindungsgemäßen Metallkomplexe als emittierende Materialien weisen eine sehr gute Lebensdauer auf.

7. Organische Elektrolumineszenzvorrichtungen enthaltend die erfindungsgemäßen Metallkomplexe als emittierende Materialien weisen eine hervorragende Effizienz auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

**Beispiele:**

**Allgemeines Verfahren zur Bestimmung von Orbitalenergien und elektronischer Zustände**

Die HOMO- und LUMO-Energien sowie das Triplettniveau und die Singulettniveaus der Materialien werden über quantenchemische Rechnungen bestimmt. Hierzu wird vorliegend das Programmpaket "Gaussian09, Revision D.01" (Gaussian Inc.) verwendet. Zur Berechnung organischer Substanzen ohne Metalle (mit Methode "org." bezeichnet) wird zuerst eine Geometrieoptimierung mit der semi-empirischen Methode AM1 (Gaussian-Eingabezeile "# AM1 opt") mit der Ladung (Charge) 0 und der Multiplizität (Multiplicity) 1 durchgeführt. Im Anschluss erfolgt auf Grundlage der optimierten Geometrie eine Energierechnung (single point) für den elektronischen Grundzustand und das Triplett-Niveau. Hierbei wird die TDDFT-Methode (time dependent density functional theory) B3PW91 mit dem Basissatz 6-31 G(d) (Gaussian-Eingabezeile "# B3PW91/6-31 G(d) td=(50-50,nstates=4)") verwendet (Ladung 0, Multiplizität 1). Für metallorganische Verbindungen (mit Methode "M-org." bezeichnet) wird die Geometrie mit der Methode Hartree-Fock und dem Basissatz LanL2MB (Gaussian-Eingabezeile "# HF/LanL2MB opt") optimiert (Ladung 0, Multiplizität 1). Die Energierechnung erfolgt, wie oben beschrieben, analog zu der der organischen Substanzen, mit dem Unterschied, dass für das Metallatom der Basissatz "LanL2DZ" und für die Liganden der Basissatz "6-31 G(d)" verwendet wird (Gaussian-Eingabezeile "#B3PW91/gen pseudo=lanl2 td=(50-50,nstates=4)"). Aus der Energierechnung erhält man das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Daraus wird der anhand von Cyclovoltammetriemessungen kalibrierte HOMO- und LUMO-Wert in Elektronenvolt wie folgt bestimmt:

$$\mathrm{HOMO(eV)} = (\mathrm{HEh}*27.212)*0.8308-1.118$$

$$\mathrm{LUMO(eV)} = (\mathrm{LEh}*27.212)*1.0658 -0.5049$$

Diese Werte sind als HOMO bzw. als LUMO der Materialien anzusehen.

Das Triplett-Niveau T1 eines Materials ist definiert als die relative Anregungsenergie (in eV) des Triplettzustands mit der niedrigsten Energie, der sich aus der quantenchemischen Energierechnung ergibt.

Das Singulett-Niveau S1 eines Materials ist definiert als die relative Anregungsenergie (in eV) des Singulettzustands mit der zweitniedrigsten Energie, der sich aus der quantenchemischen Energierechnung ergibt.

Der energetisch niedrigste Singulettzustand wird als S0 bezeichnet.

Die hierin beschriebene Methode ist unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend wird zur Berechnung der Energien das Programmpaket "Gaussian09, Revision D.01" verwendet. Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

**A: Organische Synthone:**

**1. Literaturbekannte Synthone LS**

Folgende Sythone sind literaturbekannt und werden in der Darstellung der erfindunsemäßen Verbindungen verwendet:

| | | |
|---|---|---|
| 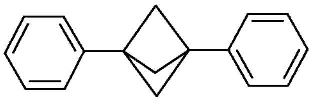 245508-15-0 LS1 | 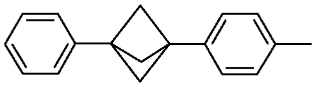 271767-93-2 LS2 | 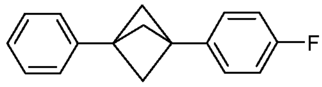 271767-92-1 LS3 |
| 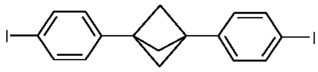 936502-32-8 LS4 | 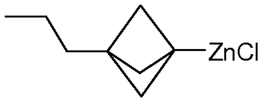 1364397-29-4 LS5 | 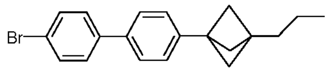 271768-10-6 LS6 |
| 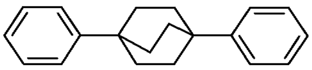 23062-63-7 LS7 | 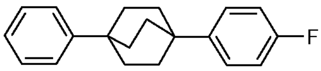 68756-32-1 LS8 | 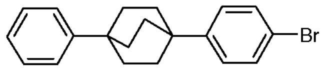 1253571-34-4 LS9 |
| 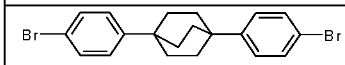 33732-71-7 LS10 | 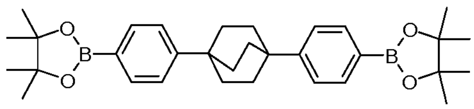 178742-53-5 LS11 | |
| 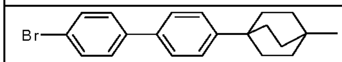 76921-39-6 LS12 | 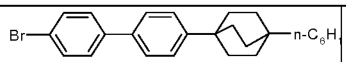 76937-43-4 LS13 | 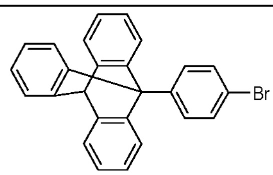 |

| | | |
|---|---|---|
| | | 162259-31-6<br>LS14 |
| 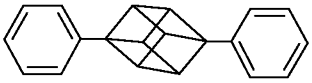<br>133180-91-3<br>LS15 | 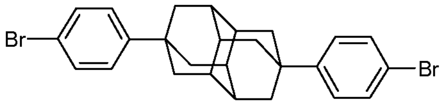<br>167013-15-2<br>LS16 | |
| 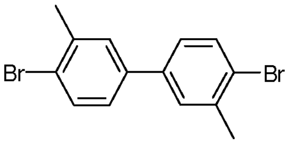<br>61794-96-5<br>LS100 | 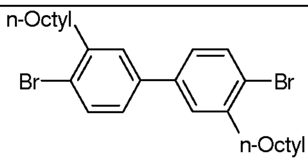<br>450398-41-1<br>LS101 | 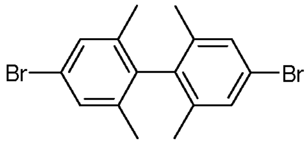<br>22409-76-3<br>LS102 |
| 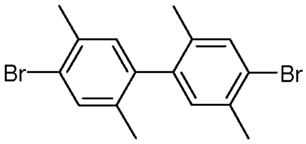<br>492434-55-6<br>LS103 | 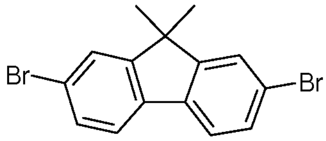<br>28320-32-3<br>LS104 | 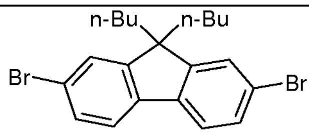<br>188200-91-1<br>LS105 |
| 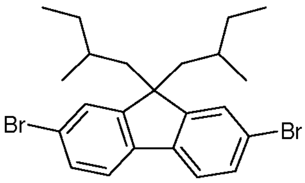<br>500343-25-9<br>LS106 | 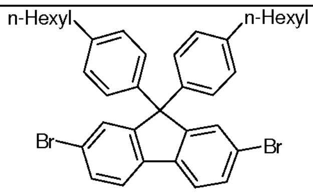<br>1059179-65-5<br>LS107 | 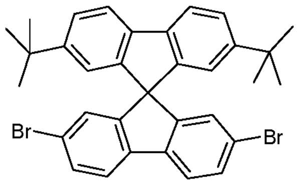<br>439791-57-8<br>LS108 |
| 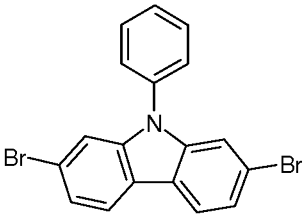<br>444796-09-2<br>LS109 | 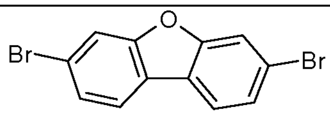<br>67019-91-4<br>LS110 | 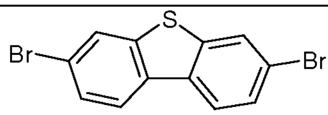<br>83834-10-0<br>LS111 |
| 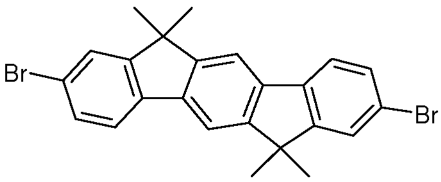<br>822705-64-1<br>LS112 | 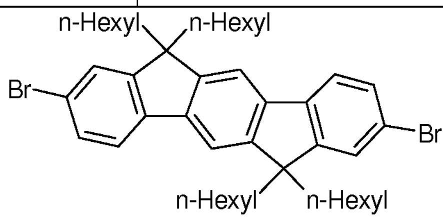<br>822705-69-6<br>LS113 | |

| | | |
|---|---|---|
| 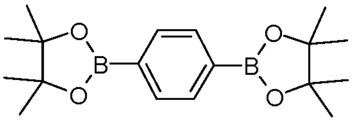<br>99770-93-1<br>LS200 | 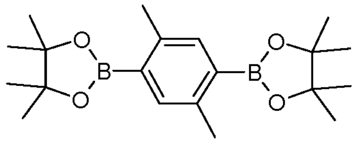<br>303006-89-5<br>LS201 | |
| 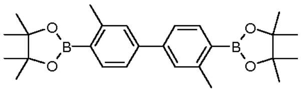<br>1422986-81-9<br>LS202 | 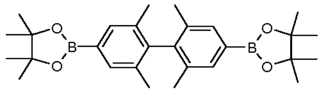<br>1449715-08-5<br>LS203 | 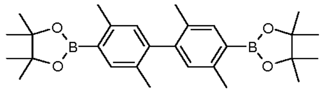<br>1399191-76-4<br>LS204 |
| 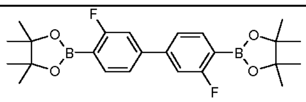<br>1515948-43-2<br>LS205 | 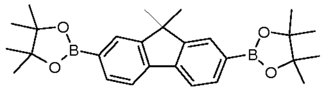<br>325129-69-9<br>LS206 | 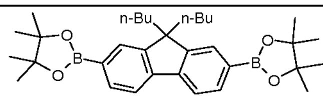<br>355135-06-7<br>LS207 |
| 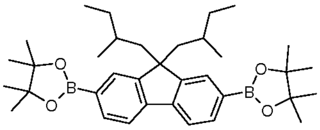<br>491880-74-1<br>LS208 | 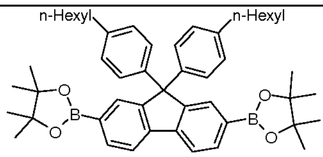<br>1206875-64-0<br>LS209 | 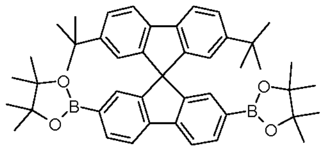<br>774611-20-0<br>LS210 |
| 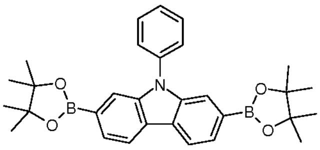<br>1035631-57-2<br>LS211 | 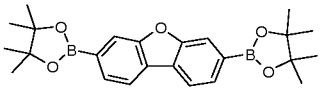<br>1821662-15-0<br>LS212 | 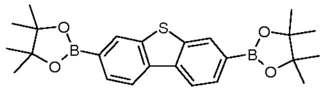<br>1378383-16-4<br>LS213 |
| 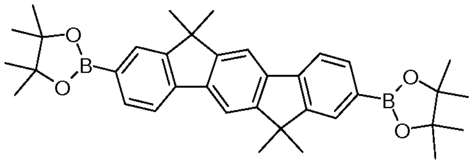<br>1563177-81-2<br>LS214 | 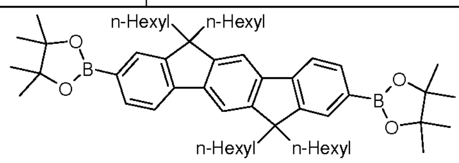<br>1210388-13-8<br>LS215 | |

| | | |
|---|---|---|
| 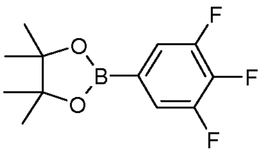 827614-70-0 LS216 | 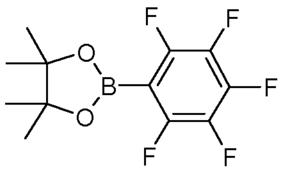 325142-81-2 LS217 | 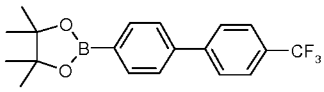 1381958-89-9 LS218 |
| 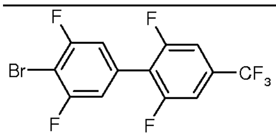 1469898-34-7 LS219 | 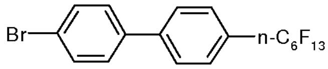 87415-27-8 LS220 | |

**2. Synthese von Iodiden durch Iodierung**

**Beispiel S1:**

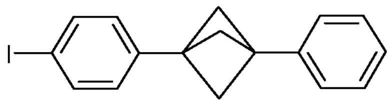

Eine Lösung von 22.0 g (100 mmol) LS1 in 1000 ml Chloroform wird unter Lichtausschluss mit 43.0 g (100 mmol) Bis(trifluoracetoxy)-iodbenzol [2712-78-9] und dann mit 12.7 g (50 mmol) Iod [7553-56-2] versetzt und 2 h bei Raumtemperatur gerührt. Die Reaktionsmischung wird unter Rühren auf 500 ml gesättigte Natriumthiosulfatlösung gegossen und 10 min. nachgerührt. Die organische Phase wird abgetrennt und über Magnesiumsulfat getrocknet. Man filtriert vom Trockenmittel ab und engt das Filtrat zur Trockene ein. Der Rückstand wird Flash-chromatographisch (CombiFlash Torrent der Fa. Axel Semrau) gereinigt. Ausbeute: 7.6 g (22 mmol), 22 %; Reinheit: 95 % n. $^1$H-NMR.

Analog können folende Verbindungen dargestellt werden:

| Bsp. | Edukt Produkt | Ausbeute |
|---|---|---|
| S2 | LS2 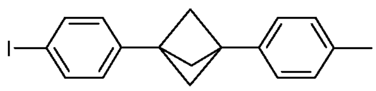 | 68 % |
| S3 | LS3 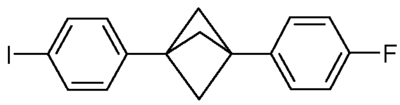 | 72 % |
| S4 | LS8 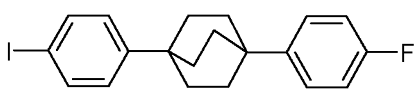 | 76 % |

(fortgesetzt)

| Bsp. | Edukt Produkt | Ausbeute |
|---|---|---|
| S5 | LS15 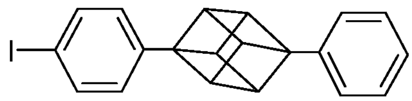 | 54 % |
| S6 | LS15, 50 mmol 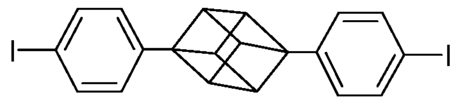 | 77 % |

**3. Synthese von Boronestern durch Borylierung**

**Allgemeine Vorschrift:**

Ein Gemisch aus 100 mmol der Monobromide/-iodide bzw. 50 mmol der Dibromide/-iodide, 105 mmol Bis(pinacolato)diboran [73183-34-3], 200 mmol Kaliumacetat [127-08-2], wasserfrei und 300 ml Dioxan wird unter Rühren mit 2 mmol Tricyclohexylphosphin [2622-14-2] und mit 1 mmol Palladium(II)acetat [3375-31-3] versetzt und dann 16 h bei 100 °C gerührt. Nach Erkalten entfernt man das Dioxan weitgehend im Vakuum, nimmt den Rückstand in 500 ml Toluol auf, wäscht dreimal mit 300 ml Wasser und einmal mit 300 ml gesättigter NaCl-Lösung und trocknet die organische Phase über Magnesiumsulfat. Nach Abfiltrieren des Trockenmittels über ein mit Toluol vorgeschlämmtes Celitebett und Entfernen des Toluols im Vakuum wird der Rückstand aus Ethylacetat/Methanol zweimal umkristallisiert. So erhaltene Diboronester, die als Monomere zur Darstellung von Oligomeren oder Polymeren verwendet werden, werden durch wiederholte Umkristallisation und abschließende Sublimation auf eine Reinheit > 99.9 % n. HPLC gebracht.

**Beispiel S20:**

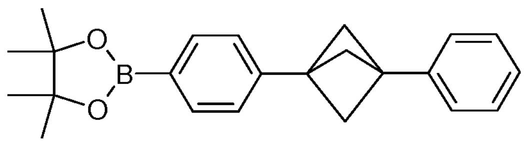

Einsatz von 34.6 g (100 mmol) S1, 26.6 g (105 mol) Bis(pinacolato)-diboran, 19.6 g (200 mmol) Kaliumacetat, 561 mg (2 mmol) Tricyclohexylphosphin und 225 mg (1 mmol) Palladium(II)acetat. Ausbeute: 15.2 g (44 mmol), 44 %; Reinheit: > 99 % n. $^{1}$H-NMR.

Analog können folgende Verbindungen dargestellt werden:

| Bsp. | Edukt Produkt | Ausbeute |
|---|---|---|
| S21 | S2 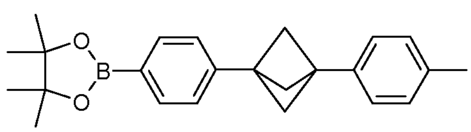 | 46 % |
| S22 | S3 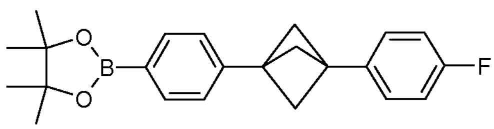 | 41 % |

(fortgesetzt)

| Bsp. | Edukt Produkt | Ausbeute |
|---|---|---|
| S23 | LS6<br>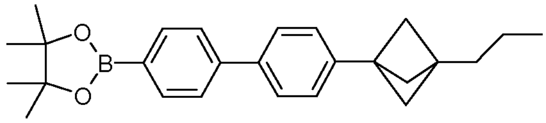 | 45 % |
| S24 | LS4<br>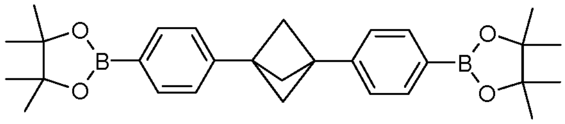 | 33 % |
| S25 | LS9<br>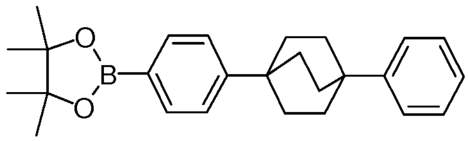 | 89 % |
| S26 | LS12<br>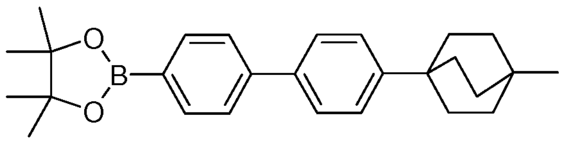 | 90 % |
| S27 | LS13<br>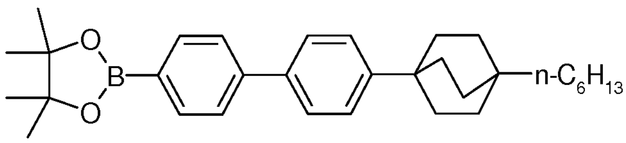 | 81 % |
| S28 | LS14<br>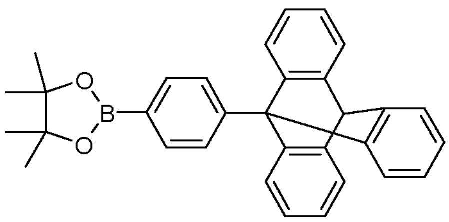 | 94 % |
| S29 | S4<br>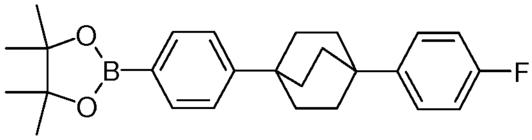 | 85 % |
| S30 | S5<br>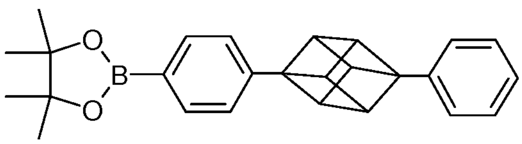 | 76 % |

(fortgesetzt)

| Bsp. | Edukt Produkt | Ausbeute |
|---|---|---|
| S31 | S6 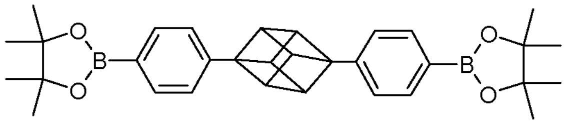 | 80 % |
| S32 | LS16 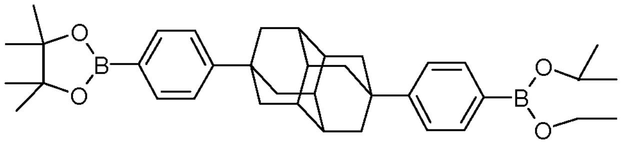 | 84 % |
| S33 | S100 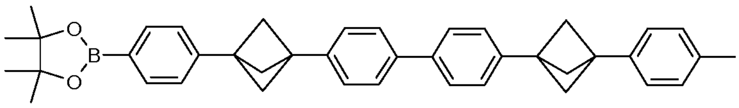 | 33 % |
| S34 | S101 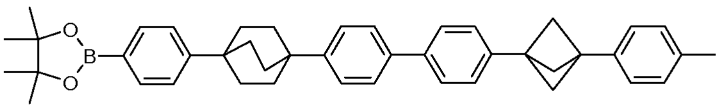 | 40 % |
| S35 | S102 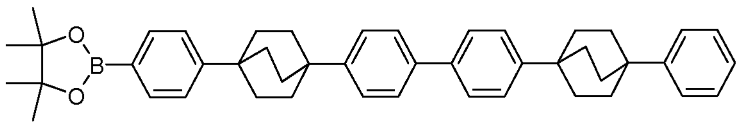 | 93 % |
| S36 | S103 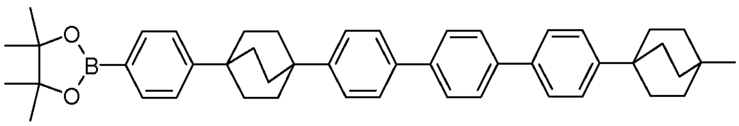 | 91 % |
| S37 | S104 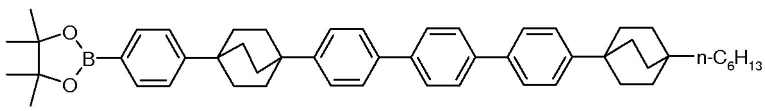 | 85 % |
| S38 | S105 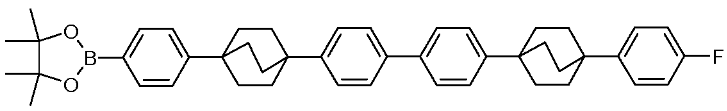 | 85 % |
| S39 | S106 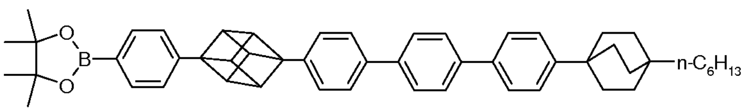 | 76 % |

(fortgesetzt)

| Bsp. | Edukt Produkt | Ausbeute |
|---|---|---|
| S40 | S107 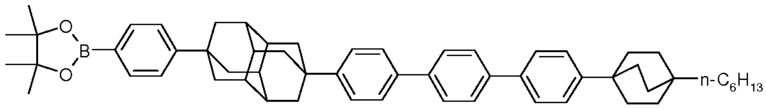 | 94 % |
| S41 | S108 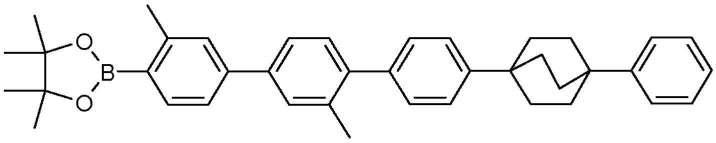 | 89 % |
| S42 | S109 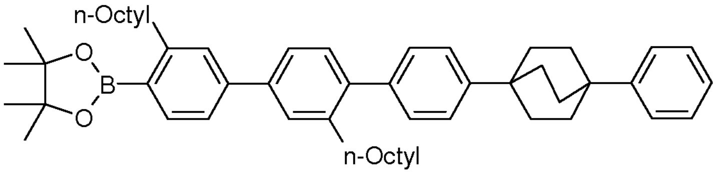 | 90 % |
| S43 | S110 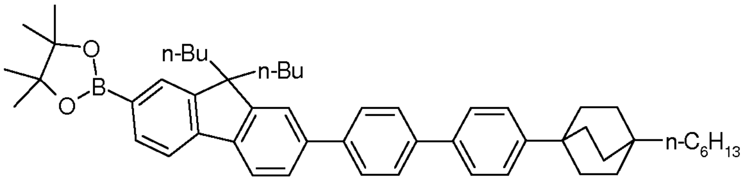 | 93 % |
| S44 | S111 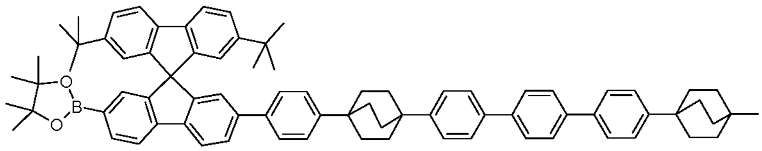 | 90 % |
| S45 | S112 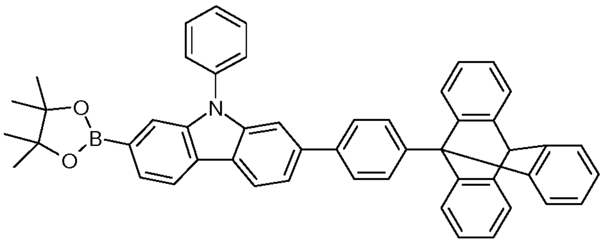 | 95 % |
| S46 | S113 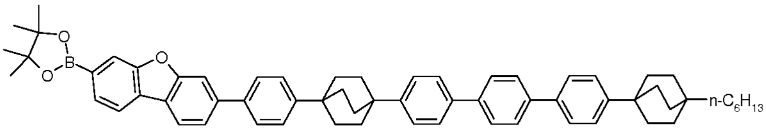 | 86 % |

(fortgesetzt)

| Bsp. | Edukt Produkt | Ausbeute |
|---|---|---|
| S90 | LS219<br>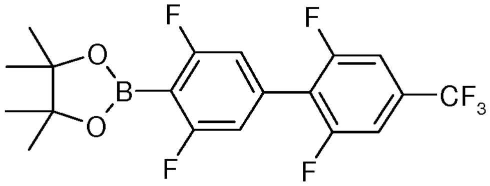 | 45 % |
| S91 | LS220<br>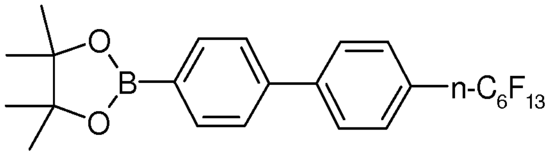 | 78 % |
| S92 | S114<br>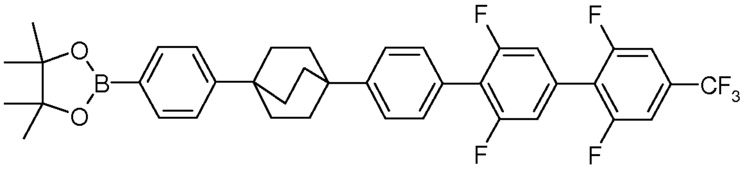 | 85 % |
| S93 | S115<br>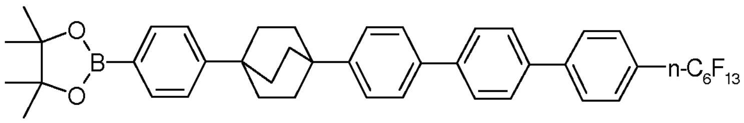 | 87 % |

**4. Synthese von Bromiden / Iodiden durch Suzuki-Kupplung**

**Beispiel S100:**

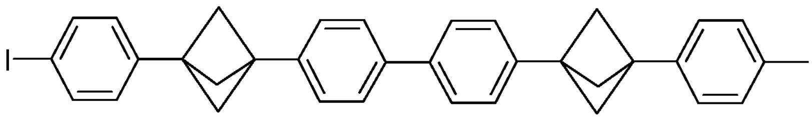

Ein Gemisch aus 39.6 g (100 mmol) LS4, 36.0 g (100 mmol) S21, 63.7 g (300 mmol) Trikaliumphosphat [7778-53-2], 500 ml Toluol, 200 ml Dioxan und 500 ml Wasser wird mit 1.83 g (6 mmol) Tri-o-tolylphosphin [6163-58-2] und mit 225 mg (1 mmol) Palladium(II)acetat [3975-31-3] versetzt und 18 h bei 100 °C gut gerührt. Nach Erkalten saugt ma n vom ausgefallenen Feststoff (ein Teil des Doppelkupplungsprodukts) ab. Man trennt die organische Phase der Mutterlauge ab, wäscht diese zweimal mit je 300 ml Wasser und einmal mit 300 ml gesättigter Kochsalzlösung und trocknet über Magnesiumsulfat. Der nach Absaugen des Trockenmittels über ein mit Toluol vorgeschlämmtes Celite-Bett und Entfernen des Toluols erhaltene Rückstand wird Flash-chromatographisch (CombiFlash Torrent der Fa. Axel Semrau) gereinigt. Ausbeute: 27.8 g (48 mmol), 48 %; Reinkeit: 97 % n. HPLC.

Analog können folgende Verbindungen dargestellt werden:

| Bsp. | Edukte Produkt | Ausbeute |
|---|---|---|
| S101 | LS10 + S21 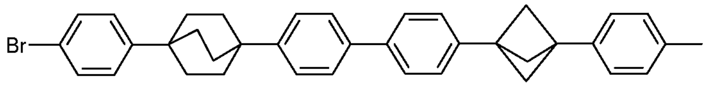 | 34% |
| S102 | LS10 + S25 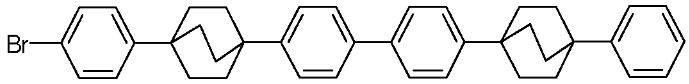 | 49 % |
| S103 | LS10 + S26 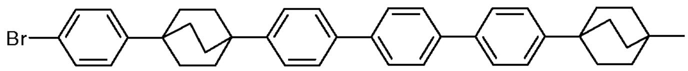 | 53 % |
| S104 | LS10 + S27 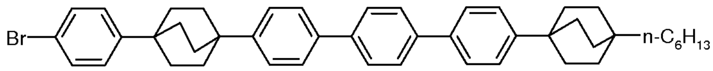 | 48 % |
| S105 | LS10 + S29 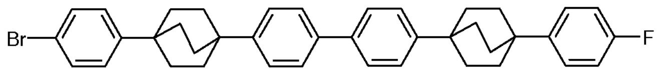 | 50 % |
| S106 | S6 + S27 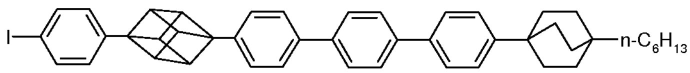 | 51 % |
| S107 | LS16 + S27 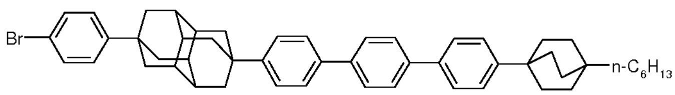 | 49 % |
| S108 | LS100 + S25 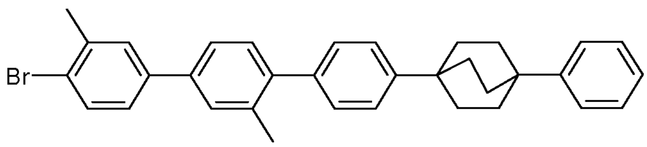 | 56 % |
| S109 | LS101 + S25 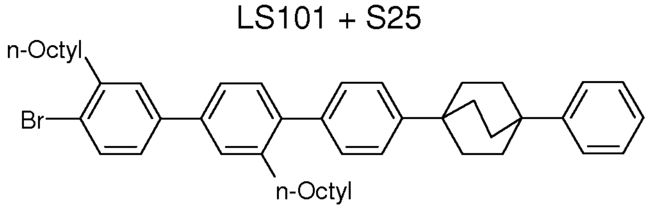 | 51 % |
| S110 | LS105 + S27 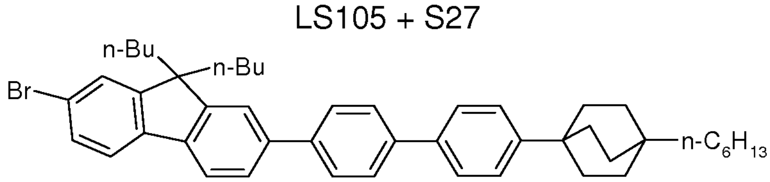 | 49 % |

(fortgesetzt)

| Bsp. | Edukte Produkt | Ausbeute |
|---|---|---|
| S111 | LS108 + S36 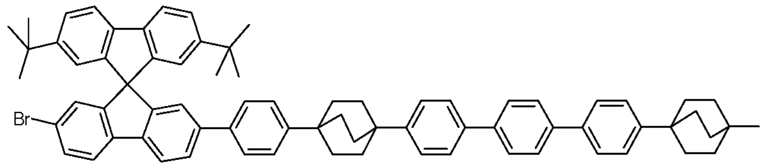 | 37% |
| S112 | LS109 + S28 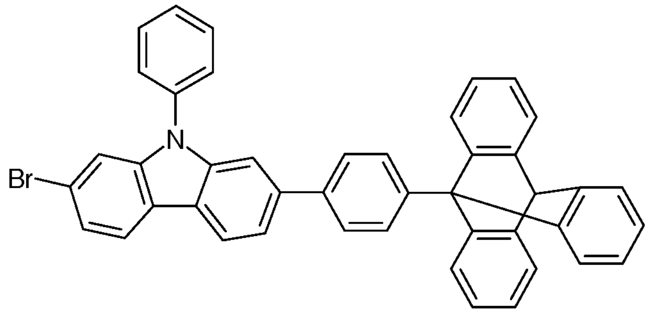 | 55 % |
| S113 | LS110 + S37 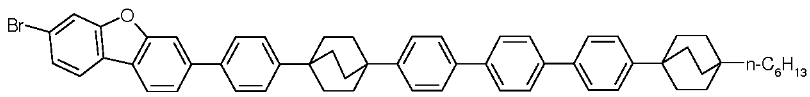 | 43 % |
| S114 | LS10 + S90 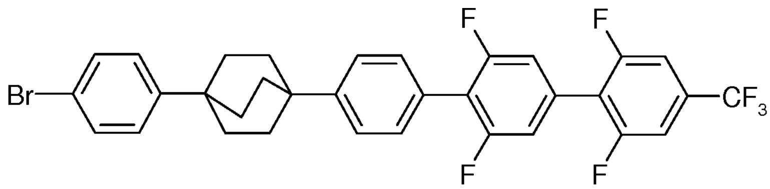 | 21 % |
| S115 | LS10 + S91 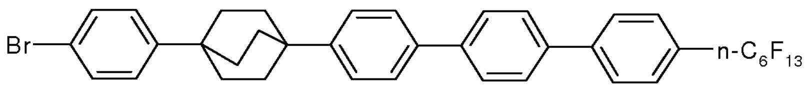 | 40 % |
| S116 | LS101 + S92 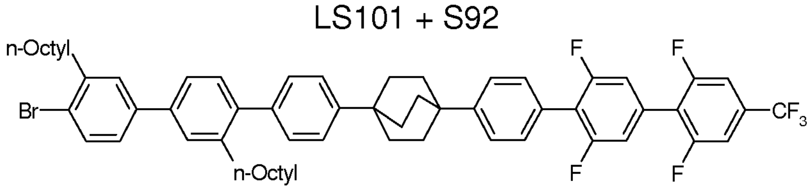 | 47 % |

**5. Synthese von Boronestern durch Suzuki-Kupplung:**

**Beispiel S200:**

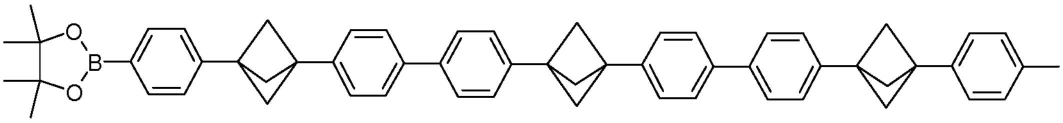

Ein Gemisch aus 47.2 g (100 mmol) S24, 57.9 g (100 mmol) S100, 23.0 g (100 mmol) Trikaliumphosphat-Monohydrat [27176-10-9] und 500 ml DMSO wird mit 1.16 g (1 mmol) Tetrakis(triphenylphosphino)palladium(0) [14221-01-3] versetzt und 18 h bei 80 °C gut gerührt. Nach Erkalten entfernt man das DMSO weitgehend im Vakuum, nimmt den Rückstand in 1000 ml heißem Toluol auf, filtriert über ein mit heißem Toluol vorgeschlämmtes Kieselgel-Bett ab, wäscht dieses mit 500 ml heißem Touol nach und engt dann die organische Phase im Vakuum zur Trockene ein. Der Rückstand wird mit 500 ml iso-Propanol ausgekocht. Nach Absaugen des Rohprodukts und Trocknen im Vakuum wird Flash-chromatographisch (CombiFlash Torrent der Fa. Axel Semrau) gereinigt. Ausbeute: 22.3 g (28 mmol), 28 %; Reinheit ca. 97 % n. $^1$H-NMR.

Analog können folgende Verbindungen dargestellt werden:

| Bsp. | Edukte Produkt | Ausbeute |
|---|---|---|
| S201 | LS11 + S102 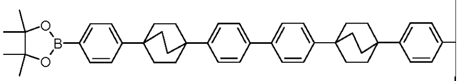 | 33 % |
| S202 | LS11 + S104 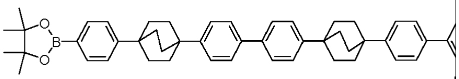 | 29 % |
| S203 | S32 + S107 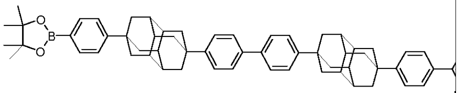 | 35 % |
| S204 | LS11 + S108 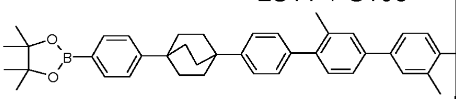 | 42 % |
| S205 | LS11 + S109 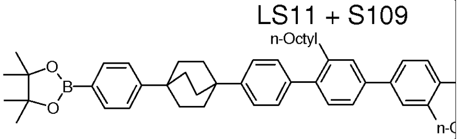 | 34 % |
| S206 | S32 + S110 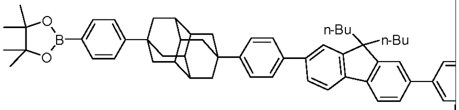 | 36 % |
| S207 | LS11 + S92 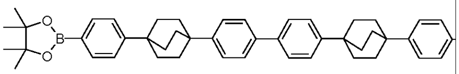 | 27% |

(fortgesetzt)

| Bsp. | Edukte Produkt | | Ausbeute |
|---|---|---|---|
| S208 | LS11 + S93 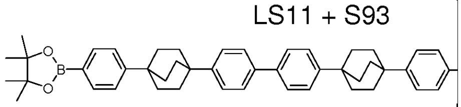 | | 24 % |
| S209 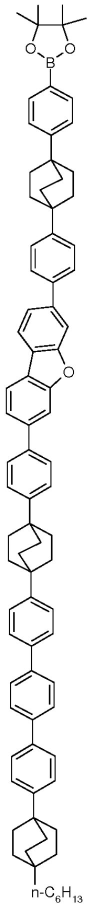 LS11 + S113 30 % | S210 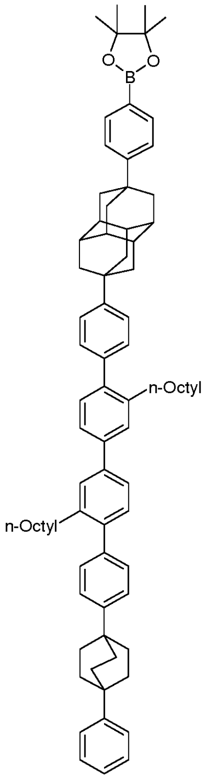 -S32 + S109 35 % | S211 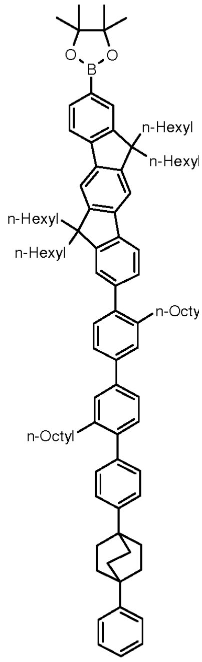 LS215 + S42 28 % | S212 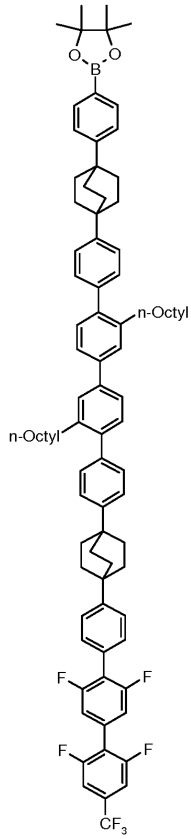 LS11 + S116 23 % |

**6. Synthese des hexadentaten Liganden L1:**

**Beispiel L1:**

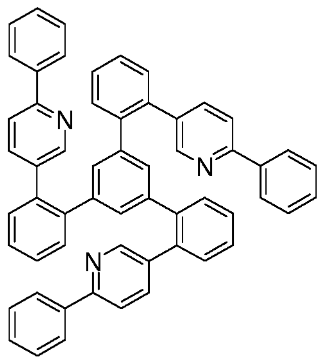

Ein Gemisch aus 54.1 g (100 mmol) 1,3,5-Tris(2-bromphenyl)benzol, [380626-56-2], 98.4 g (350 mmol) 2-Phenyl-5-(4,4,5,5-tetramethyl-[1,3,2]-dioxaborolan-2-yl)-pyridin [879291-27-7], 106.0 g (1 mol) Natriumcarbonat, 5.8 g (5 mmol) Tetrakis(triphenylphosphino)-palladium(0), 750 ml Toluol, 200 ml Ethanol und 500 ml Wasser wird unter sehr gutem Rühren 24 h unter Rückfluss erhitzt. Nach 24 h fügt man 300 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum nach Einengen der organischen Phase aus der Suzuki-Kupplung in 300 ml eines Gemischs aus Dichlormethan:Ethylacetat (8:1, vv) auf und filtriert über ein mit Dichlormethan: Ethylacetat (8:1, vv) vorgeschlämmtes Kieselgelbett (Durchmesser 15 cm, Länge 20 cm), um braune Anteile zu entfernen. Nach Einengen wird der verbliebene Schaum aus 800 ml Ethylacetat unter Zusatz von 400 ml Methanol in der Siedehitze und dann ein zweites Mal aus 1000 ml reinem Ethylacetat umkristallisiert und anschließend im Hochvakuum (p ca. $10^{-5}$ mbar, T 280 °C) Kugelrohr-sublimiert. Ausbeute: 50. 6 g (66 mmol), 66 %. Reinheit: ca. 99.7 % ig n. $^1$H-NMR.

**Beispiel L2:**

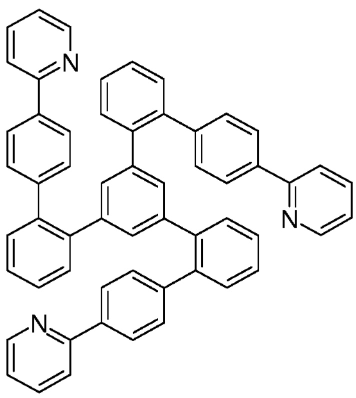

Analog kann Ligand L2 dargestellt werden. Anstelle von 2-Phenyl-5-(4,4,5,5-tetramethyl-[1,3,2]dioxaborolan-2-yl)-pyridin [879291-27-7] wird 2-[4-(4,4,5,5-tetramethyl-[1,3,2]dioxaborolan-2-yl)phenyl]-pyridin [908350-80-1] verwendet. Ausbeute: 56.0 g (73 mmol), 73 %. Reinheit: ca. 99.7 %ig n. $^1$H-NMR.

**Beispiel L3:**

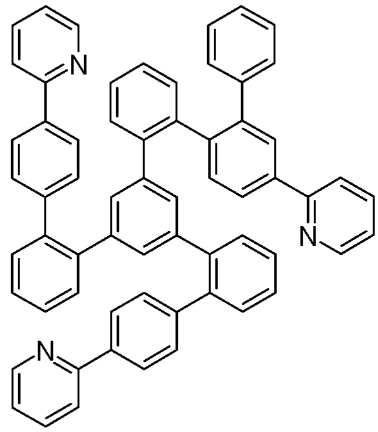

**L3-Zwischenstufe1 :**

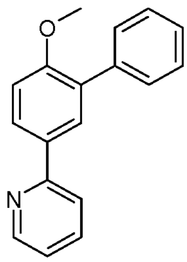

Ein Gemisch aus 22.6 g (100 mmol) (6-Methoxy-[1,1'-biphenyl]-3-yl)boronsäure [459423-16-6], 16.6 g (105 mmol) 2-Brompyridin [109-04-6], 21.2 g (200 mmol) Natriumcarbonat, 1.2 g (1 mmol) Tetrakis-triphenylphosphinopalladium [14221-01-3], 300 ml Toluol, 100 mol Ethanol und 300 ml Wasser wird unter gutem Rühren 18 h unter Rückfluss erhitzt. Nach Erkalten trennt man die organische Phase ab, wäscht diese zweimal mit je 300 ml Wasser und einmal mit 300 ml gesättigter NaCl-Lösung und trocknet über Magnesiumsulfat. Das nach Einengen der organischen Phase erhaltene Öl wird am Ölpumpenvakuum bei 80 °C getrocknet und ohne weitere Reinigung umgesetzt. Ausbeute: 25.6 g (98) mmol, 98 %; Reinheit: ca. 95 % n. $^{1}$H-NMR.

**L3-Zwischenstufe2** :

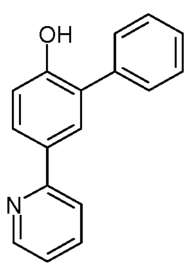

Ein Gemisch aus 26.1 g (100 mmol) L3-Zwischenstufe1 und 81.9 g (700 mmol) Pyridiniumhydrochlorid werden 3 h auf 190 °C erhitzt. Nach Erkalten gießt man die Reaktionsmischung in 500 ml Wasser ein, extrahiert fünfmal mit je 200 ml Dichlormethan, wäscht die organische Phase zweimal mit 200 ml Wasser und einmal mit 200 ml gesättigter NaCl-Lösung, entfernt das Lösungsmittel im Vakuum, gibt zur azeotropen Trocknung 300 ml Toluol zu und destilliert dieses im Vakuum komplett ab. Das so erhaltene zähe Öl wird ohne weitere Reinigung umgesetzt. Ausbeute: 21.0 g (85 mmol), 85 %; Reinheit: ca. 95 % n. $^{1}$H-NMR.

**L3-Zwischenstufe3 :**

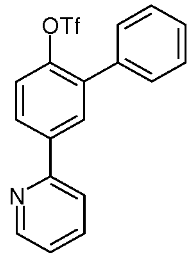

Eine auf 0 °C gekühlte Lösung von 24.7 g (100 mmol) L3-Zwischenstufe2 in einem Gemisch aus 300 ml Dichlormethan und 80 ml Pyridin wird unter gutem Rühren tropfenweise mit 34 ml (200 mmol) Trifluormethansulfonsäureanhydrid [358-23-6] versetzt. Man lässt die Reaktionsmischung auf RT erwärmen, rührt 16 h nach, gießt unter Rühren auf 1000 ml Eiswasser und extrahiert dieses dann dreimal mit je 300 ml Dichlormethan. Die vereinigten organischen Phasen werden zweimal mit je 300 ml Eiswasser und einmal mit 500 ml gesättigter NaCl-Lösung gewaschen und dann über Natriumsulfat getrocknet. Das nach Entfernen des Dichlormethans im Vakuum verbliebene Wachs wird aus Acetonitril umkristallisiert. Ausbeute: 32.6 g (86 mmol), 86 %; Reinheit: ca. 95 % n. $^1$H-NMR.

**L3-Zwischenstufe4 :**

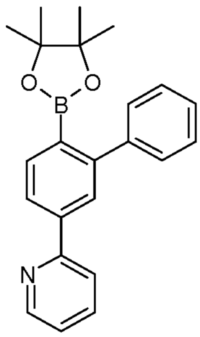

Eine Lösung von 37.9 g (100 mmol) L3-Zwischenstufe3 und 2.2 g (3 mmol) (DPPF)$PdCl_2$ in 250 ml Dioxan wird unter Rühren mit 41.6 ml (300 mmol) Triethylamin und dann mit 29.0 ml (200 mmol) 4,4,5,5-Tetramethyl-[1,3,2]dioxaborolan [25015-63-8] versetzt und anschließend 18 h unter Rückfluss erhitzt. Nach Erkalten wird das Lösungsmittel im Vakuum weitgehend entfernt, der Rückstand wird in 300 ml Ethylacetat aufgenommen, dreimal mit je 100 ml Wasser und einmal mit 200 ml gesättigter Kochsalzlösung gewaschen und über Magnesiumsulfat getrocknet. Nach Abfiltrieren des Trockenmittels wird das Lösungsmittel im Vakuum entfernt. Der so erhaltete ölige Rückstand wird ohne Reinigung weiter umgesetzt. Ausbeute: 33.9 g (95 mmol), 95 %; Reinheit: ca. 95 % n. $^1$H-NMR.

**L3-Zwischenstufe5:**

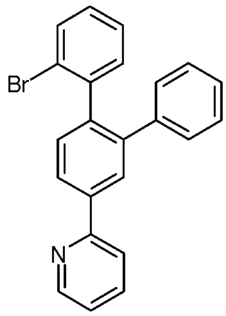

Ein Gemisch aus 35.7 g (100 mmol) L3-Zwischenstufe4, 28.3 g (100 mmol) 1-Brom-2-iod-benzol [583-55-1], 31.8 g (300 mmol) Natriumcarbonat, 787 mg (3 mmol) Triphenylphosphin, 225 mg (1 mmol) Palladium(II)acetat, 300 ml Toluol, 100 ml Ethanol und 300 ml Wasser wird 48 h unter Rückfluss erhitzt. Nach Erkalten wird die organische Phase abgetrennt, dreimal mit je 100 ml Wasser und einmal mit 100 ml gesättigter Kochsalzlösung gewaschen und über Magnesiumsulfat getrocknet. Man filtriert vom Trockenmittel über ein mit Toluol vorgeschlämmtes Celite-Bett ab, entfernt das Toluol im Vakuum und überschüssiges 1-Brom-2-iod-benzol bei 80 °C im Vakuum (ca. 0.1 mbar). Ausbeute: 36.7 g (95 mmol), 95 %; Reinheit: ca. 95 % n. $^{1}$H-NMR.

**L3:**

Ein Gemisch aus 66.3 g (100 mmol) 2-[4-[2-[3-[2-[4-(2-pyridyl)phenyl]-phenyl]-5-(4,4,5,5-tetramethyl-1,3,2-dioxaborolan-2-yl)phenyl]phenyl]-phenyl]pyridin [1989597-72-9], 38.6 g (100 mmol) L3-Zwischenstufe5, 63.7 g (300 mmol) Trikaliumphosphat, 1.6 g (4 mmol) SPhos, 449 mg (2 mmol) Palladium(II)acetat, 500 ml Toluol, 250 ml Dioxan und 500 ml Wasser wird 18 h unter Rückfluss erhitzt. Nach Erkalten trennt man die organische Phase ab, wäscht diese dreimal mit je 200 ml Wasser und einmal mit 200 ml gesättigter Kochsalzlösung, trocknet über Magnesiumsulfat, filtriert vom Trockenmittel über ein mit Toluol vorgeschlämmtes Celite-Bett ab, entfernt das Lösungsmittel im Vakuum und kristallisiert den Rückstand aus 300 ml Acetonitril unter Zugabe von ca. 80 ml Ethylacetat in der Siedehitze um. Ausbeute: 69.9 g (83 mmol), 83 %; Reinheit: ca. 95 % n. $^{1}$H-NMR.

**Beispiel L4:**

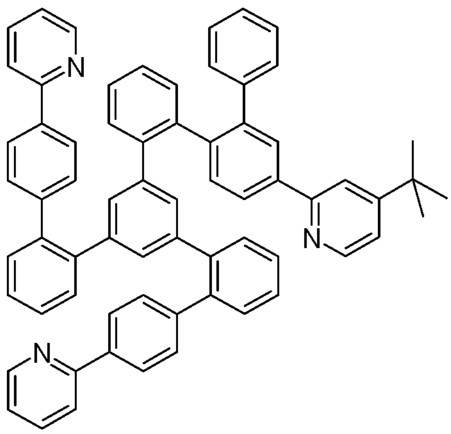

Analog zu L3 kann L4 erhalten werden, wobei anstelle von 2-Brompyridin 2-Brom-4-tert-butylpyridin [50488-34-1] eingesetzt wird.

**Beispiel L5:**

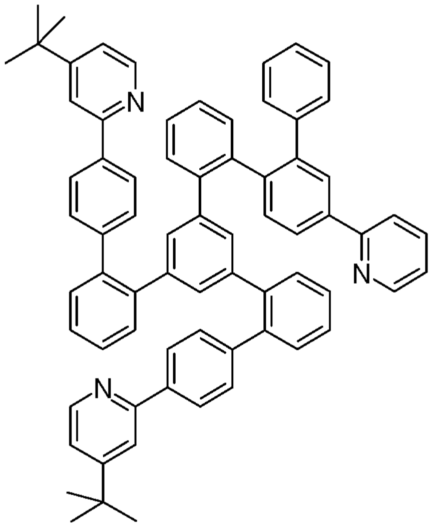

Analog zu L3 kann L5 erhalten werden, wobei anstelle von 2-[4-[2-[3-[2-[4-(2-pyridyl)phenyl]phenyl]-5-(4,4,5,5-tetramethyl-1,3,2-dioxaborolan-2-yl)phenyl]phenyl]phenyl]pyridin [1989597-72-9] das 4-tert-Butyl-2-[4-[2-[3-[2-[4-(4-tert-butyl-2-pyridyl)phenyl]phenyl]-5-(4,4,5,5-tetramethyl-1,3,2-dioxaborolan-2-yl)phenyl]phenyl]phenyl]pyridin [1989597-75-2] eingesetzt wird.

**B: Metallorganische Synthone**

**1. Literaturbekannte Metallkomplex-Synthone MS:**

| | |
|---|---|
| 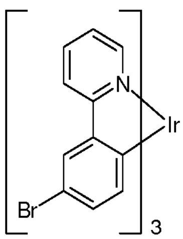<br>454454-92-3<br>MS1 | 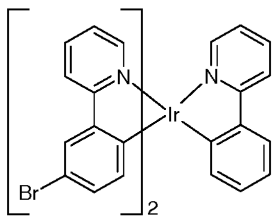<br>453538-21-1<br>MS2 |
| 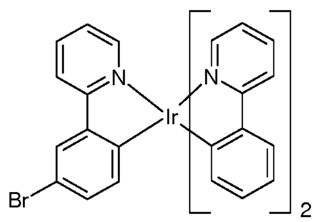<br>454454-89-8<br>MS3 | 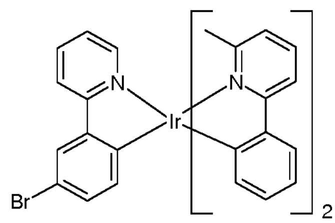<br>1149344-63-7<br>MS4 |

| | |
|---|---|
| 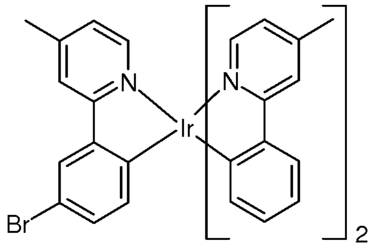<br>1149344-49-9<br>MS5 | 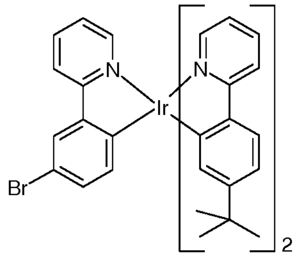<br>1252029-12-1<br>MS6 |
| 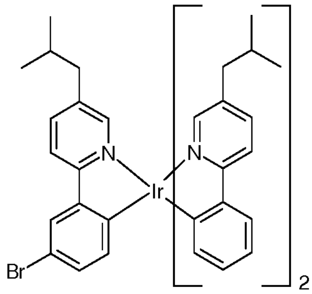<br>1149344-55-7<br>MS7 | 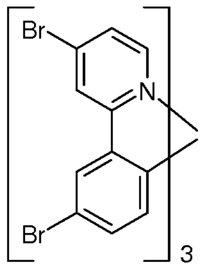<br>1309878-11-1<br>MS8 |
| 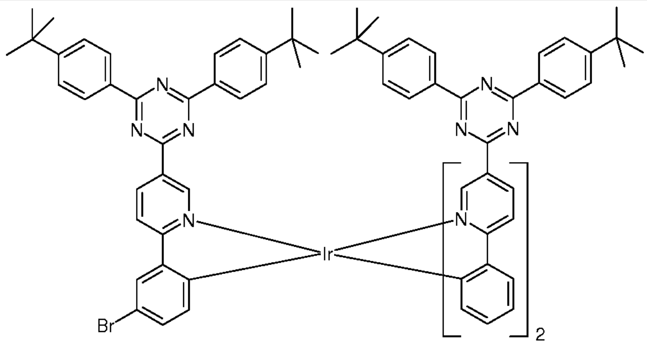<br>1820909-79-2<br>MS9 | |
| 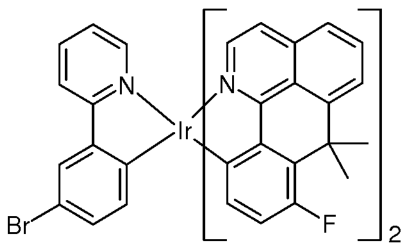<br>1423076-38-3<br>MS10 | 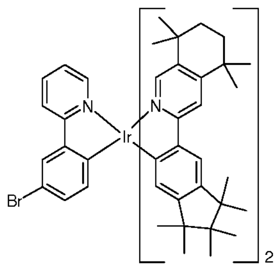<br>1803296-02-7<br>MS11 |

| | |
|---|---|
| 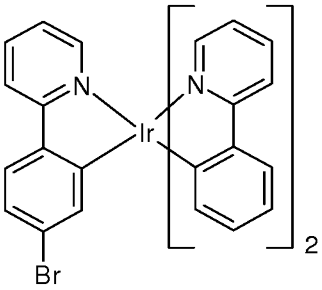<br>501330-36-5<br>MS12 | 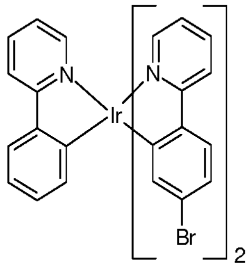<br>1627953-70-1<br>MS13 |
| 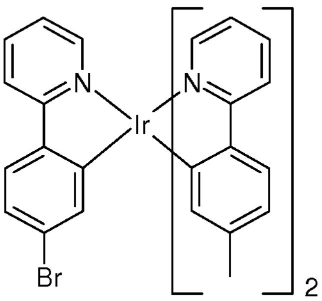<br>1455513-03-7<br>MS14 | 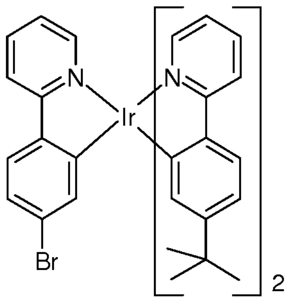<br>1252029-10-9<br>MS15 |
| 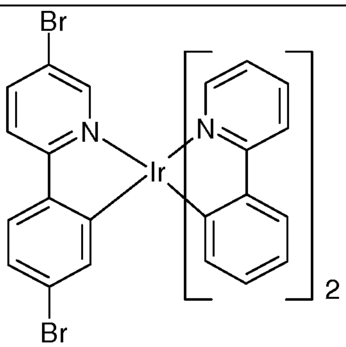<br>929088-09-5<br>MS16 | 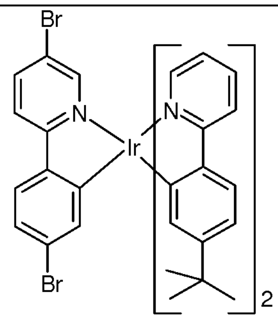<br>1252029-11-0<br>MS17 |
| 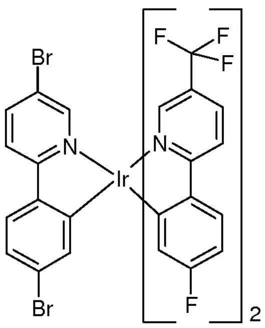<br>387859-69-0<br>MS18 | 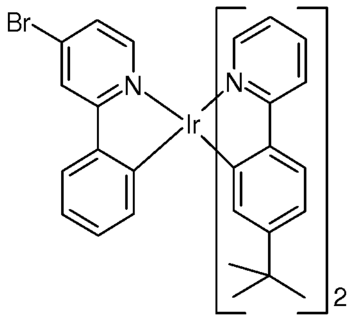<br>1651859-59-4<br>MS19 |

| | |
|---|---|
| 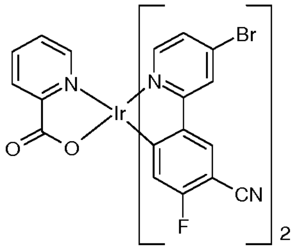<br>1783850-02-1<br>MS20 | 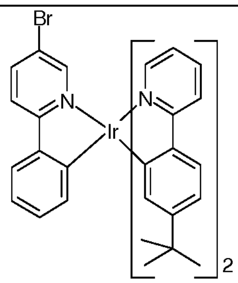<br>1252029-09-6<br>MS21 |
| 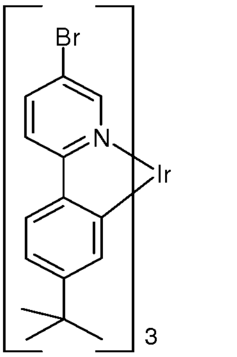<br>1651859-63-0<br>MS22 | 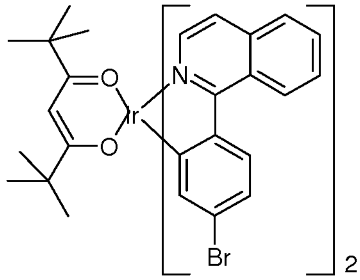<br>881882-67-3<br>MS23 |
| 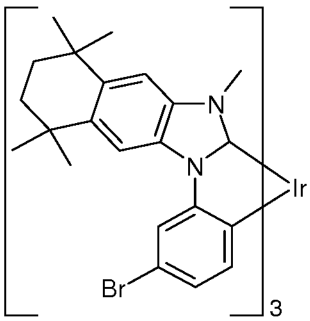<br>1803319-99-4<br>MS24 | 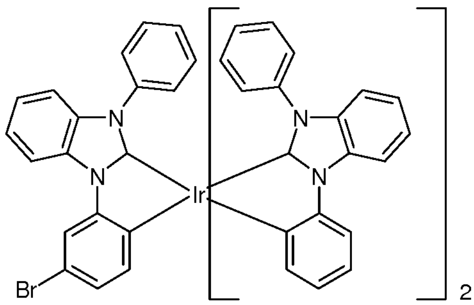<br>1651822-19-3<br>MS25 |
| 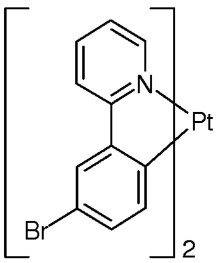<br>690269-08-0<br>MS26 | 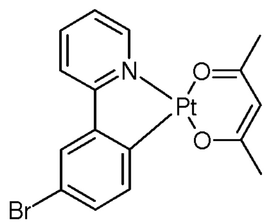<br>1364058-57-0<br>MS27 |

| | |
|---|---|
| 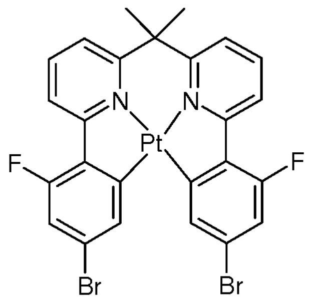<br>1285719-18-7<br>MS28 | 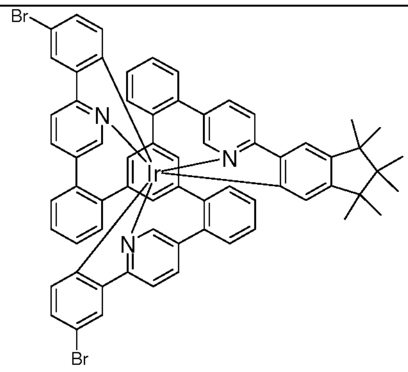<br>1989601-69-5<br>MS29 |

**2. Synthese des Metallkomplexes Ir(L1):**

**Beispiel Ir(L1):**

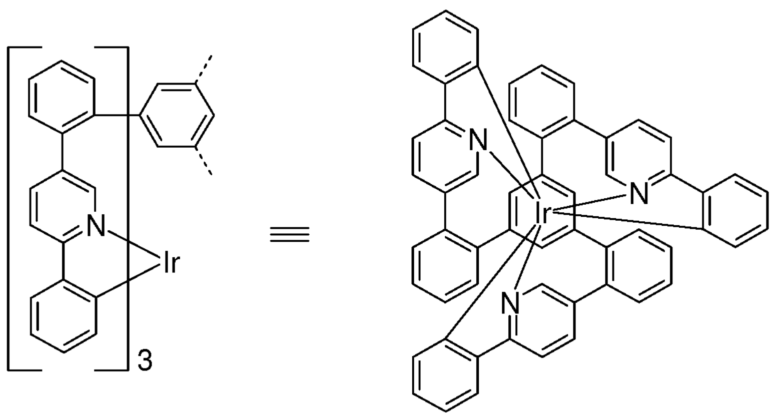

Ein Gemisch aus 7.66 g (10 mmol) des Liganden L1, 4.90 g (10mmol) Tris-acetylacetonato-iridium(III) [15635-87-7] und 120 g Hydrochinon [123-31-9] werden in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250-260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 250-260 °C gehalten, wobei wenig Kondensat abdestilliert und sich im Wasserabscheider sammelt. Nach Erkalten wird der Schmelzkuchen mechanisch zerkleinert und mit 500 ml Methanol ausgekocht. Die so erhaltene beige Suspension wird über eine Umkehrfritte filtriert, der beige Feststoff wird einmal mit 50 ml Methanol gewaschen und dann im Vakuum getrocknet. Rohausbeute: quantitativ. Der so erhaltene Feststoff wird in 1500 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer weitgehend eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des gelben Produkts durch dreimalige kontinuierliche Heißextraktion mit Toluol:Acetonitril (3:1, vv) und fünfmalige Heißextraktion mit Toluol (Vorlagemenge jeweils ca. 150 ml, Extraktionshülse:

Standard Soxhletthülsen aus Cellulose der Fa. Whatman) unter sorgfältigem Luft- und Lichtausschluss. Ausbeute: 8.52 g (8.9 mmol), 89 %. Reinheit: > 99.9 % nach HPLC.

**Beispiel Ir(L2):**

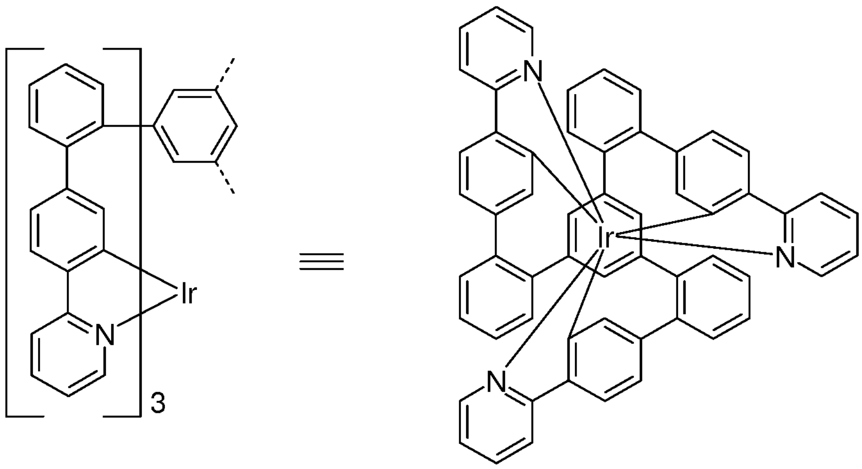

Analog kann Ir(L2) unter Verwendung von L2 statt L1 dargestellt werden.

Die Reinigung erfolgt durch dreimalige Umkristallisation aus NMP unter Zusatz von Methanol beim Auskühlen der Lösung. Ausbeute: 8.04 g (8.4 mmol), 84 %. Reinheit: > 99.7 % nach HPLC.

Analog können folgende Metallkomplexe dargestellt werden, wobei die Reinigung wie bei Ir(L1) beschrieben erfolgt.

| Bsp. | Ligand | Komplex | Ausbeute |
| --- | --- | --- | --- |
| Ir(L3) | L3 | 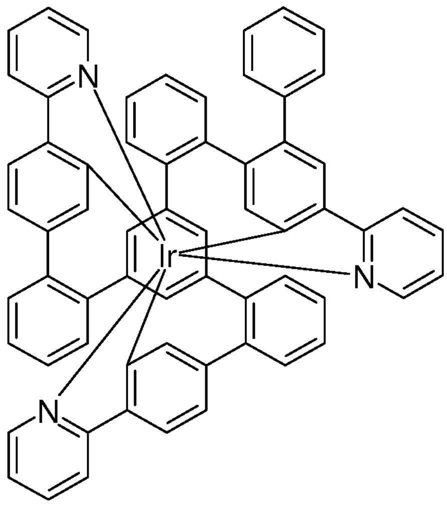 | 87 % |

(fortgesetzt)

| Bsp. | Ligand | Komplex | Ausbeute |
|---|---|---|---|
| Ir(L4) | L4 | 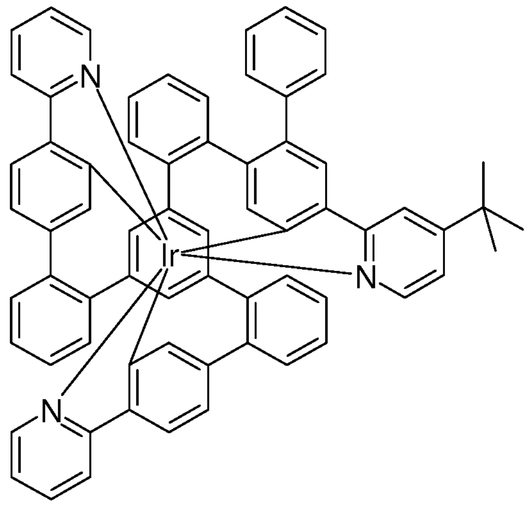 | 89 % |
| Ir(L5) | L5 | 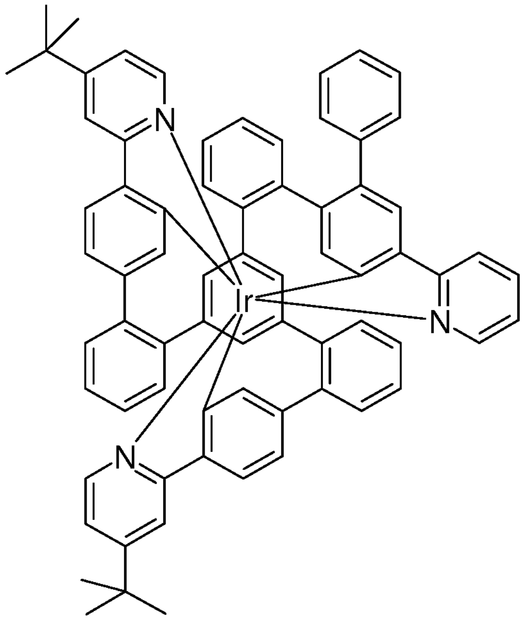 | 86 % |

### 3. Halogenierung des Metallkomplexes Ir(L1)

**Allgemeine Durchführung:**

Eine Lösung bzw. Suspension von 10 mmol eines Komplexes, der in para-Position zum Iridium A x C-H-Gruppen trägt, in 500 ml bis 2000 ml DCM (Dichlormethan), je nach Löslichkeit des Metallkomplexes, wird unter Licht- und Luftausschluss bei -30 bis +30 °C mit A x 10.5 mmol N-Halogen-succinimid (Halogen: Cl, Br, I; A = 1 entspricht Mono-, A = 2 entspricht Di-, A = 3 entspricht Trihalogenierung) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit ca. 30 ml Methanol gewaschen und dann im Vakuum getrocknet. Unterstöchiometrische Bromierungen, z.B. Mono- und Di-Bromierungen von Komplexen mit 3 C-H-Gruppen para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) getrennt werden.

**Beispiel Ir(L1-3Br):**

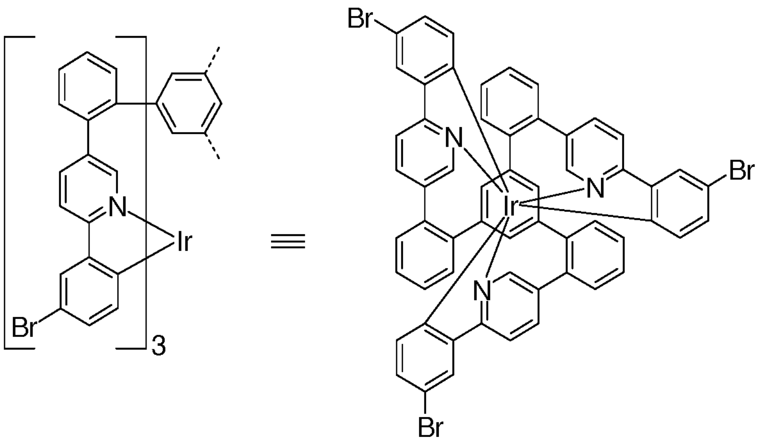

Eine bei 0 °C gerührte Suspension von 9.6 g (10 mmol) Ir(L1) in 2000 ml DCM wird auf einmal mit 5.6 g (31.5 mmol) N-Bromsuccinimid versetzt und dann weitere 20 h gerührt. Nach Entfernen von ca. 1900 ml des DCMs im Vakuum wird die gelbe Suspension mit 100 ml Methanol versetzt, unter Rühren ausgekocht, der Feststoff wird abgesaugt, dreimal mit ca. 30 ml Methanol gewaschen und dann im Vakuum getrocknet. Ausbeute: 11.3 g (9.5 mmol) 95 %; Reinheit: > 99.0 %ig nach NMR.

Analog können folgende Komplexe dargestellt werden:

| Bsp. | Edukt > bromierter Komplex | Ausbeute |
|---|---|---|
| | Tribromierung | |
| Ir(L2-3Br) | 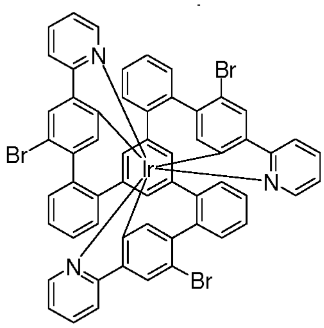<br>Ir(L2) + 40 mmol NBS > Ir(L2-3Br)<br>Lösungsmittel DCM | 94 % |
| | Dibromierung | |
| Ir(L1-2Br) | 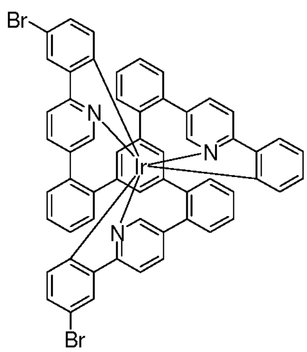<br>Ir(L1) + 21 mmol NBS > Ir(L1-2Br)<br>Lösungsmittel DMSO | 33 % |

(fortgesetzt)

| Dibromierung | | |
|---|---|---|
| Ir(L2-2Br) | 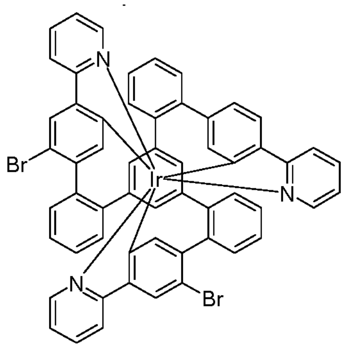<br>Ir(L2) + 21 mmol NBS > Ir(L2-2Br)<br>Lösungsmittel DMSO / 60 °C | 26 % |
| Ir(L3-2Br) | 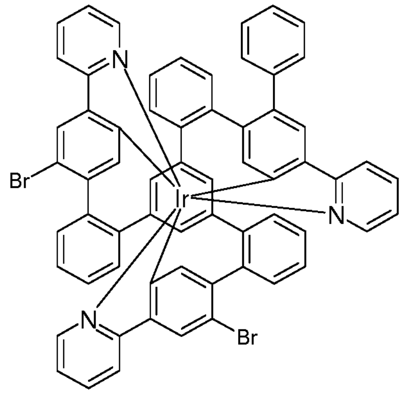<br>Ir(L3) + 21 mmol NBS > Ir(L3-2Br)<br>Lösungsmittel DCM / RT | 95 % |
| Ir(L4-2Br) | 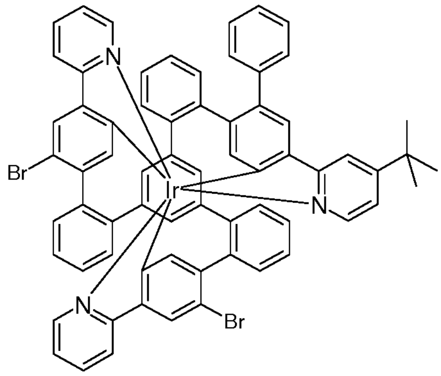<br>Ir(L4) + 21 mmol NBS > Ir(L4-2Br)<br>Lösungsmittel DCM / RT | 96 % |

(fortgesetzt)

| Dibromierung | | |
|---|---|---|
| Ir(L5-2Br) | 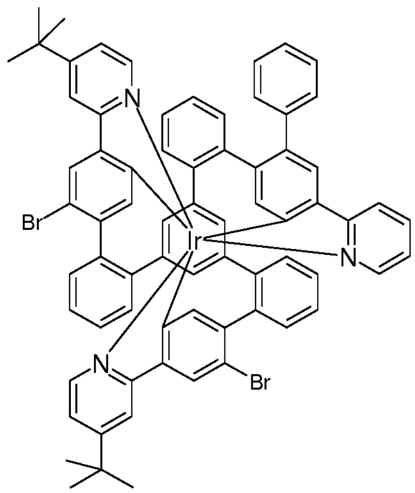<br>Ir(L5) + 21 mmol NBS > Ir(L5-2Br)<br>Lösungsmittel DCM / RT | 95 % |
| Monobromierung | | |
| Ir(L1-1Br) | 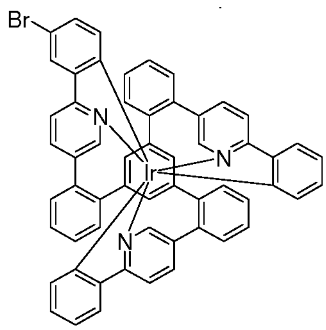<br>Ir(L1) + 10.5 mmol NBS > Ir(L1-1 Br)<br>Lösungsmittel DMSO | 24 % |
| Ir(L2-1 Br) | 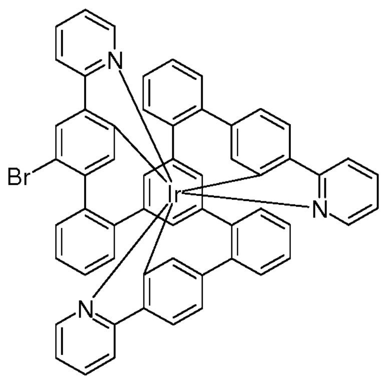<br>Ir(L2) + 10.5 mmol NBS > Ir(L2-1 Br)<br>Lösungsmittel DMSO / 60 °C | 19 % |

**4. Darstellung der erfindungsgemäßen Metallkomplexe**

**Variante 1: Suzuki-Kupplung im zweiphasigen wässrig-organischen Medium**

Ein Gemisch aus 10 mmol des bromierten Metallkomplexes, A x 11 mmol des Monoboronesters mit A = 1, 2

oder 3 für Mono-, Di- oder Tribromide, A x 30 mmol Trikaliumphosphat [7778-53-2], 300 ml Toluol, 100 ml Dioxan und 100 ml Wasser wird mit A x 0.6 mmol Tri-o-tolylphosphin [6163-58-2] und mit A x 0.1 mmol Palladium(II)acetat [3975-31-3] versetzt und 18 h bei 100 °C gut gerührt. Nach Erkalten saugt man vom ausgefallenen Feststoff ab. Fällt kein Festsoff aus, trennt man die organische Phase ab, wäscht diese zweimal mit je 300 ml Wasser, einmal mit 300 ml gesättigter Kochsalzlösung, trocknet dann über Magnesiumsulfat, filtriert vom Magnesiumsulfat ab und engt das Filtrat zur Tockene ein. Das so erhaltene Rohprodukt wird chromatographisch oder Flash-chromatographisch (CombiFlash Torrent der Fa. Axel Semrau) gereinigt. Die weitere Reinigung erfolgt durch wiederholte kontinuierliche Heißextraktion, wobei das Produkt in einem Heißextraktor in einer Cellulosehülse (Fa. Whatman) vorgelegt und mit einem geeigneten Heißextraktionsmittel, z. B. Toluol, Chlorbenzol, Anisol, Ethylacetat, Butylacetat, Acetonitril, Dichlormethan, etc. (Vorlagemenge ca. 150-200 ml) wiederholt (typischerweise 3-6 mal) heißextrahiert wird, bis eine Reinheit > 99.5 %, bevorzugt > 99.9 % erreicht wird.

**Variante 2: Suzuki-Kupplung im einphasigen dipolar-aprotischen Medium**

Ein Gemisch aus 10 mmol des Metallkomplexes, A x 11 mmol des Monoboronesters mit A = 1, 2 oder 3 für Mono-, Di- oder Tribromide, A x 30 mmol Trikaliumphosphat-Trihydrat [22763-03-7] und 200 ml DMSO wird mit A x 0.1 mmol Tetrakis(triphenylphosphino)palladium(0) [14221-01-3] versetzt und 18 h bei 80 °C gut gerührt. Nach Erkalten entfernt man das DMSO weitgehend im Vakuum, nimmt den Rückstand in 1000 ml Dichlormethan auf, filtriert über ein mit Dichlormethan vorgeschlämmtes Kieselgel-Bett ab, wäscht dieses mit 500 ml Dichlormethan nach und engt dann die organische Phase im Vakuum zur Trockene ein. Die weitere Reinigung des so erhaltenen Rohprodukts erfolgt wie unter Variante 1 beschrieben.

**Beispiel Ir1: MS1 + 3xS20 → (MS1-3xS20) = Ir1**

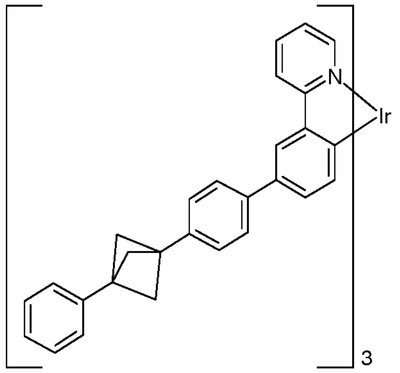

Durchführung nach Variante 1. Einsatz von 8.92 g (10.0 mmol) MS1, 11.43 g (33.0 mmol) S20, 19.12 g (90.0 mmol) Trikaliumphosphat, 548 mg (1.8 mmol) Tri-o-tolylphosphin, 67 mg (0.3 mmol) Palladium(II)acetat. Heißextraktion: 5 x aus Toluol. Ausbeute: (4.8 mmol), 48 %. Reinheit: > 99.8 % n. HPLC.

Analog können folgende Verbindungen dargestellt werden:

| Bsp. | Edukte → Produkt<br>Heißextraktionsmittel* | Ausbeute |
|---|---|---|
| Ir2 | MS1 + 3xS26 → (MS1-3xS26) = Ir2 | 44 % |

(fortgesetzt)

| Bsp. | Edukte → Produkt<br>Heißextraktionsmittel* | Ausbeute |
|---|---|---|
| | 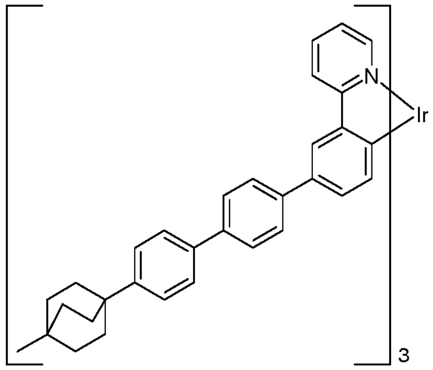<br>Xylol | |
| Ir3 | MS1 + 3xS27 → (MS1-3xS27) = Ir3 | 45 % |
| Ir4 | MS1 + 3xS41 → (MS1-3xS41) = Ir4 | 41 % |
| Ir5 | MS1 + 3xS92 → (MS1-3xS92) = Ir5 | 46 % |
| Ir6 | MS1 + 3xS208 → (MS1-3xS208) = Ir6 | 39 % |
| Ir7 | MS2 + 2xS37 → (MS2-2xS37) = Ir7 | 59 % |
| Ir8 | MS2 + 2xS46 → (MS3-2xS46) = Ir8 | 61 % |
| Ir9 | MS3 + 1xS25 → (MS3-1xS25) = Ir9 | 70 % |
| Ir10 | MS3 + 1xS92 → (MS3-1xS92) = Ir10 | 68 % |
| Ir11 | MS3 + 1xS212 → (MS3-1xS212) = Ir11 | 71 % |
| Ir12 | MS4 + 1xS205 → (MS4-1xS205) = Ir12 | 75 % |
| Ir13 | MS5+ 1xS29 → (MS51xS29) = Ir13 | 67% |
| Ir14 | MS6 + 1xS39 → (MS6-1xS39) = Ir14 | 70 % |
| Ir15 | MS7 + 1xS42 → (MS7-1xS42) = Ir15 | 72 % |
| Ir16 | MS8 + 6S28 → (MS8-6xS28) = Ir16 | 24 % |
| Ir17 | MS9 + 1 xS211 → (MS9-1xS211) = Ir17 | 66 % |
| Ir18 | MS10 + 1xS46 → (MS10-1xS46) = Ir18 | 67 % |
| Ir19 | MS11 + 1xS43 → (MS11-1xS43) = Ir19 | 70 % |
| Ir20 | MS12 + 1xS93 → (MS12-1xS93) = Ir20<br>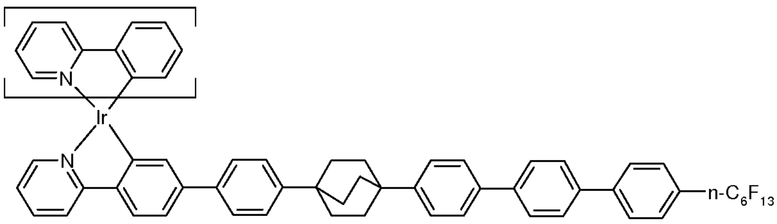<br>Mesitylen | 67 % |
| Ir21 | MS13 + 2xS26 → (MS13-2xS26) = Ir21 | 53 % |
| Ir22 | MS14 + 1xS210 → (MS14-1xS210) = Ir22 | 62 % |

(fortgesetzt)

| Bsp. | Edukte → Produkt<br>Heißextraktionsmittel* | Ausbeute |
|---|---|---|
| Ir23 | MS15 + 1xS207 → (MS15-1xS207) = Ir23 | 66 % |
| Ir24 | MS16 + 2xS27 → (MS16-2xS27) = Ir24<br>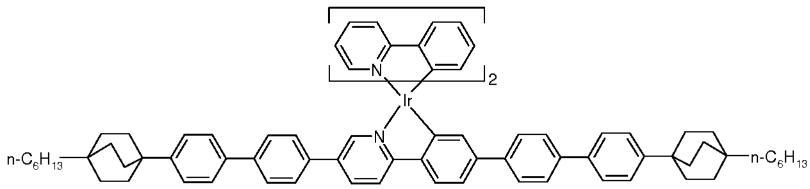 | 53 % |
| Ir25 | MS17 + 2xS205 → (MS17-2xS205) = Ir25 | 51 % |
| Ir26 | MS18 + 2xS209 → (MS18-2xS209) = Ir26 | 54 % |
| Ir27 | MS19 + 1xS203 → (MS19-1xS203) = Ir27<br>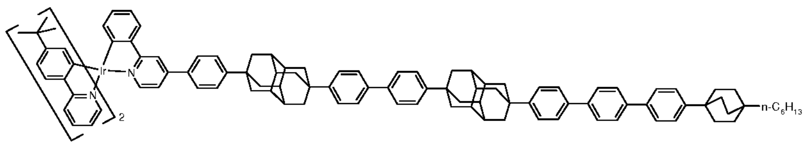 | 68 % |
| Ir28 | MS20 + 2xS91 → (MS20-2xS91) = Ir28 | 50 % |
| Ir29 | MS21 + 1xS204 → (MS21-1xS204) = Ir29<br>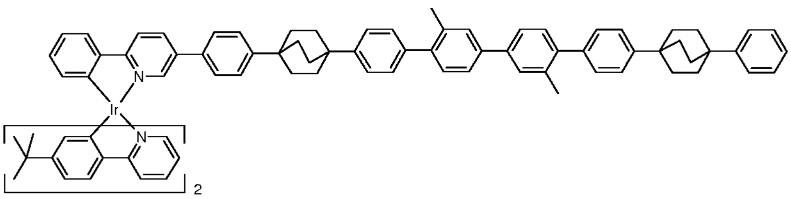 | 62 % |
| Ir30 | MS22 + 3xS22 → (MS22-3xS22) = Ir30 | 43 % |
| Ir31 | MS23 + 2xS45 → (MS23-2xS45) = Ir31 | 49 % |
| Ir32 | MS24 + 3xS41 → MS24-3xS41 = Ir32<br>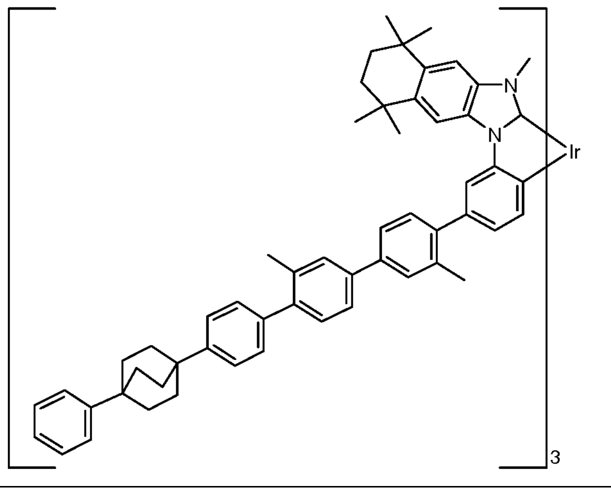 | 54 % |
| Ir33 | MS25 + 1xS205 → (MS25-1xS205) = Ir33 | 72 % |
| IPt1 | MS26 + 2xS25 → MS26-2xS25 = Pt1 | 57 % |

(fortgesetzt)

| Bsp. | Edukte → Produkt<br>Heißextraktionsmittel* | Ausbeute |
|---|---|---|
| | 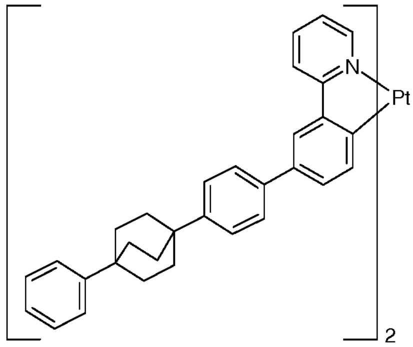 | |
| Pt2 | MS27 + 1xS37 → (MS27-1xS37) = Pt2 | 56 % |
| Pt3 | MS28 + 2xS205 → (MS28-2xS205) = Pt3<br>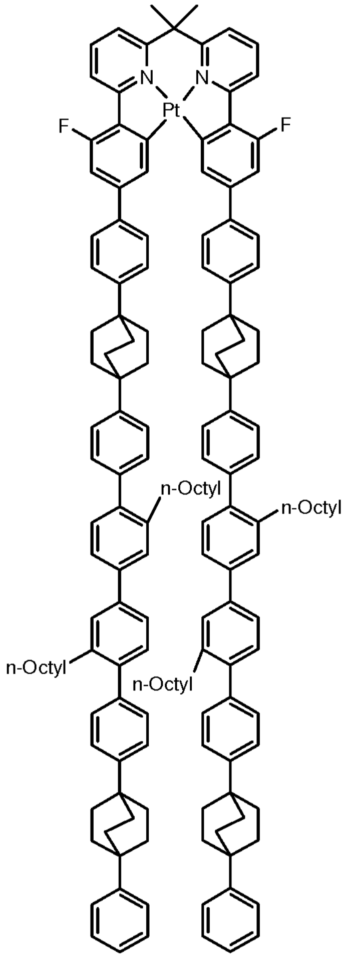<br>Butylacetat | 34 % |
| Ir37 | Ir(L1-3Br) + 3xS28 → Ir(L1-3xS28) = Ir37 | 44 % |

(fortgesetzt)

| Bsp. | Edukte → Produkt<br>Heißextraktionsmittel* | Ausbeute |
|---|---|---|
| | 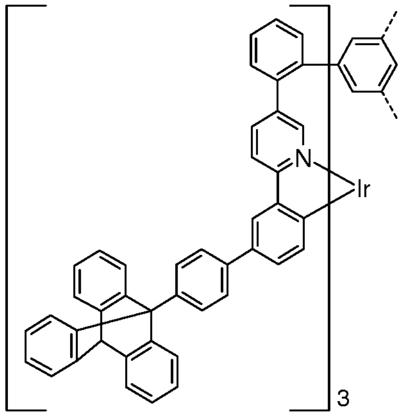<br>Variante 2 – auch Ir38 bis Ir55 | |
| Ir38 | Ir(L1-3Br) + 3xS26 → Ir(L1-3xS26) = Ir38 | 46 % |
| Ir39 | Ir(L1-3Br) + 3xS42 → Ir(L1-3xS42) = Ir39 | 40 % |
| Ir40 | Ir(L1-3Br) + 3xS205 → Ir(L1-3xS205) = Ir40 | 41 % |
| Ir41 | Ir(L1-2Br) + 2xS29 → Ir(L1-2xS29) = Ir41<br>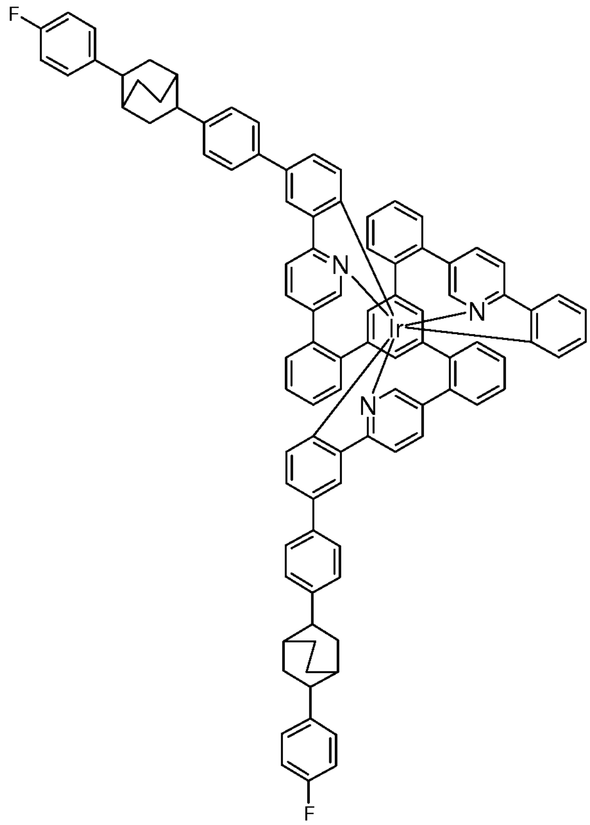<br>Variante 2 | 57 % |
| Ir42 | Ir(L1-2Br) + 2xS40 → Ir(L1-2xS40) = Ir42 | 55 % |
| Ir43 | Ir(L1-2Br) + 2xS44 → Ir(L1-2xS44) = Ir43 | 55 % |

(fortgesetzt)

| Bsp. | Edukte → Produkt Heißextraktionsmittel* | Ausbeute |
|---|---|---|
| Ir44 | Ir(L1-2Br) + 2xS205 → Ir(L1-2xS205) = Ir44 | 58 % |
| Ir45 | Ir(L1-1Br) + 1xS29 → Ir(L1-1xS29) = Ir45 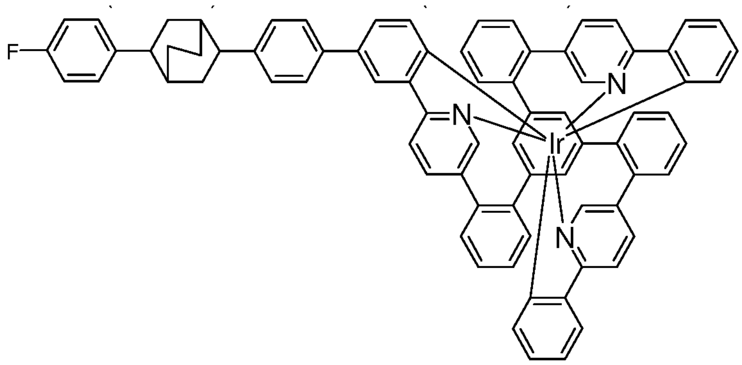 Variante 2 | 64 % |
| Ir46 | Ir(L1-1Br) + 1xS35 → Ir(L1-1xS35) = Ir46 | 66 % |
| Ir47 | Ir(L1-1Br) + 1xS40 → Ir(L1-1xS40) = Ir47 | 70 % |
| Ir48 | Ir(L1-1Br) + 1xS44 → Ir(L1-1xS44) = Ir48 | 72 % |
| Ir49 | Ir(L1-1Br) + 1xS92 → Ir(L1-1xS92) = Ir49 | 67 % |
| Ir50 | Ir(L1-1Br) + 1xS202 → Ir(L1-1xS202) = Ir50 | 65 % |
| Ir51 | Ir(L1 -1Br) + 1xS203 → Ir(L1-1xS203) = Ir51 | 70 % |
| Ir52 | Ir(L1 -1Br) + 1xS205 → Ir(L1-1xS205) = Ir52 | 71 % |
| Ir53 | Ir(L1 -1Br) + 1xS207 → Ir(L1-1xS207) = Ir53 | 76 % |
| Ir54 | Ir(L1-1Br) + 1xS210 → Ir(L1-1xS210) = Ir54 | 73 % |
| Ir55 | Ir(L1-1Br) + 1xS212 → Ir(L1-1xS212) = Ir55 | 69 % |
| Ir56 | Ir(L2-3Br) + 3xS27 → Ir(L1-3xS27) = Ir56 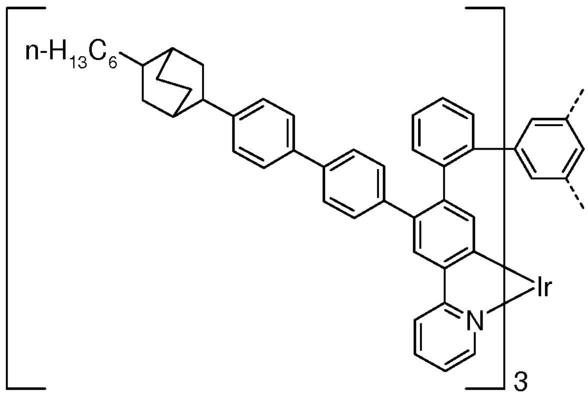 Variante 2 – auch Ir57 bis Ir60 | 42 % |
| Ir57 | Ir(L2-2Br) + 2xS26 → Ir(L2-2xS26) = Ir57 | 54 % |

(fortgesetzt)

| Bsp. | Edukte → Produkt<br>Heißextraktionsmittel* | Ausbeute |
|---|---|---|
| | 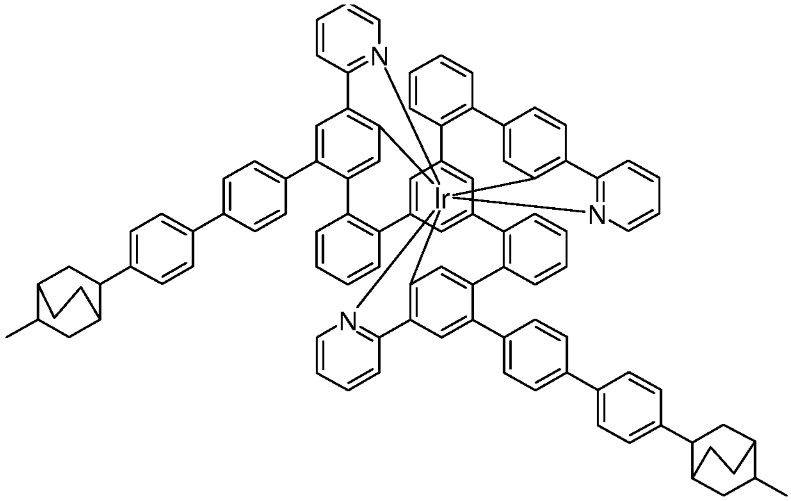 | |
| Ir58 | Ir(L2-1Br) + 1xS23 → Ir(L1-1xS23) = Ir58<br>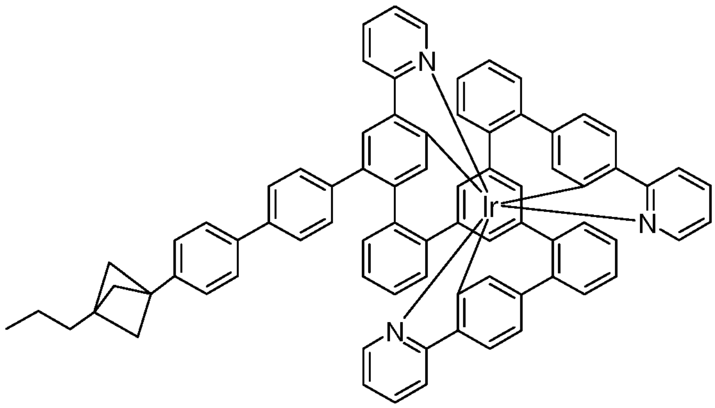 | 69 % |
| Ir59 | Ir(L2-1 Br) + 1xS210 → Ir(L1-1xS10) = Ir59 | 67 % |
| Ir60 | Ir(L2-1 Br) + 1xS212 → Ir(L1-1xS212) = Ir60 | 69 % |
| Ir61 | MS29 + 2xS205 → (MS29-2xS205) = Ir61 | 55 % |
| Ir62 | Ir(L3-2Br) + 2xS26 → Ir(L3-2xS26) = Ir62 | 53 % |
| Ir63 | Ir(L3-2Br) + 2xS42 → Ir(L3-2xS42) = Ir63 | 49 % |
| Ir64 | Ir(L4-2Br) + 2xS37 → Ir(L4-2xS37) = Ir64 | 51 % |
| Ir65 | Ir(L5-2Br) + 2xS46 → Ir(L5-2xS46) = Ir65 | 57 % |
| IrRef4 | Ir(L3-2Br) + 2x[5122-95-2] = IrRef4 | |

(fortgesetzt)

| Bsp. | Edukte → Produkt<br>Heißextraktionsmittel* | Ausbeute |
|---|---|---|
| | 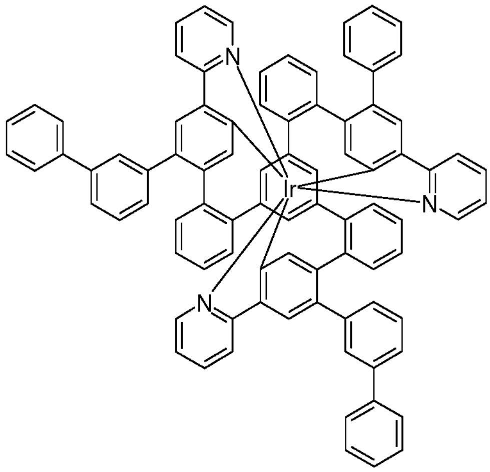 | |
| IrRef5 | Ir(L4-2Br) + 2x[5122-94-1] = IrRef5<br>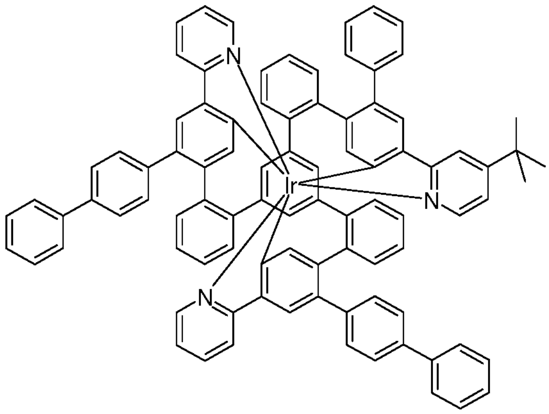 | |
| IrRef6 | Ir(L5-2Br) + 2x[100124-06-9] = IrRef6<br>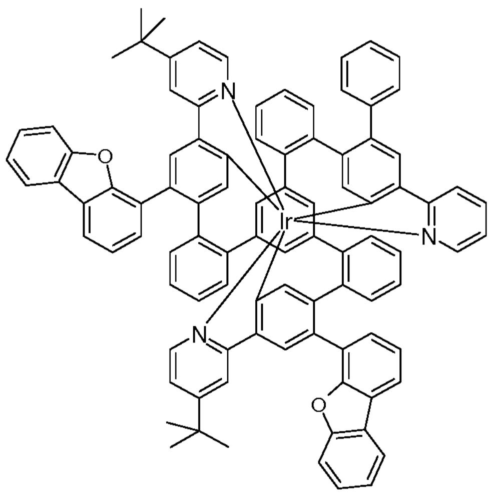 | |
| IrRef7 | Ir(L5-2Br) + 2x[395087-89-5] = IrRef7 | |

(fortgesetzt)

| Bsp. | Edukte → Produkt Heißextraktionsmittel* | Ausbeute |
|---|---|---|
| | 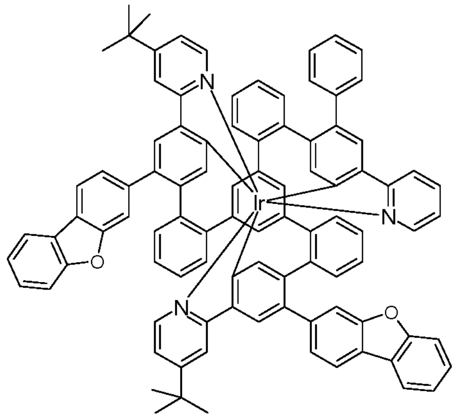 | |
| *: sofern abweichend von Beispiel Ir1 | | |

**5) Oligomere / polymere Metallkomplexe**

**Allgemeine Polymerisationsvorschrift für die Bromide bzw. Boronsäure-Derivate als polymerisierbare Gruppe, Suzuki-Polymerisation**

**Variante A- Zweiphasiges Reaktionsgemisch**

Die Durchführung erfolgt in Anlehnung an WO 2002/077060 und WO 2003/048225 unter inerten Bedingungen mit sorgfältig entgasten Lösungsmitteln. Die Monomere (Bromide und Boronsäuren bzw. Boronsäureester, Reinheit nach HPLC > 99.8 %ig) werden in der in der nachfolgenden Tabelle angegebenen Zusammensetzung in einer Gesamtkonzentration von ca. 100 mmol/L in einem Gemisch aus 3 Volumenteilen Toluol : 6 Volumenteilen Dioxan : 2 Volumenteilen Wasser umgesetzt. Dabei werden das Monomer M1 und das Monomer M2 stets vollständig vorgelegt. Dann gibt man 2 mol Äquivalente Trikaliumphosphat pro insgesamt eingesetzter Br-Funktionalität zu, rührt 5 min. nach, fügt dann 0.06 mol Äquivalente Tri-ortho-tolylphosphin und dann 0.01 mol Äquivalente Palladium(II)acetat pro eingesetzter Br-Funktionalität zu und erhitzt unter sehr gutem Rühren unter Rückfluss. Nach 1 h fügt man die restlichen Monomere gemäß Tabelle auf einmal zu und erhitzt für weitere 4 h unter Rückfluss. Falls die Viskosität der Mischung zu stark ansteigt, kann mit einem Gemisch aus 2 Volumenteilen Toluol : 3 Volumenteilen Dioxan verdünnt werden. Nach insgesamt 4-6 h Reaktionszeit fügt man zum End-capping 0.05 mol Aquivalente pro eingesetzter Boronsäure-Funktionalität eines Monobromaromaten, hier 3-Brombiphenyl [2113-57-7] und dann nach 30 min. 0.05 mol Äquivalente pro eingesetzter Br-Funktionalität einer Monoboronsäure bzw. eines Monoboronsäureesters, hier Biphenyl-3-pinacolboronester [912844-88-3], zu und kocht weitere 1 h nach. Nach Erkalten verdünnt man mit 500 ml Toluol, trennt die wässrige Phase ab und wäscht die organische Phase zweimal mit je 300 ml Wasser. Man rührt die organische Phase 16 h bei 80 °C mit 300 m l einer wässrigen 5 Gew.-%igen N-Acetylcystein-Lösung, trennt die organische Phase ab, trocknet über Magnesiumsulfat, filtriert über ein Celite-Bett ab und engt dann zur Trockene ein. Man löst das Rohpolymer in THF (Konzentration ca. 10 - 30 g/L) und lässt die Lösung unter sehr gutem Rühren langsam in das doppelte Volumen Methanol einlaufen. Das Polymer wird abgesaugt und dreimal mit Methanol gewaschen und getrocknet. Der Umfällvorgang wird fünfmal wiederholt, danach wird das Polymer im Vakuum bis zur Gewichtskonstanz bei 30-50 °C getrocknet.

**Variante B - Einphasiges Reaktionsgemisch**

Die Monomere (Bromide und Boronsäuren bzw. Boronsäureester, Reinheit nach HPLC > 99.8 %ig) werden in der in der nachfolgenden Tabelle angegebenen Zusammensetzung in einer Gesamtkonzentration von ca. 100 mmol/L in einem Lösemittel (THF, Dioxan, Xylol, Mesitylen, Dimethylacetamid, NMP, DMSO, etc.) gelöst bzw. suspendiert. Dann gibt man 3 mol Äquivalente Base (Kaliumfluorid, Trikaliumphosphat (wasserfrei, Monohydrat oder Trihydrat), Kaliumcarbonat, Cäsiumcarbonat, etc., jeweils wasserfrei) pro Br-Funktionalität und das Gewichtsäquivalent Glaskugeln (3 mm Durchmesser) zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro Br-Funktionalität

zu und erhitzt unter sehr gutem Rühren 2-3 h auf 80 °C bis unter Rückfluss. Alternativ können andere Phosphine wir Tri-tert-butylphosphin, SPhos, XPhos, RuPhos, XanthPhos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum End-capping 0.05 mol Äquivalente eines Monobromaromaten (siehe oben) und dann 30 min. danach 0.05 mol Äquivalente einer Monoboronsäure bzw. eines Monoboronsäureesters (siehe oben) zu und kocht weiter 1 h nach. Man entfernt das Lösungsmittel weitgehend im Vakuum, nimmt den Rückstand in Toluol auf und reinigt das Polymer wie unter Variante A beschrieben.

Oliogomer/Polymer P und deren Zusammensetzung aus den Monomeren M1 bis M5, Angaben in mmol:

| Bsp. | M1 | M2 | M3 | M4 | M5 | Ausbeute |
|---|---|---|---|---|---|---|
| IrP1 | MS5<br>20 mmol | LS11<br>100 mmol | LS101<br>90 mmol | --- | --- | 89 % |
| IrP2 | Ir(L1-Br)<br>10 mmol | LS11<br>100 mmol | LS105<br>95 mmol | --- | --- | 94 % |
| IrP3 | Ir(L1-Br)<br>2 mmol | LS11<br>100 mmol | LS106<br>99 mmol | --- | --- | 90 % |
| IrP4 | Ir(L1-Br)<br>10 mmol | S32<br>100 mmol | LS106<br>50 mmol | LS109<br>45 mmol | --- | 95 % |
| IrP5 | Ir(L1-Br)<br>20 mmol | LS11<br>70 mmol | LS202<br>30 mmol | LS101<br>45 mmol | LS107<br>45 mmol | 96 % |
| IrP6 | Ir(L2-Br)<br>1 mmol | LS11<br>100 mmol | LS106<br>99 mmol | --- | --- | 88 % |
| IrP7 | Ir(L2-Br)<br>6 mmol | LS208<br>100 mmol | LS10<br>97 mmol | --- | --- | 90 % |
| IrP8 | S210<br>10 mmol | LS11<br>95 mmol | LS101<br>95 mmol | MS9<br>10 mmol | --- | 92 % |
| IrP9 | MS9<br>20 mmol | LS11<br>100 mmol | LS113<br>90 mmol | --- | --- | 92 % |

**Stereochemie**

Üblicherweise werden die einkerigen Komplex-Synthesebausteine als Racemat der Δ- und Λ-Isomeren eingesetzt. Dies führt in mehrkernigen erfindungsgemäßen Verbindungen zu Diastereomerengemischen, z. B. für zweikernige Verbindungen zu Δ,Δ-/Λ,Λ- und (meso)Δ,Λ-Formen. Diese werden, sofern nicht anders vermerkt, als Diastereomerengemisch weiter um- bzw. eingesetzt. Daneben besteht die Möglichkeit, diese durch chromatographische Methoden oder durch fraktionierte Kristallisation zu trennen.

**Beispiel: Herstellung der OLEDs**

**1) Vakuum-prozessierte Devices:**

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-Zinn-Oxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 5 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M3:M2:Ir(L2) (55%:35%:10%) bedeutet hierbei, dass das Material M3 in einem Volumenanteil von 55%, M2 in einem Volumenanteil von 35% und Ir(L2) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/$m^2$ in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z. B. 1000 cd/$m^2$ auf 500 cd/$m^2$. Je nach Emissionsfarbe werden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/$m^2$ eine übliche Angabe.

**Verwendung von erfindungsgemäßen Verbindungen als Emittermaterialien in phosphoreszierenden OLEDs**

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 4 verwendet. Die Ergebnisse der OLEDs sind in Tabelle 2 zusammengefasst.

**Tabelle 1: Aufbau der OLEDs**

| Bsp. | HTL2 Dicke | EBL Dicke | EML Dicke | HBL Dicke | ETL Dicke |
|---|---|---|---|---|---|
| Ref.-D1 | HTM 40 nm | --- | M1:IrPPy (90%:10%) 30 nm | --- | ETM1:ETM2 (50%:50%) 30 nm |
| Ref.-D2 | HTM 40 nm | --- | M1:IrPPy (90%:10%) 30 nm | HBM1 10 nm | ETM1:ETM2 (50%:50%) 30 nm |
| Ref.-D3 | HTM 40 nm | --- | M1:IrPPy (85%:15%) 30 nm | HBM1 10 nm | ETM1:ETM2 (50%:50%) 30 nm |
| D1 | HTM 40 nm | --- | M1:Ir9 (90%:10%) 30 nm | --- | ETM1:ETM2 (50%:50%) 30 nm |
| D2 | HTM 40 nm | --- | M1:Ir9 (90%:10%) 30 nm | HBM1 10 nm | ETM1:ETM2 (50%:50%) 30 nm |
| D3 | HTM 40 nm | --- | M1:Ir9 (85%:15%) 30 nm | HBM1 10 nm | ETM1:ETM2 (50%:50%) 30 nm |
| D4 | HTM 40 nm | --- | M1:M3:Ir9 (60%:30%:10%) 30 nm | HBM1 10 nm | ETM1:ETM2 (50%:50%) 30 nm |
| D5 | HTM 40 nm | --- | M1:M2:Ir13 (60%:30%:10%) 30 nm | HBM1 10 nm | ETM1:ETM2 (50%:50%) 30 nm |

**Tabelle 2: Ergebnisse der Vakuum-prozessierten OLEDs**

| Bsp. | EQE (%) 1000 cd/m2 | Spannung (V) 1000 cd/m2 | CIE x/y 1000 cd/m2 | LD50 (h) 1000 cd/m2 |
|---|---|---|---|---|
| Ref.-D1 | 15.8 | 2.7 | 0.33/062 | 55000 |
| Ref.-D2 | 15.6 | 3.3 | 0.33/062 | 70000 |
| Ref.-D3 | 16.0 | 3.3 | 0.33/062 | 85000 |
| D1 | 20.6 | 2.9 | 0.36/061 | 100000 |
| D2 | 21.5 | 3.4 | 0.36/062 | 105000 |
| D3 | 22.0 | 3.2 | 0.37/060 | 125000 |
| D4 | 21.8 | 3.1 | 0.37/061 | 185000 |
| D5 | 22.3 | 3.3 | 0.36/061 | 175000 |

**Lösungs-prozessierte Devices:**

**A: Aus niedermolekularen löslichen Funktionsmaterialien**

Die erfindungsgemäßen Iridiumkomplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HL-X092 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ 1a enthalten eine Emissionsschicht aus M4:M5:IrL (42%:45%:13%), die vom Typ 1b enthalten eine Emissionsschicht aus M4:M5:IrL (40%:32%:28%), die vom Typ2 enthalten eine Emissionsschicht aus M4:M5:IrLa:IrLb (30%:35%:30%:5%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck 5 x $10^{-6}$ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| Bsp. | Emitter Device | EQE (%) 1000 cd/m2 | Spannung (V) 1000 cd/m2 | CIE x/y | LD50 (h) 1000 cd/m2 |
|---|---|---|---|---|---|
| Sol-Ref-Red1 | IrRef3 Typ1a | 15.0 | 6.2 | 0.61/0.38 | 4000 |
| Sol-Ref-Red2 | IrRef1 IrRef3 Typ2 | 17.3 | 6.4 | 0.61/0.39 | 240000 |

(fortgesetzt)

| Bsp. | Emitter Device | EQE (%) 1000 cd/m2 | Spannung (V) 1000 cd/m2 | CIE x/y | LD50 (h) 1000 cd/m2 |
|---|---|---|---|---|---|
| Sol-RedD1 | IrRef1 Ir17 Typ2 | 19.9 | 6.2 | 0.64/0.35 | 310000 |
| Sol-RedD2 | IrRef1 Ir18 Typ2 | 20.4 | 6.3 | 0.61/0.38 | 160000 |
| Sol-Ref-Green1 | IrRef1 Typ1a | 19.6 | 5.2 | 0.36/0.61 | 190000 |
| Sol-Ref-Green2 | IrRef1 Typ1b | 19.8 | 4.9 | 0.36/0.61 | 210000 |
| Sol-Ref-Green3 | IrRef4 Typ1b | 22.0 | 5.3 | 0.33/0.64 | 310000 |
| Sol-Ref-Green4 | IrRef5 Typ1b | 21.9 | 5.4 | 0.33/0.62 | 340000 |
| Sol-Ref-Green5 | IrRef6 Typ1b | 21.7 | 5.4 | 0.34/0.62 | 320000 |
| Sol-Ref-Green6 | IrRef7 Typ1b | 21.9 | 5.5 | 0.34/0.62 | 300000 |
| Sol-GreenD1 | Ir5 Typ1a | 20.4 | 5.7 | 0.38/0.58 | 170000 |
| Sol-GreenD2 | Ir6 Typ1b | 21.4 | 5.1 | 0.37/0.60 | 270000 |
| Sol-GreenD3 | Ir11 Typ1b | 21.4 | 5.1 | 0.37/0.60 | 190000 |
| Sol-GreenD4 | Ir12 Typ1b | 22.1 | 5.1 | 0.37/0.60 | 250000 |
| Sol-GreenD5 | Ir15 Typ1b | 22.0 | 5.1 | 0.37/0.60 | 260000 |
| Sol-GreenD6 | Ir19 Typ1b | 21.5 | 5.0 | 0.40/0.58 | 300000 |
| Sol-GreenD7 | Ir23 Typ1b | 22.1 | 5.3 | 0.39/0.58 | 180000 |
| Sol-GreenD8 | Ir25 Typ1b | 24.6 | 5.2 | 0.43/0.55 | 290000 |
| Sol-GreenD9 | Ir29 Typ1b | 23.1 | 5.2 | 0.40/0.58 | 270000 |
| Sol-GreenD10 | Pt3 Typ1b | 25.0 | 5.0 | 0.29/0.64 | --- |
| Sol-Green011 | Ir37 Typ1b | 20.3 | 5.3 | 0.37/0.60 | 340000 |
| Sol-GreenD12 | Ir44 Typ1b | 24.3 | 5.2 | 0.37/0.60 | 380000 |

(fortgesetzt)

| Bsp. | Emitter Device | EQE (%) 1000 cd/m2 | Spannung (V) 1000 cd/m2 | CIE x/y | LD50 (h) 1000 cd/m2 |
|---|---|---|---|---|---|
| Sol-GreenD13 | Ir54 Typ1b | 25.2 | 5.2 | 0.37/0.60 | 400000 |
| Sol-GreenD14 | Ir55 Typ1b | 24.0 | 5.4 | 0.38/0.58 | 340000 |
| Sol-GreenD15 | IrP1 Typ1b | 22.9 | 5.5 | 0.37/0.60 | 300000 |
| Sol-GreenD16 | IrP3 Typ1b | 25.1 | 5.6 | 0.37/0.59 | 210000 |
| Sol-GreenD17 | Ir61 Typ1b | 22.3 | 5.3 | 0.39/0.59 | 280000 |
| Sol-GreenD18 | Ir62 Typ1b | 22.8 | 5.3 | 0.34/0.62 | 300000 |
| Sol-GreenD19 | Ir63 Typ1b | 22.9 | 5.4 | 0.34/0.62 | 330000 |
| Sol-GreenD20 | Ir64 Typ1b | 23.4 | 5.2 | 0.34/0.62 | 360000 |
| Sol-GreenD21 | Ir65 Typ1b | 23.6 | 5.1 | 0.34/0.61 | 320000 |

## Tabelle 4: Strukturformeln der verwendeten Materialien

| | |
|---|---|
| 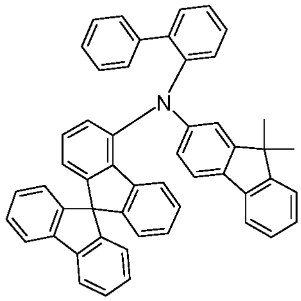<br>HTM = M9<br>1450933-44-4 | 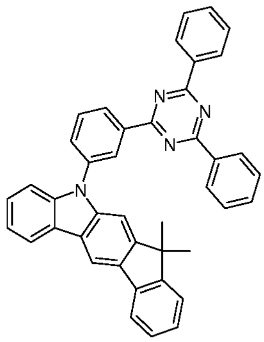<br>M1<br>1257248-13-7 |
| 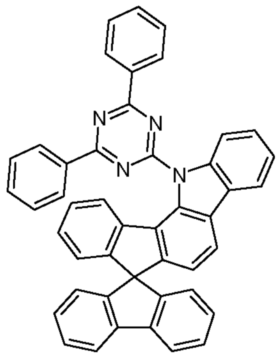<br>M2<br>1615703-29-1 | 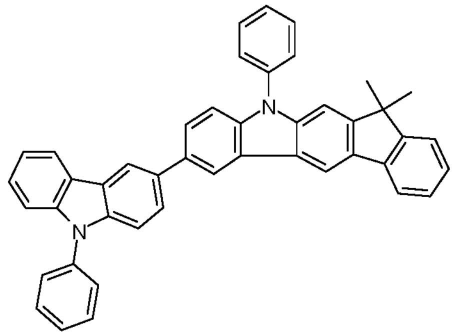<br>M3<br>1357150-54-9 |
| 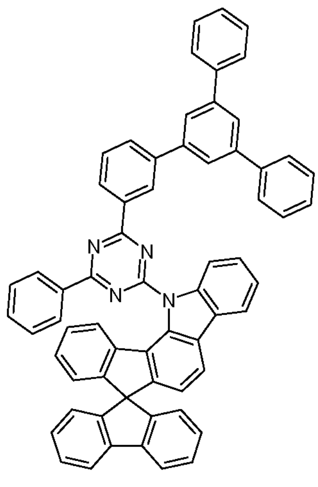<br>M4<br>1616231-60-7 | 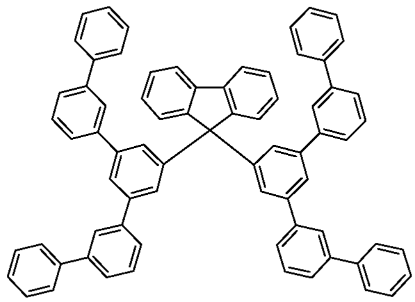<br>M5<br>1246496-85-4 |

| | |
|---|---|
| 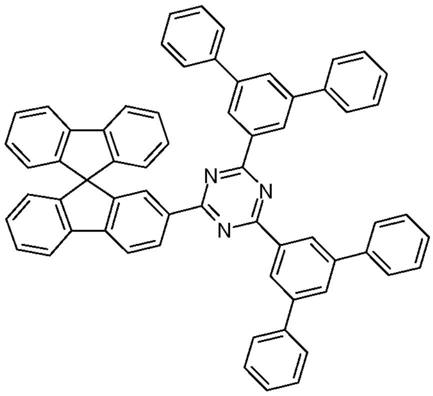<br>ETM1 = HBM1 = M10<br>1233200-52-6 | 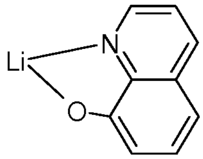<br>ETM2<br>25387-93-3 |
| 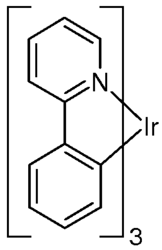<br>IrPPy<br>693794-98-8 | 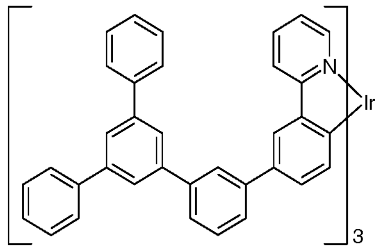<br>IrRef1<br>1269508-30-6 |
| 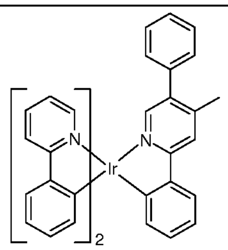<br>IrRef2<br>1215692-34-4 | 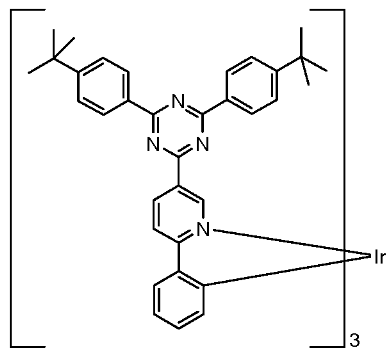<br>IrRef3<br>1202823-72-0 |

**Patentansprüche**

**1.** Verbindung gemäß der Formel (1),

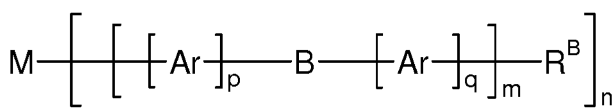

Formel (1)

wobei für die verwendeten Symbole und Indizes gilt:

M ist bei jedem Auftreten gleich oder verschieden ein organometallischer Iridiumkomplex oder ein organometallischer Platinkomplex;
Ar ist bei jedem Auftreten gleich oder verschieden eine linear verknüpfte Arylen- oder Heteroarylengruppe mit 6 bis 30 aromatischen Ringatomen, welche mit einem oder mehreren Resten R substituiert sein kann;
B ist eine Gruppe der folgenden Formel (2),

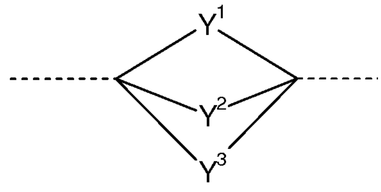

Formel (2)

wobei die gestrichelten Bindungen die Verknüpfungen dieser Gruppe mit Ar bzw. mit $R^B$ andeutet und weiterhin gilt:

$Y^1$, $Y^2$, $Y^3$ ist gleich oder verschieden bei jedem Auftreten $CR_2$, $CR_2$-$CR_2$, $CR_2$-$CR_2$-$CR_2$, $CR_2$-$CR_2$-$CR_2$-$CR_2$, CR=CR oder eine ortho-verknüpfte Phenylengruppe, welche mit einem oder mehreren Resten R substituiert sein kann; dabei können die Gruppen $Y^1$, $Y^2$ und/oder $Y^3$ durch eine Einfachbindung oder über Reste R miteinander verknüpft sein, so dass oligocyclische Gruppen entstehen;
$R^B$ ist bei jedem Auftreten gleich oder verschieden ausgewählt aus M oder H, D, einer geradkettigen Alkylgruppe mit 1 bis 20 C-Atomen oder einer verzweigten oder cyclischen Alkylgruppe mit 3 bis 20 C-Atomen, wobei die Alkylgruppe jeweils mit einem oder mehreren Resten $R^1$ substituiert sein kann, oder einem aromatischen oder heteroaromatischen Ringsystem mit 5 bis 40 aromatischen Ringatomen, das jeweils durch einen oder mehrere Reste $R^1$ substituiert sein kann;
R ist bei jedem Auftreten gleich oder verschieden H, D, F, Cl, Br, I, $N(R^1)_2$, CN, $NO_2$, $OR^1$, $SR^1$, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^1$ substituiert sein kann, wobei eine oder mehrere nicht benachbarte $CH_2$-Gruppen durch $R^1C=CR^1$, C=C, $Si(R^1)_2$, C=O, $NR^1$, O, S oder $CONR^1$ ersetzt sein können, oder ein aromatisches oder heteroaromatisches Ringsystem mit 5 bis 40 aromatischen Ringatomen, das jeweils durch einen oder mehrere Reste $R^1$ substituiert sein kann; dabei können zwei Reste R auch miteinander ein Ringsystem bilden;
$R^1$ ist bei jedem Auftreten gleich oder verschieden H, D, F, Cl, Br, I, $N(R^2)_2$, CN, $NO_2$, $OR^2$, $SR^2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können, oder ein aromatisches oder heteroaromatisches Ringsystem mit 5 bis 40 aromatischen Ringatomen, das jeweils durch einen oder mehrere Reste $R^2$ substituiert sein kann; dabei können zwei oder mehrere Reste $R^1$ miteinander ein Ringsystem bilden;
$R^2$ ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
n ist 1, 2, 3, 4, 5 oder 6;
p ist bei jedem Auftreten gleich oder verschieden 1 bis 100;
q ist bei jedem Auftreten gleich oder verschieden 0 bis 100;
m ist bei jedem Auftreten gleich oder verschieden 1 bis 100.

2. Verbindung nach Anspruch 1, **dadurch gekennzeichnet, dass** die Triplettenergie des Fragments M nicht mehr als 0.1 eV größer ist als die Triplettenergie des Fragments $-[[Ar]_p-B]_m-R^B$ für q = 0 bzw. als des Fragments $-[[Ar]_p-B-[Ar]_p]_m-R^B$ für q = 1 bis 100.

3. Verbindung nach Anspruch 1 oder 2, **dadurch gekennzeichnet, dass** es sich um einen Iridiumkomplex handelt,

der drei bidentate, monoanionische Liganden oder einen tripodalen, hexadentaten, trianionischen Liganden enthält, oder dass es sich um einen Platinkomplex handelt, der zwei bidentate, monoanionische Liganden oder einen tetradentaten, dianionischen Liganden enthält.

**4.** Verbindung nach einem oder mehreren der Ansprüche 1 bis 3, **dadurch gekennzeichnet, dass** M ein Iridiumkomplex mit einem tripodalen, hexadentaten Liganden ist, wobei der tripodale, hexadentate Ligand drei bidentate Teilliganden enthält, die gleich oder verschieden sein können und die an ein Iridiumatom koordinieren und die drei bidentaten Teilliganden über eine Brücke der Formel (3) oder (4) verknüpft sind,

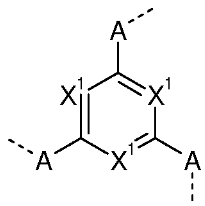

Formel (3)

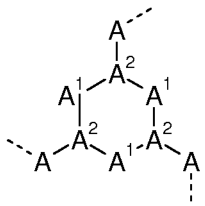

Formel (4)

wobei die gestrichelte Bindung die Bindung der bidentaten Teilliganden an diese Struktur darstellt, R, $R^1$ und $R^2$ die oben genannten Bedeutungen aufweisen und weiterhin gilt:

$X^1$ ist bei jedem Auftreten gleich oder verschieden CR oder N;
$A^1$ ist bei jedem Auftreten gleich oder verschieden $C(R)_2$ oder O;
$A^2$ ist bei jedem Auftreten gleich oder verschieden CR, P(=O), B oder SiR, mit der Maßgabe, dass für $A^2$ = P(=O), B oder SiR das Symbol $A^1$ für O steht und das Symbol A, das an dieses $A^2$ gebunden ist, nicht für -C(=O)-NR'- oder -C(=O)-O- steht;
A ist bei jedem Auftreten gleich oder verschieden -CR=CR-, -C(=O)-NR', -C(=O)-O-, $-CR_2-CR_2-$ oder eine Gruppe der folgenden Formel (5),

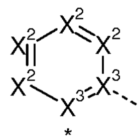

Formel (5)

wobei die gestrichelte Bindung die Position der Bindung der bidentaten Teilliganden an diese Struktur darstellt und * die Position der Verknüpfung der Einheit der Formel (5) mit der zentralen cyclischen Gruppe in Formel (3) bzw. Formel (4) darstellt;
$X^2$ ist bei jedem Auftreten gleich oder verschieden CR oder N oder zwei benachbarte Gruppen $X^2$ stehen zusammen für NR, O oder S, so dass ein Fünfring entsteht, und die verbleibenden $X^2$ stehen gleich oder verschieden bei jedem Auftreten für CR oder N; oder zwei benachbarte Gruppen $X^2$ stehen zusammen für CR oder N, wenn in dem Cyclus eine der Gruppen $X^3$ für N steht, so dass ein Fünfring entsteht; mit der Maßgabe, dass maximal zwei benachbarte Gruppen $X^2$ für N stehen;
$X^3$ ist bei jedem Auftreten C oder eine Gruppe $X^3$ steht für N und die andere Gruppe $X^3$ in demselben Cyclus steht für C; mit der Maßgabe, dass zwei benachbarte Gruppen $X^2$ zusammen für CR oder N stehen, wenn in dem Cyclus eine der Gruppen $X^3$ für N steht;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten $R^1$ substituiert sein kann und wobei eine oder mehrere nicht benachbarte $CH_2$-Gruppen durch $Si(R^1)_2$ ersetzt sein können, oder ein aromatisches oder heteroaromatisches Ringsystem mit 5 bis 40 aromatischen Ringatomen, das jeweils durch einen oder mehrere Reste $R^1$ substituiert sein kann;

dabei können die drei bidentaten Liganden außer durch die Brücke der Formel (3) oder (4) auch noch durch eine weitere Brücke zu einem Kryptat geschlossen sein.

**5.** Verbindung nach Anspruch 4, **dadurch gekennzeichnet, dass** die Gruppe der Formel (3) ausgewählt ist aus den Strukturen der Formeln (6) bis (9) und dass die Gruppe der Formel (4) ausgewählt ist aus den Strukturen der Formeln (10) bis (14),

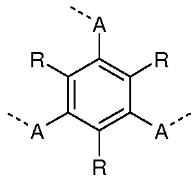
Formel (6)

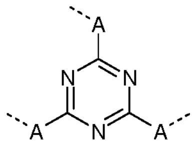
Formel (7)

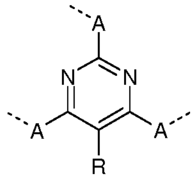
Formel (8)

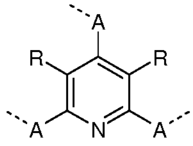
Formel (9)

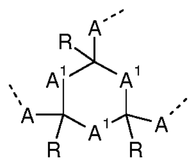
Formel (10)

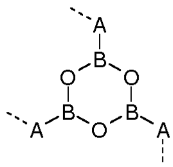
Formel (11)

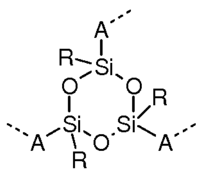
Formel (12)

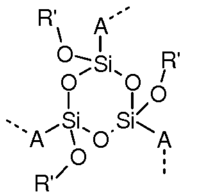
Formel (13)

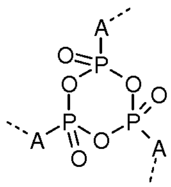
Formel (14)

wobei die Symbole die in Anspruch 1 und 4 genannten Bedeutungen aufweisen.

**6.** Verbindung nach Anspruch 4 oder 5, **dadurch gekennzeichnet, dass** zwei Gruppen A gleich sind und auch gleich substituiert sind und die dritte Gruppe A von den ersten beiden Gruppen A verschieden ist oder dass alle drei Gruppen A gleich sind und auch gleich substituiert sind, wobei A gleich oder verschieden bei jedem Auftreten ausgewählt ist aus der Gruppe bestehend aus -C(=O)-O-, -C(=O)-NR'- oder einer Gruppe gemäß einer der Formeln (15) bis (39),

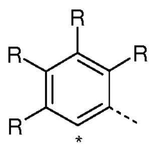
Formel (15)

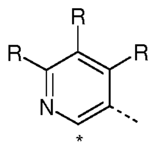
Formel (16)

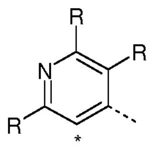
Formel (17)

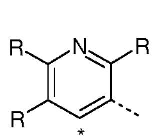
Formel (18)

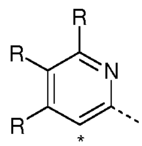
Formel (19)

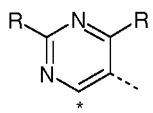
Formel (20)

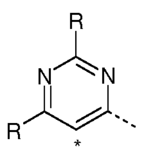
Formel (21)

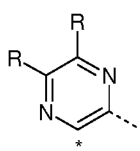
Formel (22)

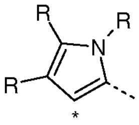
Formel (23)
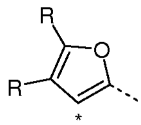
Formel (24)
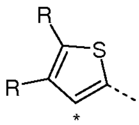
Formel (25)
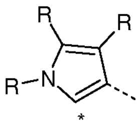
Formel (26)
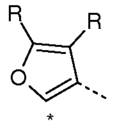
Formel (27)

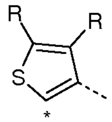
Formel (28)
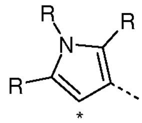
Formel (29)
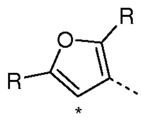
Formel (30)
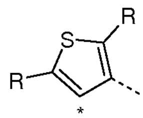
Formel (31)

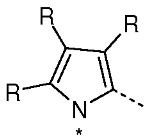
Formel (32)
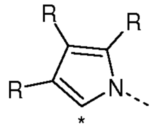
Formel (33)
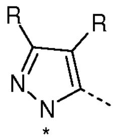
Formel (34)
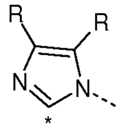
Formel (35)

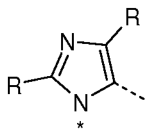
Formel (36)
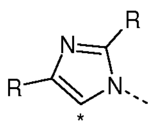
Formel (37)
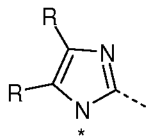
Formel (38)
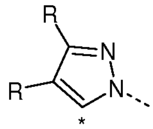
Formel (39)

wobei die Symbole die in Anspruch 1 genannten Bedeutungen aufweisen.

7. Verbindung nach einem oder mehreren der Ansprüche 4 bis 6, **dadurch gekennzeichnet, dass** die bidentaten Teilliganden gleich oder verschieden bei jedem Auftreten ausgewählt sind aus den Strukturen der folgenden Formeln (L-1), (L-2) oder (L-3),

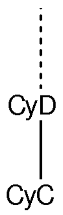
Formel (L-1)
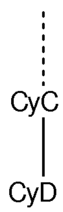
Formel (L-2)
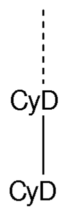
Formel (L-3)

wobei die gestrichelte Bindung die Bindung des Teilliganden an die Brücke der Formeln (3) bzw (4) darstellt und für die weiteren verwendeten Symbole gilt:

CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche jeweils über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;

dabei können mehrere der optionalen Substituenten miteinander ein Ringsystem bilden.

**8.** Verbindung nach einem oder mehreren der Ansprüche 1 bis 3, **dadurch gekennzeichnet, dass** der Komplex M einen Iridiumkomplex darstellt, in dem drei bidentate Liganden, die gleich oder verschieden sein können, an ein Iridiumatom koordinieren, wobei die Gruppe $-[[Ar]_p-B-[Ar]_q]_m-R^B$ an einen der drei bidentaten Liganden bzw. für n > 1 auch an zwei oder drei der bidentaten Liganden bindet und die bidentaten Liganden ausgewählt sind aus den Strukturen gemäß der Formeln (L-1') oder (L-3'),

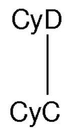

Formel (L-1')

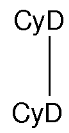

Formel (L-3')

wobei die Symbole die in Anspruch 7 genannten Bedeutungen aufweisen.

**9.** Verbindung nach einem oder mehreren der Ansprüche 1 bis 8, **dadurch gekennzeichnet, dass** Ar bei jedem Auftreten gleich oder verschieden ausgewählt ist aus den Gruppen der Formeln (Ar-1) bis (Ar-10),

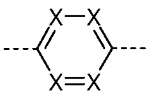

(Ar-1)

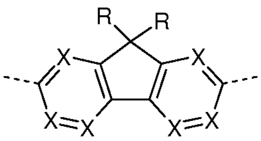

(Ar-2)

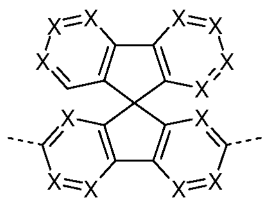

(Ar-3)

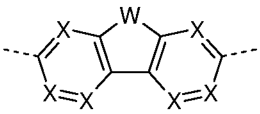

(Ar-4)

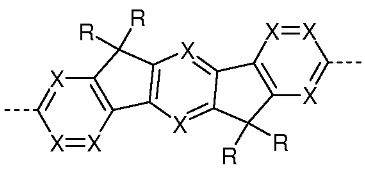

(Ar-5)

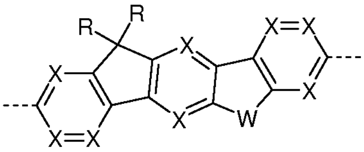

(Ar-6)

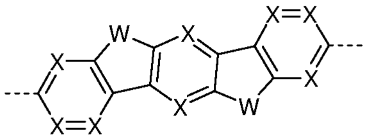

(Ar-7)

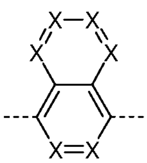

(Ar-8)

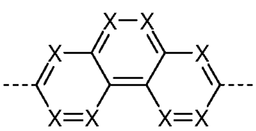

(Ar-9)

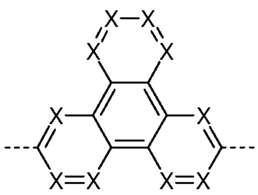

(Ar-10)

wobei die gestrichelten Bindungen die Verknüpfung dieser Gruppe andeuten, X bei jedem Auftreten gleich oder verschieden für CR oder N steht, wobei maximal zwei Symbole X pro Gruppe Ar für N stehen, W bei jedem Auftreten gleich oder verschieden für NR, O oder S steht und R die in Anspruch 1 genannten Bedeutungen aufweist.

**10.** Verbindung nach einem oder mehreren der Ansprüche 1 bis 9, **dadurch gekennzeichnet, dass** die Gruppen $Y^1$, $Y^2$ und $Y^3$ gleich sind und für $CH_2$, $CH_2$-$CH_2$, $CH_2$-$CH_2$-$CH_2$, $CH_2$-$CH_2$-$CH_2$-$CH_2$ oder für eine unsubstituierte ortho-Phenylengruppe stehen.

**11.** Verbindung nach einem oder mehreren der Ansprüche 1 bis 10, **dadurch gekennzeichnet, dass** die Gruppen der Formel (2) ausgewählt sind aus den Strukturen (B-1) bis (B-6),

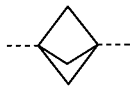
(B-1)

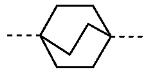
(B-2)

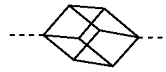
(B-3)

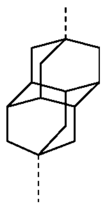
(B-4)

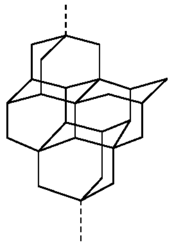
(B-5)

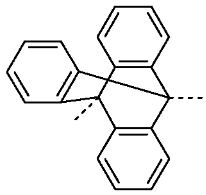
(B-6)

wobei die gestrichelte Bindung jeweils die Verknüpfung dieser Gruppe darstellt.

**12.** Verbindung nach einem oder mehreren der Ansprüche 1 bis 11, **dadurch gekennzeichnet, dass** $R^B$ ausgewählt ist aus H, M, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils mit einem oder mehreren Resten $R^1$ substituiert sein kann, bevorzugt aber unsubstituiert ist, oder einem aromatischen oder heteroaromatischen Ringsystem mit 6 bis 24 aromatischen Ringatomen, das jeweils durch einen oder mehrere Reste $R^1$ substituiert sein kann.

**13.** Oligomer, Polymer oder Dendrimer enthaltend eine oder mehrere der Verbindungen nach einem oder mehreren der Ansprüche 1 bis 12, wobei ein oder mehrere Bindungen der Verbindung zum Polymer, Oligomer oder Dendrimer vorhanden sind.

**14.** Formulierung, enthaltend mindestens eine Verbindung nach einem oder mehreren der Ansprüche 1 bis 12 oder ein Oligomer, Polymer oder Dendrimer nach Anspruch 13 und mindestens eine weitere Verbindung.

**15.** Verwendung einer Verbindung nach einem oder mehreren der Ansprüche 1 bis 12 oder eines Oligomers, Polymers oder Dendrimers nach Anspruch 13 in einer elektronischen Vorrichtung oder als Sauerstoff-Sensibilisator oder in der Photokatalyse.

**16.** Elektronische Vorrichtung, bevorzugt ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren oder organischen Laserdioden, enthaltend mindestens eine Verbindung nach einem oder mehreren der Ansprüche 1 bis 12 oder mindestens ein Oligomer, Polymer oder Dendrimer nach Anspruch 13.

**17.** Elektronische Vorrichtung nach Anspruch 16, wobei es sich um eine organische Elektrolumineszenzvorrichtung handelt, **dadurch gekennzeichnet, dass** die Verbindung nach einem oder mehreren der Ansprüche 1 bis 12 als emittierende Verbindung in einer oder mehreren emittierenden Schichten eingesetzt wird.

## Claims

**1.** Compound of the formula (1)

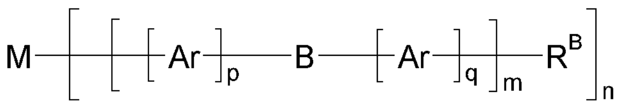

Formula (1)

where the symbols and indices used are as follows:

M is the same or different at each instance and is an organometallic iridium complex or an organometallic platinum complex;

Ar is the same or different at each instance and is a linear-bonded arylene or heteroarylene group which has 6 to 30 aromatic ring atoms and may be substituted by one or more R radicals;

B is a group of the following formula (2):

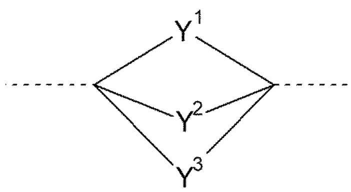

**Formula** (2)

where the dotted bonds indicate the linkages of this group to Ar or to $R^B$ and, in addition:

$Y^1$, $Y^2$, $Y^3$ is the same or different at each instance and is $CR_2$, $CR_2$-$CR_2$, $CR_2$-$CR_2$-$CR_2$, $CR_2$-$CR_2$-$CR_2$-$CR_2$, CR=CR or an ortho-bonded phenylene group which may be substituted by one or more R radicals; at the same time, the $Y^1$, $Y^2$ and/or $Y^3$ groups may be joined to one another by a single bond or via R radicals, so as to form oligocyclic groups;

$R^B$ is the same or different at each instance and is selected from M or H, D, a straight-chain alkyl group having 1 to 20 carbon atoms or a branched or cyclic alkyl group having 3 to 20 carbon atoms, where the alkyl group may be substituted in each case by one or more $R^1$ radicals, or an aromatic or heteroaromatic ring system which has 5 to 40 aromatic ring atoms and may be substituted in each case by one or more $R^1$ radicals;

R is the same or different at each instance and is H, D, F, Cl, Br, I, $N(R^1)_2$, CN, $NO_2$, $OR^1$, $SR^1$, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, a straight-chain alkyl group having 1 to 20 carbon atoms or a branched or cyclic alkyl group having 3 to 20 carbon atoms, where the alkyl group may be substituted in each case by one or more $R^1$ radicals, where one or more nonadjacent $CH_2$ groups may be replaced by $R^1C=CR^1$, C≡C, $Si(R^1)_2$, C=O, $NR^1$, O, S or $CONR^1$, or an aromatic or heteroaromatic ring system which has 5 to 40 aromatic ring atoms and may be substituted in each case by one or more $R^1$ radicals; at the same time, two R radicals together may also form a ring system;

$R^1$ is the same or different at each instance and is H, D, F, Cl, Br, I, $N(R^2)_2$, CN, $NO_2$, $OR^2$, $SR^2$, $Si(R^2)_3$, $B(OR^2)_2$, $C(=O)R^2$, $P(=O)(R^2)_2$, $S(=O)R^2$, $S(=O)_2R^2$, $OSO_2R^2$, a straight-chain alkyl group having 1 to 20 carbon atoms or a branched or cyclic alkyl group having 3 to 20 carbon atoms, where the alkyl group may be substituted in each case by one or more $R^2$ radicals, where one or more nonadjacent $CH_2$ groups may be replaced by $R^2C=CR^2$, C≡C, $Si(R^2)_2$, C=O, $NR^2$, O, S or $CONR^2$, or an aromatic or heteroaromatic ring system which has 5 to 40 aromatic ring atoms and may be substituted in each case by one or more $R^2$ radicals; at the same time, two or more $R^1$ radicals together may form a ring system;

$R^2$ is the same or different at each instance and is H, D, F or an aliphatic, aromatic or heteroaromatic organic radical, especially a hydrocarbyl radical, having 1 to 20 carbon atoms, in which one or more hydrogen atoms may also be replaced by F;

n is 1, 2, 3, 4, 5 or 6;
p is the same or different at each instance and is 1 to 100;
q is the same or different at each instance and is 0 to 100;
m is the same or different at each instance and is 1 to 100.

**2.** Compound according to Claim 1, **characterized in that** the triplet energy of the fragment M is not more than 0.1 eV greater than the triplet energy of the fragment $-[[Ar]_p-B]_m-R^B$ when q = 0 or than that of the fragment $-[[Ar]_p-B-[Ar]_p]_m-R^B$ when q = 1 to 100.

**3.** Compound according to Claim 1 or 2, **characterized in that** the complex is an iridium complex containing three bidentate, monoanionic ligands or one tripodal, hexadentate, trianionic ligand, or **in that** it is a platinum complex containing two bidentate, monoanionic ligands or one tetradentate, dianionic ligand.

**4.** Compound according to one or more of Claims 1 to 3, **characterized in that** M is an iridium complex having a tripodal, hexadentate ligand, where the tripodal, hexadentate ligand contains three bidentate sub-ligands which may be the same or different, and coordinate to an iridium atom and the three bidentate sub-ligands are joined via a bridge of the formula (3) or (4):

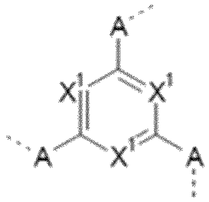

Formula (3)

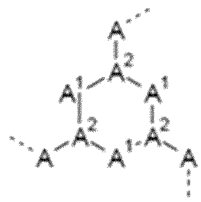

Formula (4)

where the dotted bond represents the bond of the bidentate sub-ligands to this structure, R, $R^1$ and $R^2$ have the definitions given above and, in addition:

$X^1$ is the same or different at each instance and is CR or N;
$A^1$ is the same or different at each instance and is $C(R)_2$ or O;
$A^2$ is the same or different at each instance and is CR, P(=O), B or SiR, with the proviso that, when $A^2$ = P(=O), B or SiR, the symbol $A^1$ is O and the symbol A bonded to this $A^2$ is not -C(=O)-NR'- or -C(=O)-O-;
A is the same or different at each instance and is -CR=CR-, -C(=O)-NR'-, -C(=O)-O-, $-CR_2-CR_2-$ or a group of the following formula (5):

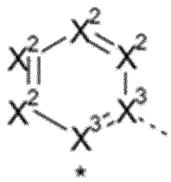

Formula (5)

where the dotted bond represents the position of the bond of the bidentate sub-ligands to this structure and * represents the position of the linkage of the unit of the formula (5) to the central cyclic group in formula (3) or formula (4);
$X^2$ is the same or different at each instance and is CR or N or two adjacent $X^2$ groups together are NR, O or S, thus forming a five-membered ring, and the remaining $X^2$ are the same or different at each instance and are CR or N; or two adjacent $X^2$ groups together are CR or N when one of the $X^3$ groups in the cycle is N, thus forming a five-membered ring; with the proviso that not more than two adjacent $X^2$ groups are N;
$X^3$ is C at each instance or one $X^3$ group is N and the other $X^3$ group in the same cycle is C; with the proviso that two adjacent $X^2$ groups together are CR or N when one of the $X^3$ groups in the cycle is N;
R' is the same or different at each instance and is H, D, a straight-chain alkyl group having 1 to 20 carbon atoms or a branched or cyclic alkyl group having 3 to 20 carbon atoms, where the alkyl group in each case may be substituted by one or more $R^1$ radicals and where one or more nonadjacent $CH_2$ groups may be replaced by $Si(R^1)_2$, or an aromatic or heteroaromatic ring system which has 5 to 40 aromatic ring atoms and may be substituted in each case by one or more $R^1$ radicals;

at the same time, the three bidentate ligands, apart from by the bridge of the formula (3) or (4), may also be closed

by a further bridge to form a cryptate.

**5.** Compound according to Claim 4, **characterized in that** the group of the formula (3) is selected from the structures of the formulae (6) to (9) and **in that** the group of the formula (4) is selected from the structures of the formulae (10) to (14)

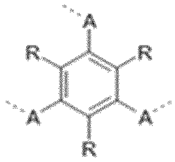
Formula (6)

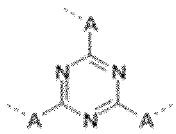
Formula (7)

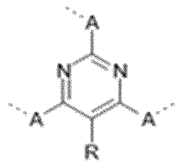
Formula (8)

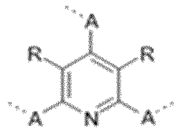
Formula (9)

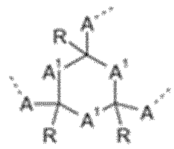
Formula (10)

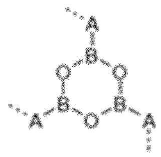
Formula (11)

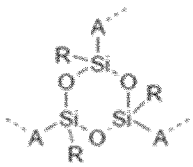
Formula (12)

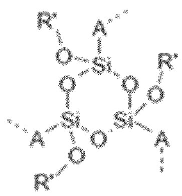
Formula (13)

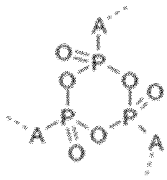
Formula (14)

where the symbols have the definitions given in Claim 1 and 4.

**6.** Compound according to Claim 4 or 5, **characterized in that** two A groups are the same and also have the same substitution and the third A group is different from the first two A groups, or **in that** all three A groups are the same and also have the same substitution, where A is the same or different at each instance and is selected from the group consisting of -C(=O)-O-, -C(=O)-NR'- or a group of one of the formulae (15) to (39)

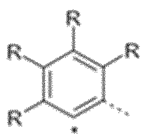
Formula (15)

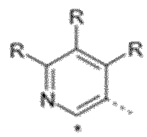
Formula (16)

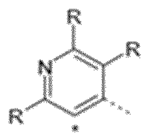
Formula (17)

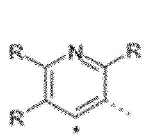
Formula (18)

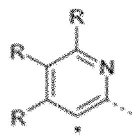
Formula (19)

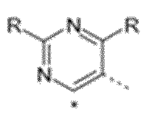
Formula (20)

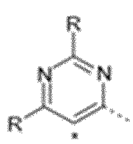
Formula (21)

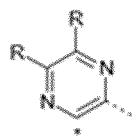
Formula (22)

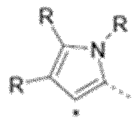
Formula (23)

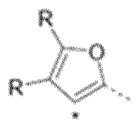
Formula (24)

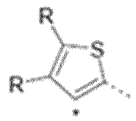
Formula (25)

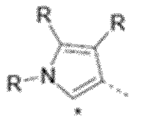
Formula (26)

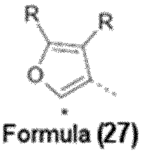
Formula (27)

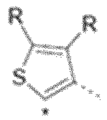
Formula (28)

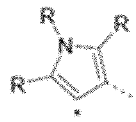
Formula (29)

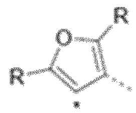
Formula (30)

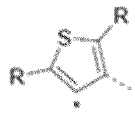
Formula (31)

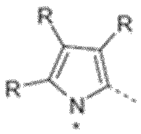
Formula (32)

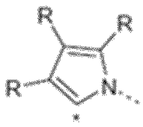
Formula (33)

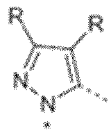
Formula (34)

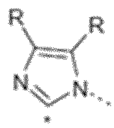
Formula (35)

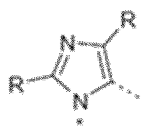
Formula (36)

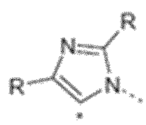
Formula (37)

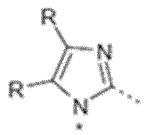
Formula (38)

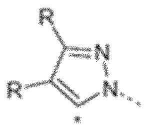
Formula (39)

where the symbols have the definitions given in Claim 1.

**7.** Compound according to one or more of Claims 4 to 6, **characterized in that** the bidentate sub-ligands are the same or different at each instance and are selected from the structures of the following formulae (L-1), (L-2) and (L-3) :

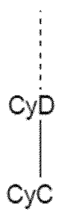
Formula (L-1)

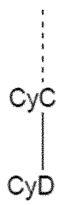
Formula (L-2)

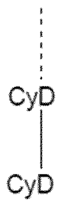
Formula (L-3)

where the dotted bond represents the bond of the sub-ligand to the bridge of the formula (3) or (4) and the other symbols used are as follows:

CyC is the same or different at each instance and is a substituted or unsubstituted aryl or heteroaryl group which has 5 to 14 aromatic ring atoms, each of which coordinates to the metal via a carbon atom and which is bonded in each case to CyD via a covalent bond;
CyD is the same or different at each instance and is a substituted or unsubstituted heteroaryl group which has 5 to 14 aromatic ring atoms and coordinates to the metal via a nitrogen atom or via a carbene carbon atom and which is bonded to CyC via a covalent bond;

at the same time, two or more of the optional substituents together may form a ring system.

**8.** Compound according to one or more of Claims 1 to 3, **characterized in that** the complex M is an iridium complex in which three bidentate ligands which may be the same or different coordinate to one iridium atom, where the -$[[Ar]_p$-B-$[Ar]_q]_m$-$R^B$ group binds to one of the three bidentate ligands or, when n > 1, also binds to two or three of the bidentate ligands, and the bidentate ligands are selected from the structures of the formulae (L-1') and (L-3')

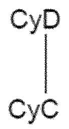

Formula (L-1')

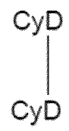

Formula (L-3')

where the symbols have the definitions given in Claim 7.

**9.** Compound according to one or more of Claims 1 to 8, **characterized in that** Ar is the same or different at each instance and is selected from the groups of the formulae (Ar-1) to (Ar 10)

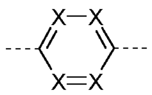

(Ar-1)

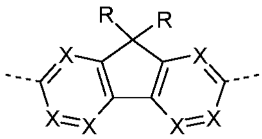

(Ar-2)

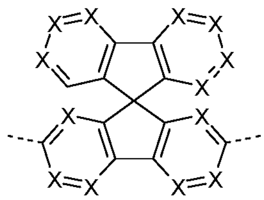

(Ar-3)

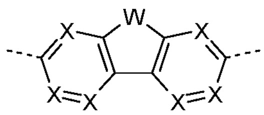

(Ar-4)

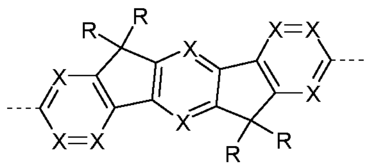

(Ar-5)

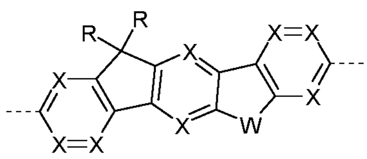

(Ar-6)

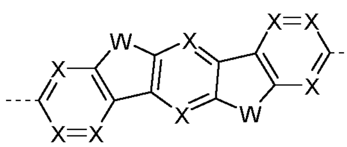

(Ar-7)

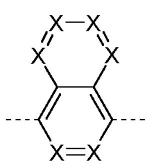

(Ar-8)

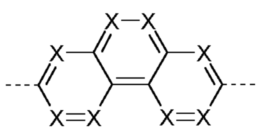

(Ar-9)

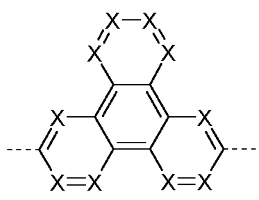

(Ar-10)

where the dotted bonds indicate the linkage of this group, X is the same or different at each instance and is CR or N, where not more than two X per Ar group are N, W is the same or different at each instance and is NR, O or S, and R has the definitions given in Claim 1.

**10.** Compound according to one or more of Claims 1 to 9, **characterized in that** the $Y^1$, $Y^2$ and $Y^3$ groups are the same

and are $CH_2$, $CH_2$-$CH_2$, $CH_2$-$CH_2$-$CH_2$, $CH_2$-$CH_2$-$CH_2$-$CH_2$ or an unsubstituted ortho-phenylene group.

**11.** Compound according to one or more of Claims 1 to 10, **characterized in that** the groups of the formula (2) are selected from the structures (B-1) to (B-6)

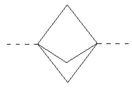

(B-1)

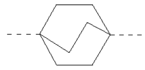

(B-2)

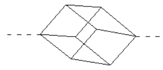

(B-3)

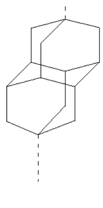

(B-4)

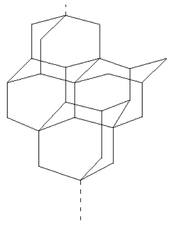

(B-5)

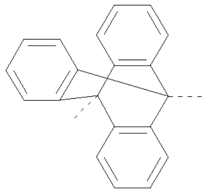

(B-6)

where the dotted bond in each case represents the linkage of this group.

**12.** Compound according to one or more of Claims 1 to 11, **characterized in that** $R^B$ is selected from H, M, a straight-chain alkyl group having 1 to 10 carbon atoms or a branched or cyclic alkyl group having 3 to 10 carbon atoms, where the alkyl group may be substituted in each case by one or more $R^1$ radicals, but is preferably unsubstituted, or an aromatic or heteroaromatic ring system which has 6 to 24 aromatic ring atoms and may be substituted in each case by one or more $R^1$ radicals.

**13.** Oligomer, polymer or dendrimer containing one or more of the compounds according to one or more of Claims 1 to 12, wherein one or more bonds of the compound to the polymer, oligomer or dendrimer are present.

**14.** Formulation comprising at least one compound according to one or more of Claims 1 to 12 or an oligomer, polymer or dendrimer according to Claim 13 and at least one further compound.

**15.** Use of a compound according to one or more of Claims 1 to 12 or of an oligomer, polymer or dendrimer according to Claim 13 in an electronic device or as oxygen sensitizer or in photocatalysis.

**16.** Electronic device, preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells, oxygen sensors and organic laser diodes, comprising at least one compound according to one or more of Claims 1 to 12 or at least one oligomer, polymer or dendrimer according to Claim 13.

**17.** Electronic device according to Claim 16 which is an organic electroluminescent device, **characterized in that** the compound according to one or more of Claims 1 to 12 is used as emitting compound in one or more emitting layers.

### Revendications

**1.** Composé selon la formule (1),

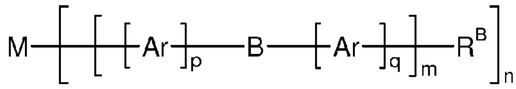

Formule (1)

dans laquelle les symboles et les indices utilisés ont les significations suivantes :

M représente à chaque occurrence, de manière identique ou différente, un complexe d'iridium organométallique ou un complexe de platine organométallique ;

les Ar représentent à chaque occurrence, de manière identique ou différente, un groupe arylène ou hétéroarylène relié linéairement de 6 à 30 atomes de cycle aromatique, qui peut être substitué avec un ou plusieurs radicaux R ;

B représente un groupe de la formule (2) suivante,

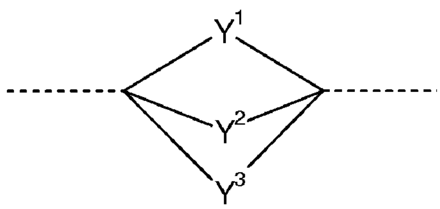

Formule (2)

dans laquelle les liaisons en pointillés indiquent les liaisons de ce groupe avec Ar ou avec $R^B$, et en outre : $Y^1$, $Y^2$, $Y^3$ représentent de manière identique ou différente à chaque occurrence $CR_2$, $CR_2$-$CR_2$, $CR_2$-$CR_2$-$CR_2$, $CR_2$-$CR_2$-$CR_2$-$CR_2$, CR=CR ou un groupe phénylène relié en ortho, qui peut être substitué avec un ou plusieurs radicaux R ;

les groupes $Y^1$, $Y^2$ et/ou $Y^3$ pouvant être reliés les uns avec les autres par une simple liaison ou par des radicaux R, de manière à former des groupes oligocycliques ;

les $R^B$ sont choisis à chaque occurrence de manière identique ou différente parmi M ou H, D, un groupe alkyle linéaire de 1 à 20 atomes C ou un groupe alkyle ramifié ou cyclique de 3 à 20 atomes C, le groupe alkyle pouvant à chaque fois être substitué avec un ou plusieurs radicaux $R^1$, ou un système cyclique aromatique ou hétéroaromatique de 5 à 40 atomes de cycle aromatique, qui peut à chaque fois être substitué par un ou plusieurs radicaux $R^1$ ;

les R représentent à chaque occurrence, de manière identique ou différente, H, D, F, Cl, Br, I, $N(R^1)_2$, CN, $NO_2$, $OR^1$, $SR^1$, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, un groupe alkyle linéaire de 1 à 20 atomes C, ou un groupe alkyle ramifié ou cyclique de 3 à 20 atomes C, le groupe alkyle pouvant à chaque fois être substitué avec un ou plusieurs radicaux $R^1$, un ou plusieurs groupes $CH_2$ non voisins pouvant être remplacés par $R^1C{=}CR^1$, C=C, $Si(R^1)_2$, C=O, $NR^1$, O, S ou $CONR^1$, ou un système cyclique aromatique ou hétéroaromatique de 5 à 40 atomes de cycle aromatique, qui peut à chaque fois être substitué par un ou plusieurs radicaux $R^1$ ; deux radicaux R pouvant également former l'un avec l'autre un système cyclique ;

les $R^1$ représentent à chaque occurrence, de manière identique ou différente, H, D, F, Cl, Br, I, $N(R^2)_2$, CN, $NO_2$, $OR^2$, $SR^2$, $Si(R^2)_3$, $B(OR^2)_2$, $C(=O)R^2$, $P(=O)(R^2)_2$, $S(=O)R^2$, $S(=O)_2R^2$, $OSO_2R^2$, un groupe alkyle linéaire de 1 à 20 atomes C, ou un groupe alkyle ramifié ou cyclique de 3 à 20 atomes C, le groupe alkyle pouvant à chaque fois être substitué avec un ou plusieurs radicaux $R^2$, un ou plusieurs groupes $CH_2$ non voisins pouvant être remplacés par $R^2C{=}CR^2$, C=C, $Si(R^2)_2$, C=O, $NR^2$, O, S ou $CONR^2$, ou un système cyclique aromatique ou hétéroaromatique de 5 à 40 atomes de cycle aromatique, qui peut à chaque fois être substitué par un ou plusieurs radicaux $R^2$ ; deux ou davantage de radicaux $R^1$ pouvant également former les uns avec les autres un système cyclique ;

les $R^2$ représentent à chaque occurrence, de manière identique ou différente, H, D, F ou un radical organique aliphatique, aromatique ou hétéroaromatique, notamment un radical hydrocarboné de 1 à 20 atomes C, dans lequel un ou plusieurs atomes H peuvent également être remplacés par F ;

n représente 1, 2, 3, 4, 5 ou 6 ;

les p représentent à chaque occurrence, de manière identique ou différente, 1 à 100 ;
les q représentent à chaque occurrence, de manière identique ou différente, 0 à 100 ;
les m représentent à chaque occurrence, de manière identique ou différente, 1 à 100.

2. Composé selon la revendication 1, **caractérisé en ce que** l'énergie triplet du fragment M n'est pas plus de 0,1 eV supérieure à l'énergie triplet du fragment-$[[Ar]_p\text{-}B]_m\text{-}R^B$ pour q = 0 ou du fragment -$[[Ar]_p\text{-}B\text{-}[Ar]_p]_m\text{-}R^B$ pour q = 1 à 100.

3. Composé selon la revendication 1 ou 2, **caractérisé en ce qu'**il s'agit d'un complexe d'iridium, qui contient trois ligands bidentates monoanioniques ou un ligand tripodal hexadentate trianionique, ou **en ce qu'**il s'agit d'un complexe de platine, qui contient deux ligands bidentates monoanioniques ou un ligand tétradentate dianionique.

4. Composé selon une ou plusieurs des revendications 1 à 3, **caractérisé en ce que** M est un complexe d'iridium contenant un ligand tripodal hexadentate, le ligand tripodal hexadentate contenant trois ligands partiels bidentates, qui peuvent être identiques ou différents, et qui sont coordonnés à un atome d'iridium, les trois ligands partiels bidentates étant reliés par un pont de la formule (3) ou (4),

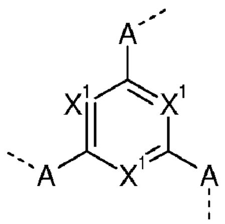

Formule (3)

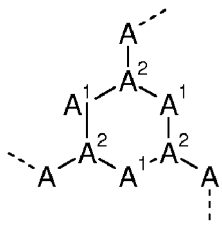

Formule (4)

dans lesquelles la liaison en pointillés représente la liaison des ligands partiels bidentates à cette structure, R, $R^1$ et $R^2$ ont les significations indiquées précédemment, et par ailleurs :

les $X^1$ représentent à chaque occurrence, de manière identique ou différente, CR ou N ;
les $A^1$ représentent à chaque occurrence, de manière identique ou différente, $C(R)_2$ ou O ;
les $A^2$ représentent à chaque occurrence, de manière identique ou différente CR, P(=O), B ou SiR, à condition que pour $A^2$ = P(=O), B ou SiR, le symbole $A^1$ représente O et le symbole A, qui est relié à cet $A^2$, ne représente pas -C(=O)-NR' ou -C(=O)-O- ;
les A représentent à chaque occurrence, de manière identique ou différente, -CR=CR-, -C(=O)-NR'-, -C(=O)-O-, $-CR_2\text{-}CR_2\text{-}$ ou un groupe de la formule (5) suivante,

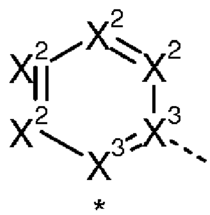

Formule (5)

dans laquelle la liaison en pointillés représente la position de la liaison des ligands partiels bidentates à cette structure, et * représente la position de la liaison de l'unité de la formule (5) avec le groupe cyclique central dans la formule (3) ou la formule (4) ;
les $X^2$ représentent à chaque occurrence, de manière identique ou différente, CR ou N, ou deux groupes $X^2$ voisins représentent ensemble NR, O ou S, de manière à former un cycle à cinq chaînons, et les $X^2$ restants représentent de manière identique ou différente à chaque occurrence CR ou N ; ou deux groupes $X^2$ voisins représentent ensemble CR ou N lorsqu'un des groupes $X^3$ dans le cycle représente N, de manière à former un cycle à cinq chaînons ; à condition qu'au plus deux groupes $X^2$ voisins représentent N ;

les $X^3$ représentent à chaque occurrence C ou un groupe $X^3$ représente N et l'autre groupe $X^3$ dans le même cycle représente C ; à condition que deux groupes $X^2$ voisins représentent ensemble CR ou N lorsqu'un des groupes $X^3$ dans le cycle représente N ;
les R' représentent à chaque occurrence, de manière identique ou différente, H, D, un groupe alkyle linéaire de 1 à 20 atomes C ou un groupe alkyle ramifié ou cyclique de 3 à 20 atomes C, le groupe alkyle pouvant à chaque fois être substitué avec un ou plusieurs radicaux $R^1$, et un ou plusieurs groupes $CH_2$ non voisins pouvant être remplacés par $Si(R^1)_2$, ou un système cyclique aromatique ou hétéroaromatique de 5 à 40 atomes de cycle aromatique, qui peut à chaque fois être substitué par un ou plusieurs radicaux $R^1$ ;
les trois ligands bidentates pouvant en plus du pont de la formule (3) ou (4) également être fermés par un pont supplémentaire en un cryptant.

**5.** Composé selon la revendication 4, **caractérisé en ce que** le groupe de la formule (3) est choisi parmi les structures des formules (6) à (9) et **en ce que** le groupe de la formule (4) est choisi parmi les structures des formules (10) à (14),

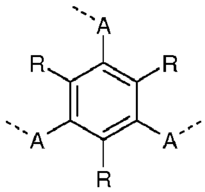
Formule (6)

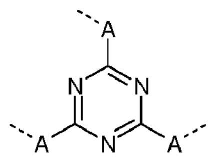
Formule (7)

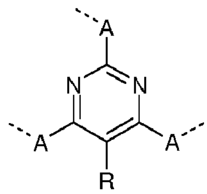
Formule (8)

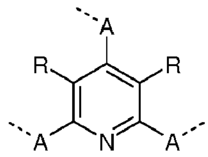
Formule (9)

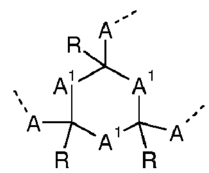
Formule (10)

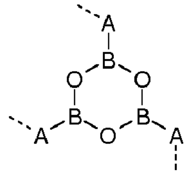
Formule (11)

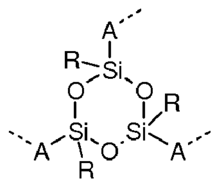
Formule (12)

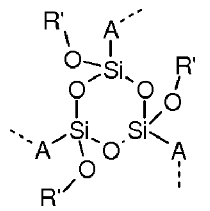
Formule (13)

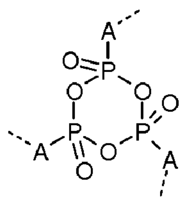
Formule (14)

dans lesquelles les symboles ont les significations indiquées dans les revendications 1 et 4.

**6.** Composé selon la revendication 4 ou 5, **caractérisé en ce que** deux groupes A sont identiques et sont également substitués de manière identique, et le troisième groupe A est différent des deux premiers groupes A, ou **en ce que** les trois groupes A sont identiques et sont également substitués de manière identique, A étant choisi de manière identique ou différente à chaque occurrence dans le groupe constitué par -C(=O)-O-, -C(=O)-NR'- ou un groupe selon l'une quelconque des formules (15) à (39),

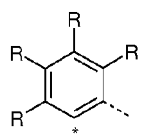
Formule (15)

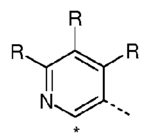
Formule (16)

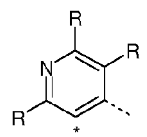
Formule (17)

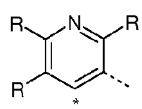
Formule (18)

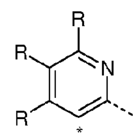
Formule (19)

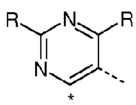
Formule (20)

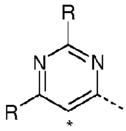
Formule (21)

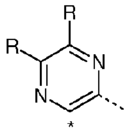
Formule (22)

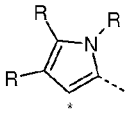
Formule (23)

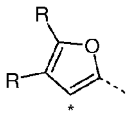
Formule (24)

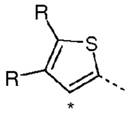
Formule (25)

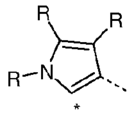
Formule (26)

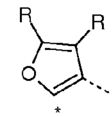
Formule (27)

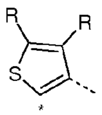
Formule (28)

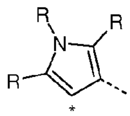
Formule (29)

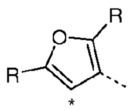
Formule (30)

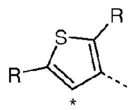
Formule (31)

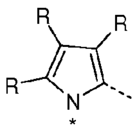
Formule (32)

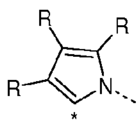
Formule (33)

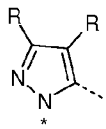
Formule (34)

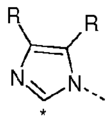
Formule (35)

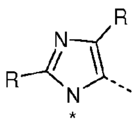
Formule (36)

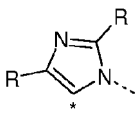
Formule (37)

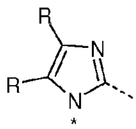
Formule (38)

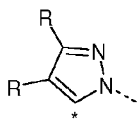
Formule (39)

dans lesquelles les symboles ont les significations indiquées dans la revendication 1.

**7.** Composé selon une ou plusieurs des revendications 4 à 6, **caractérisé en ce que** les ligands partiels bidentates sont choisis de manière identique ou différente à chaque occurrence parmi les structures des formules (L-1), (L-2) ou (L-3) suivantes,

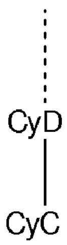
Formule (L-1)

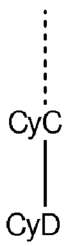
Formule (L-2)

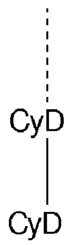
Formule (L-3)

dans lesquelles la liaison en pointillés représente la liaison du ligand partiel au pont de la formule (3) ou (4) et, les autres symboles utilisés ont les significations suivantes :

les CyC représentent de manière identique ou différente à chaque occurrence un groupe aryle ou hétéroaryle

substitué ou non substitué de 5 à 14 atomes de cycle aromatique, qui est à chaque fois coordonné par un atome de carbone au métal et qui est à chaque fois relié par une liaison covalante avec CyD ;
les CyD représentent de manière identique ou différente à chaque occurrence un groupe hétéroaryle substitué ou non substitué de 5 à 14 atomes de cycle aromatique, qui est coordonné par un atome d'azote ou par un atome de carbone de carbène au métal, et qui est relié par une liaison covalente avec CyC ;
plusieurs des substituants optionnels pouvant former les uns avec les autres un système cyclique.

**8.** Composé selon une ou plusieurs des revendications 1 à 3, **caractérisé en ce que** le complexe M est un complexe d'iridium, dans lequel trois ligands bidentates, qui peuvent être identiques ou différents, sont coordonnés à un atome d'iridium, le groupe $-[[Ar]_p-B-[Ar]_q]_m-R^B$ étant relié à un des trois ligands bidentates ou, pour n > 1, également à deux ou trois des ligands bidentates, et les ligands bidentates étant choisis parmi les structures selon les formules (L-1') ou (L-3'),

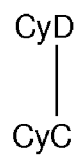

Formule (L-1')

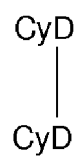

Formule (L-3')

dans lesquelles les symboles ont les significations indiquées dans la revendication 7.

**9.** Composé selon une ou plusieurs des revendications 1 à 8, **caractérisé en ce qu'**Ar est choisi à chaque occurrence de manière identique ou différente parmi les groupes des formules (Ar-1) à (Ar-10),

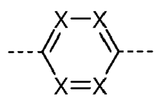

(Ar-1)

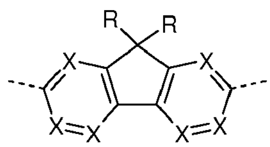

(Ar-2)

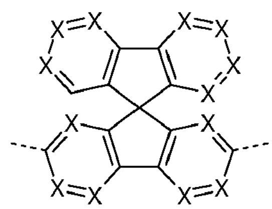

(Ar-3)

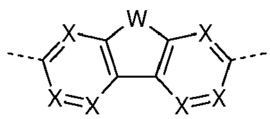

(Ar-4)

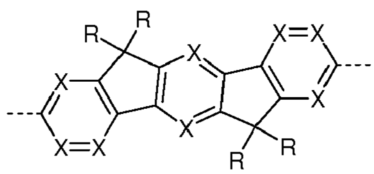

(Ar-5)

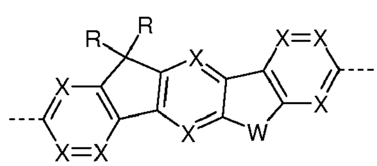

(Ar-6)

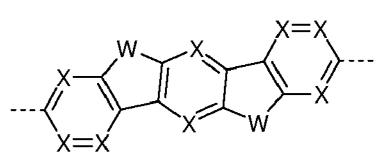

(Ar-7)

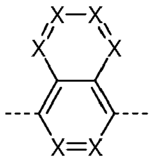

(Ar-8)

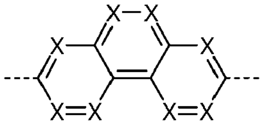

(Ar-9)

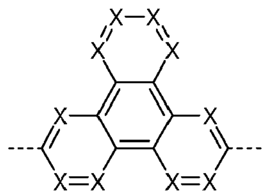

(Ar-10)

dans lesquelles les liaisons en pointillés indiquent la liaison de ce groupe, les X représentent à chaque occurrence de manière identique ou différente CR ou N, au plus deux symboles X par groupe Ar représentant N, les W représentent à chaque occurrence de manière identique ou différente NR, O ou S, et R a les significations indiquées dans la revendication 1.

**10.** Composé selon une ou plusieurs des revendications 1 à 9, **caractérisé en ce que** les groupes $Y^1$, $Y^2$ et $Y^3$ sont identiques et représentent $CH_2$, $CH_2$-$CH_2$, $CH_2$-$CH_2$-$CH_2$, $CH_2$-$CH_2$-$CH_2$-$CH_2$ ou un groupe ortho-phénylène non substitué.

**11.** Composé selon une ou plusieurs des revendications 1 à 10, **caractérisé en ce que** les groupes de la formule (2) sont choisis parmi les structures (B-1) à (B-6),

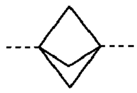

(B-1)

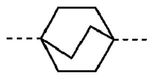

(B-2)

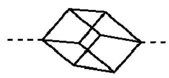

(B-3)

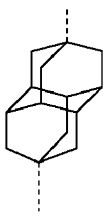

(B-4)

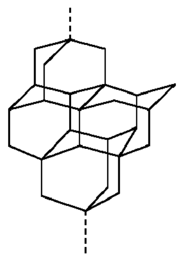

(B-5)

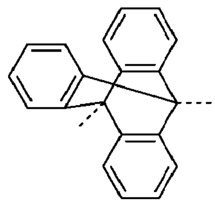

(B-6)

dans lesquelles la liaison en pointillés représente à chaque fois la liaison de ce groupe.

**12.** Composé selon une ou plusieurs des revendications 1 à 11, **caractérisé en ce que** $R^B$ est choisi parmi H, M, un groupe alkyle linéaire de 1 à 10 atomes C, ou un groupe alkyle ramifié ou cyclique de 3 à 10 atomes C, le groupe alkyle pouvant à chaque fois être substitué avec un ou plusieurs radicaux $R^1$, mais étant de préférence non substitué, ou un système cuclique aromatique ou hétéroaromatique de 6 à 24 atomes de cycle aromatique, qui peut à chaque fois être substitué par un ou plusieurs radicaux $R^1$.

**13.** Oligomère, polymère ou dendrimère contenant un ou plusieurs des composés selon une ou plusieurs des revendications 1 à 12, une ou plusieurs liaisons du composé avec le polymère, l'oligomère ou le dendrimère étant présentes.

**14.** Formulation, contenant au moins un composé selon une ou plusieurs des revendications 1 à 12 ou un oligomère, un polymère ou un dendrimère selon la revendication 13, et au moins un composé supplémentaire.

**15.** Utilisation d'un composé selon une ou plusieurs des revendications 1 à 12 ou d'un oligomère, d'un polymère ou d'un dendrimère selon la revendication 13 dans un dispositif électronique ou en tant que sensibilisateur à l'oxygène ou dans la photocatalyse.

**16.** Dispositif électronique, de préférence choisi dans le groupe constitué par les dispositifs électroluminescents organiques, les circuits intégrés organiques, les transistors à effet de champ organiques, les transistors à film mince organiques, les transistors électroluminescents organiques, les cellules solaires organiques, les détecteurs optiques organiques, les photorécepteurs organiques, les dispositifs d'extinction de champ organiques, les cellules électrochimiques électroluminescentes, les capteurs à oxygène ou les diodes lasers organiques, contenant au moins un composé selon une ou plusieurs des revendications 1 à 12 ou au moins un oligomère, un polymère ou un dendrimère selon la revendication 13.

**17.** Dispositif électronique selon la revendication 16, qui consiste en un dispositif électroluminescent organique, **caractérisé en ce que** composé selon une ou plusieurs des revendications 1 à 12 est utilisé en tant que composé d'émission dans une ou plusieurs couches d'émission.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004085449 A
- WO 2002060910 A
- WO 2005011013 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- WO 2009148015 A
- WO 2015169412 A
- US 20090136779 A
- WO 2010050778 A
- WO 2011042107 A
- WO 2011088877 A
- WO 2010108579 A
- WO 2014094964 A
- WO 2002077060 A
- WO 2003048225 A
- WO 2004058911 A
- WO 2004037887 A


### In der Beschreibung aufgeführte Nicht-Patentliteratur


- **CHE-JEN LIN et al.** Unichromophoric Platinum-Acetylides That Contain Pentiptycene Scaffolds: Torsion-Induced Dual Emission and Steric Shielding of Dynamic Quenching. *INORGANIC CHEMISTRY,* 2014, vol. 53, 737-745